# EUROPEAN PATENT APPLICATION

(11) **EP 4 451 058 A2**
(43) Date of publication of application: **23.10.2024**
(21) Application number: 24170991.4
(22) Date of filing: 18.04.2024
(51) Int. Cl.: G03F 1/50, G03F 1/84

(54) **METAL SHEET, INSPECTING METHOD FOR METAL SHEET, MANUFACTURING METHOD FOR METAL SHEET, MASK, MASK DEVICE, AND MANUFACTURING METHOD FOR MASK**

(30) Priority: 18.04.2023 JP 2023068083; 12.01.2024 JP 2024003530
(71) Applicant: Dai Nippon Printing Co., Ltd., Tokyo 162-8001 (JP)
(72) Inventor: HATSUTA, Chiaki, Tokyo-to, 162-8001 (JP); NAKAMURA, Yoko, Tokyo-to, 162-8001 (JP); INOUE, Isao, Tokyo-to, 162-8001 (JP); YANO, Hiroshi, Tokyo-to, 162-8001 (JP); MIYATANI, Isao, Tokyo-to, 162-8001 (JP)
(74) Representative: Müller-Boré & Partner Patentanwälte PartG mbB

(57) **Abstract**

A surface of a metal plate used for manufacturing a mask may have a first reflectance, a second reflectance, a third reflectance, and a fourth reflectance. The first reflectance is the reflectance of first reflected light having a first output angle. The third reflectance is the reflectance of the first reflected light having a third output angle. The first output angle is an output angle at which the first reflected light indicates a maximum intensity. The third output angle is an output angle different from the first output angle by a first deviation angle. The second reflectance is the reflectance of second reflected light having a second output angle. The fourth reflectance is the reflectance of the second reflected light having a fourth output angle. The second output angle is an output angle at which the second reflected light indicates a maximum intensity. The fourth output angle is an output angle different from the second output angle by a second deviation angle. A first ratio as a ratio of the third reflectance to the first reflectance may be 0.40 or lower. A second ratio as a ratio of the fourth reflectance to the second reflectance may be 0.40 or lower.

## Description

### Technical Field

Embodiments of the present disclosure relate to metal plate, inspection method for metal plate, manufacturing methods for metal plate, mask, mask device, and manufacturing methods for mask.

### Background Art

Organic devices, such as organic EL display devices, are attracting attention. A known method for forming elements of an organic device involves adhering a material constituting the elements to a substrate by vapor deposition. For example, a substrate having first electrodes formed thereon in accordance with a pattern corresponding to the elements is first prepared. Then, organic materials are adhered onto the first electrodes via through-holes in a mask, thereby forming organic layers on the first electrodes. Subsequently, a second electrode is formed on the organic layers.

A known manufacturing method for a mask involves forming a through-hole by etching a metal plate. The manufacturing method includes, for example, a step of forming a first resist pattern on a first surface of the metal plate and forming a second resist pattern on a second surface of the metal plate, a first etching step of forming a plurality of first recesses in the first surface by etching the first surface of the metal plate, a step of filling the first recesses with resin, and a second etching step of forming a plurality of second recesses in the second surface by etching the second surface of the metal plate. Each second recess is connected to the corresponding first recess, thereby forming a through-hole extending through the metal plate.

If the dimensional accuracy of each resist pattern is low, the dimensional accuracy of the through-hole also becomes lower. For example, if a fringe occurs in the resist pattern, the dimensional accuracy of the through-hole becomes lower. A fringe is a part of the resist pattern protruding toward the center of an opening of the resist pattern.

### Citation List

### Patent Literature

PTL 1: Japanese Unexamined Patent Application Publication No. 2000-178765
PTL 2: PCT International Publication No. WO 2019/098168
PTL 3: PCT International Publication No. WO 2017/014172
PTL 4: PCT International Publication No. WO 2017/013904

### Summary of Invention

### Technical Problem

An object of an embodiment of the present disclosure is to suppress the occurrence of a fringe in a resist pattern. Solution to Problem

According to an embodiment of the present disclosure, a metal plate used for manufacturing a mask may include a surface having a longitudinal direction of the metal plate and a width direction orthogonal to the longitudinal direction. The surface may have a first reflectance, a second reflectance, a third reflectance, and a fourth reflectance. The first reflectance is a reflectance of first reflected light having a first output angle. The third reflectance is a reflectance of the first reflected light having a third output angle. The first reflected light is reflected light of first incident light reflected at the surface. The first incident light travels in the width direction in plan view and is incident on the surface at a first specific incident angle. The first output angle is an output angle at which the first reflected light indicates a maximum intensity. The third output angle is an output angle different from the first output angle by a first deviation angle. The second reflectance is a reflectance of second reflected light having a second output angle. The fourth reflectance is a reflectance of the second reflected light having a fourth output angle. The second reflected light is reflected light of second incident light reflected at the surface. The second incident light travels in the longitudinal direction in plan view and is incident on the surface at a second specific incident angle. The second output angle is an output angle at which the second reflected light indicates a maximum intensity. The fourth output angle is an output angle different from the second output angle by a second deviation angle. Each of the first specific incident angle and the second specific incident angle may be 20°. A first ratio (R3/R1) as a ratio of the third reflectance to the first reflectance may be 0.40 or lower. A second ratio as a ratio of the fourth reflectance to the second reflectance may be 0.40 or lower. Advantageous Effects of Invention

According to the embodiment of the present disclosure, the occurrence of a fringe in a resist pattern can be suppressed.

### Brief Description of Drawings

[Fig. 1] Fig. 1 is a plan view illustrating an example of an organic device.
[Fig. 2] Fig. 2 is a plan view illustrating an example of elements of the organic device.
[Fig. 3] Fig. 3 is a cross-sectional view taken along line III-III in Fig. 2.
[Fig. 4] Fig. 4 is a plan view illustrating an example of an organic device group.
[Fig. 5] Fig. 5 is a cross-sectional view illustrating an example of a deposition apparatus.
[Fig. 6] Fig. 6 is a plan view illustrating an example of a mask device.
[Fig. 7] Fig. 7 is a plan view illustrating an example of a mask.
[Fig. 8] Fig. 8 is a plan view illustrating an example of through-holes.
[Fig. 9] Fig. 9 is a rear view illustrating the example of the through-holes.
[Fig. 10] Fig. 10 is a cross-sectional view illustrating the example of the through-holes.
[Fig. 11] Fig. 11 illustrates an example of a mask manufacturing apparatus.
[Fig. 12] Fig. 12 is a cross-sectional view illustrating an example of a resist forming step.
[Fig. 13] Fig. 13 is a cross-sectional view illustrating an example of an exposure step.
[Fig. 14A] Fig. 14A is a cross-sectional view illustrating an example of a patterning step.
[Fig. 14B] Fig. 14B is a plan view illustrating the example of the patterning step.
[Fig. 15] Fig. 15 is a cross-sectional view illustrating an example of a first etching step.
[Fig. 16] Fig. 16 is a cross-sectional view illustrating an example of a filling step.
[Fig. 17] Fig. 17 is a cross-sectional view illustrating an example of a second etching step.
[Fig. 18] Fig. 18 is a cross-sectional view illustrating an example of a removing step.
[Fig. 19] Fig. 19 is a plan view illustrating an example of a separating step.
[Fig. 20] Fig. 20 is a plan view illustrating an example of a surface of a metal plate.
[Fig. 21] Fig. 21 is a cross-sectional view illustrating an example of light reflection occurring at the surface of the metal plate.
[Fig. 22] Fig. 22 is a cross-sectional view illustrating an example where light is reflected at the surface of the metal plate in the exposure step.
[Fig. 23] Fig. 23 is a cross-sectional view illustrating an example of a resist pattern.
[Fig. 24] Fig. 24 is a plan view illustrating the example of the resist pattern including a fringe.
[Fig. 25] Fig. 25 is a plan view illustrating an example of a through-hole.
[Fig. 26] Fig. 26 illustrates a sample extracted from the metal plate.
[Fig. 27] Fig. 27 is a perspective view illustrating a step of measuring the reflectance of the sample.
[Fig. 28] Fig. 28 is a cross-sectional view illustrating a step of measuring a first reflectance and a third reflectance of the sample.
[Fig. 29] Fig. 29 illustrates an example of a measurement result of the intensity of first reflected light.
[Fig. 30] Fig. 30 is a cross-sectional view illustrating a step of measuring a second reflectance and a fourth reflectance of the sample.
[Fig. 31] Fig. 31 illustrates an example of a measurement result of the intensity of second reflected light.
[Fig. 32] Fig. 32 is a plan view illustrating measurement positions of the sample.
[Fig. 33] Fig. 33 illustrates verification samples extracted from the metal plate.
[Fig. 34] Fig. 34 is a plan view illustrating an example of a method for extracting the sample of the metal plate from the mask.
[Fig. 35] Fig. 35 illustrates an example of a rolling step.
[Fig. 36] Fig. 36 illustrates an example of an annealing step.
[Fig. 37] Fig. 37 illustrates a measurement result of the intensity of light used in Examples.
[Fig. 38A] Fig. 38A is a table illustrating measurement results of the first reflectance and the third reflectance of the metal plate according to each of Examples 1 to 11, Comparative Examples 1 to 6, and Example 12 when an incident angle is 20°.
[Fig. 38B] Fig. 38B is a table illustrating measurement results of the second reflectance and the fourth reflectance of the metal plate according to each of Examples 1 to 11, Comparative Examples 1 to 6, and Example 12 when the incident angle is 20°.
[Fig. 38C] Fig. 38C is a table illustrating measurement results of the metal plate according to each of Examples 1 to 11, Comparative Examples 1 to 6, and Example 12 when the incident angle is 20°.
[Fig. 39] Fig. 39 illustrates measurement results of the metal plate according to Example 1 when the incident angle is 20°.
[Fig. 40] Fig. 40 illustrates measurement results of the metal plate according to Example 4 when the incident angle is 20°.
[Fig. 41] Fig. 41 illustrates measurement results of the metal plate according to Example 6 when the incident angle is 20°.
[Fig. 42] Fig. 42 illustrates measurement results of the metal plate according to Example 8 when the incident angle is 20°.
[Fig. 43] Fig. 43 illustrates measurement results of the metal plate according to Comparative Example 1 when the incident angle is 20°.
[Fig. 44] Fig. 44 illustrates measurement results of the metal plate according to Comparative Example 4 when the incident angle is 20°.
[Fig. 45] Fig. 45 illustrates an image of the surface of the metal plate according to Comparative Example 1.
[Fig. 46A] Fig. 46A is a table illustrating measurement results of the first reflectance and the third reflectance of a verification sample according to each of Examples 1, 4, and 8 when the incident angle is 20°.
[Fig. 46B] Fig. 46B is a table illustrating measurement results of the second reflectance and the fourth reflectance of the verification sample according to each of Examples 1, 4, and 8 when the incident angle is 20°.
[Fig. 46C] Fig. 46C is a table illustrating measurement results of the verification sample according to each of Examples 1, 4, and 8 when the incident angle is 20°.
[Fig. 47A] Fig. 47A is a cross-sectional view illustrating an example of light reflection occurring at the surface of the metal plate when the incident angle is 20°.
[Fig. 47B] Fig. 47B is a cross-sectional view illustrating an example of light reflection occurring at the surface of the metal plate when the incident angle is 45°.
[Fig. 48A] Fig. 48A is a table illustrating measurement results of the first reflectance and the third reflectance of the metal plate according to each of Examples 1 to 12 and Comparative Examples 1 to 6 when the incident angle is 45°.
[Fig. 48B] Fig. 48B is a table illustrating measurement results of the second reflectance and the fourth reflectance of the metal plate according to each of Examples 1 to 12 and Comparative Examples 1 to 6 when the incident angle is 45°.
[Fig. 48C] Fig. 48C is a table illustrating measurement results of the metal plate according to each of Examples 1 to 12 and Comparative Examples 1 to 6 when the incident angle is 45°.
[Fig. 49A] Fig. 49A is a table illustrating the regular reflectance of the metal plate according to each of Examples 1 to 12 and Comparative Examples 1 to 6.
[Fig. 49B] Fig. 49B is a graph illustrating the relationship between the regular reflectance when the incident angle is 20° and the regular reflectance when the incident angle is 45°.
[Fig. 49C] Fig. 49C is a graph illustrating the relationship between the regular reflectance when the incident angle is 20° and the regular reflectance when the incident angle is 45°.

### Description of Embodiments

In this description and the drawings, terms, such as "plate", "sheet", and "film", referring to materials serving as bases for certain components are not to be distinguished from each other based only on the differences in how they are called, unless otherwise specified.

In this description and the drawings, terms, such as "parallel" and "orthogonal", for specifying shapes, geometric conditions, and degrees thereof, as well as values of lengths and angles, are not limited to exact meanings, and the interpretations thereof are to include an extent to which similar functions may be expected, unless otherwise specified.

In this description and the drawings, if a certain member or a certain component in a certain region is "on" or "under", "at the upper side of" or "at the lower side of", or "above" or "below" another member or another component in another region, a case where the certain component is directly in contact with the other component is included. Furthermore, if an additional component is included between a certain component and another component, a case where the certain component and the other component are indirectly in contact with each other is included, unless otherwise specified. Furthermore, with regard to the terms "on", "at the upper side of", and "above", or "under", "at the lower side of", and "below", the up-down direction may be inverted, unless otherwise specified.

In this description and the drawings, identical parts or parts having similar functions may be given the same reference sign or similar reference signs, and redundant descriptions may be omitted, unless otherwise specified. Moreover, the dimensional ratio in each drawing may be different from the actual ratio for the sake of convenience, and some of the components may be omitted from the drawings.

In this description and the drawings, an embodiment in this description may be combined with another embodiment within a range in which inconsistency does not occur, unless otherwise specified. Furthermore, other embodiments may be combined with each other within a range in which inconsistency does not occur.

In this description and the drawings, when two or more steps or processes are to be disclosed with regard to a method, such as a manufacturing method, another undisclosed step or process may be executed between the disclosed steps or processes, unless otherwise specified. Furthermore, the order of the disclosed steps or processes is arbitrary within a range in which inconsistency does not occur.

In this description and the drawings, a numerical range expressed by the symbol "-" includes numerical values placed in front of and behind the sign "-", unless otherwise specified. For example, a numerical range defined by the expression "34-38 mass%" is the same as a numerical range defined by the expression "34 mass% or higher and 38 mass% or lower".

An embodiment in this description relates to an example where a mask is used for forming organic layers or electrodes on a substrate when an organic EL display device is to be manufactured. However, the purpose of the mask is not particularly limited, and the embodiment can be applied to a mask used for various purposes. For example, the mask according to this embodiment may be used for forming electrodes of a device for displaying or projecting an image or a video image for expressing virtual reality, that is, VR, or augmented reality, that is, AR. Moreover, the mask according to this embodiment may be used for forming electrodes of a display device other than an organic EL display device, such as electrodes of a liquid crystal display device. Moreover, the mask according to this embodiment may be used for forming electrodes of an organic device other than a display device, such as electrodes of a pressure sensor.

A first aspect of the present disclosure provides a metal plate used for manufacturing a mask.

The metal plate includes a surface having a longitudinal direction of the metal plate and a width direction orthogonal to the longitudinal direction.

The surface has a first reflectance, a second reflectance, a third reflectance, and a fourth reflectance.

The first reflectance is a reflectance of first reflected light having a first output angle.

The third reflectance is a reflectance of the first reflected light having a third output angle.

The first reflected light is reflected light of first incident light reflected at the surface. The first incident light travels in the width direction in plan view and is incident on the surface at a first specific incident angle.

The first output angle is an output angle at which the first reflected light indicates a first maximum intensity.

The third output angle is an output angle different from the first output angle by a first deviation angle.

The second reflectance is a reflectance of second reflected light having a second output angle.

The fourth reflectance is a reflectance of the second reflected light having a fourth output angle.

The second reflected light is reflected light of second incident light reflected at the surface. The second incident light travels in the longitudinal direction in plan view and is incident on the surface at a second specific incident angle.

The second output angle is an output angle at which the second reflected light indicates a second maximum intensity.

The fourth output angle is an output angle different from the second output angle by a second deviation angle.

Each of the first specific incident angle and the second specific incident angle is 20°.

A first ratio as a ratio of the third reflectance to the first reflectance is 0.40 or lower.

A second ratio as a ratio of the fourth reflectance to the second reflectance is 0.40 or lower.

According to a second aspect of the present disclosure, in the metal plate according to the aforementioned first aspect, each of the first deviation angle and the second deviation angle may be 2.5°.

According to a third aspect of the present disclosure, in the metal plate according to the aforementioned first or second aspect, an absolute value of a difference between the first specific incident angle and the first output angle may be 0.30° or smaller, and an absolute value of a difference between the second specific incident angle and the second output angle may be 0.30° or smaller.

According to a fourth aspect of the present disclosure, in the metal plate according to any one of the aforementioned first to third aspects, the surface of the metal plate may include a plurality of rolling streaks extending in the longitudinal direction and a plurality of oil pits.

According to a fifth aspect of the present disclosure, in the metal plate according to any one of the aforementioned first to fourth aspects, the metal plate may have a thickness of 80 µm or smaller.

According to a sixth aspect of the present disclosure, in the metal plate according to any one of the aforementioned first to fifth aspects, the metal plate may include an iron alloy containing 34 mass% or higher and 38 mass% or lower of nickel.

According to a seventh aspect of the present disclosure, in the metal plate according to any one of the aforementioned first to sixth aspects, an absolute value of a difference between the first ratio and the second ratio may be 0.20 or smaller.

According to an eighth aspect of the present disclosure, in the metal plate according to any one of the aforementioned first to seventh aspects, each of the first ratio and the second ratio may be 0.30 or lower.

According to a ninth aspect of the present disclosure, in the metal plate according to the aforementioned eighth aspect, the second ratio may be 0.20 or lower.

According to a tenth aspect of the present disclosure, in the metal plate according to any one of the aforementioned first to ninth aspects, the metal plate may have a regular reflectance of 35.0% or lower. The regular reflectance may be an average value of the first reflectance and the second reflectance.

An eleventh aspect of the present disclosure provides an inspection method for a metal plate used for manufacturing a mask.

The metal plate includes a surface having a longitudinal direction and a width direction orthogonal to the longitudinal direction.

The inspection method includes:
a step of measuring a first reflectance, a second reflectance, a third reflectance, and a fourth reflectance of the metal plate;
a first determination step of determining whether a first ratio as a ratio of the third reflectance to the first reflectance is lower than or equal to a first threshold value; and
a second determination step of determining whether a second ratio as a ratio of the fourth reflectance to the second reflectance is lower than or equal to a second threshold value.

The first reflectance is a reflectance of first reflected light having a first output angle.

The third reflectance is a reflectance of the first reflected light having a third output angle.

The first reflected light is reflected light of first incident light reflected at the surface. The first incident light travels in the width direction in plan view and is incident on the surface at a first specific incident angle.

The first output angle is an output angle at which the first reflected light indicates a first maximum intensity.

The third output angle is an output angle different from the first output angle by a first deviation angle.

The second reflectance is a reflectance of second reflected light having a second output angle.

The fourth reflectance is a reflectance of the second reflected light having a fourth output angle.

The second reflected light is reflected light of second incident light reflected at the surface. The second incident light travels in the longitudinal direction in plan view and is incident on the surface at a second specific incident angle.

The second output angle is an output angle at which the second reflected light indicates a second maximum intensity.

The fourth output angle is an output angle different from the second output angle by a second deviation angle.

A twelfth aspect of the present disclosure provides a manufacturing method for a metal plate used for manufacturing a mask.

The manufacturing method includes a rolling step of rolling the metal plate to reduce a thickness of the metal plate.

The metal plate having undergone the rolling includes a surface having a longitudinal direction of the metal plate and a width direction orthogonal to the longitudinal direction.

The surface has a first reflectance, a second reflectance, a third reflectance, and a fourth reflectance.

The first reflectance is a reflectance of first reflected light having a first output angle.

The third reflectance is a reflectance of the first reflected light having a third output angle.

The first reflected light is reflected light of first incident light reflected at the surface. The first incident light travels in the width direction in plan view and is incident on the surface at a first specific incident angle.

The first output angle is an output angle at which the first reflected light indicates a first maximum intensity.

The third output angle is an output angle different from the first output angle by a first deviation angle.

The second reflectance is a reflectance of second reflected light having a second output angle.

The fourth reflectance is a reflectance of the second reflected light having a fourth output angle.

The second reflected light is reflected light of second incident light reflected at the surface. The second incident light travels in the longitudinal direction in plan view and is incident on the surface at a second specific incident angle.

The second output angle is an output angle at which the second reflected light indicates a second maximum intensity.

The fourth output angle is an output angle different from the second output angle by a second deviation angle.

A first ratio as a ratio of the third reflectance to the first reflectance is 0.40 or lower.

A second ratio as a ratio of the fourth reflectance to the second reflectance is 0.40 or lower.

A thirteenth aspect of the present disclosure provides a mask including:
a metal plate; and
a plurality of through-holes extending through the metal plate.

The metal plate includes a surface having a longitudinal direction of the metal plate and a width direction orthogonal to the longitudinal direction.

The surface has a first reflectance, a second reflectance, a third reflectance, and a fourth reflectance.

The first reflectance is a reflectance of first reflected light having a first output angle.

The third reflectance is a reflectance of the first reflected light having a third output angle.

The first reflected light is reflected light of first incident light reflected at the surface. The first incident light travels in the width direction in plan view and is incident on the surface at a first specific incident angle.

The first output angle is an output angle at which the first reflected light indicates a first maximum intensity.

The third output angle is an output angle different from the first output angle by a first deviation angle.

The second reflectance is a reflectance of second reflected light having a second output angle.

The fourth reflectance is a reflectance of the second reflected light having a fourth output angle.

The second reflected light is reflected light of second incident light reflected at the surface. The second incident light travels in the longitudinal direction in plan view and is incident on the surface at a second specific incident angle.

The second output angle is an output angle at which the second reflected light indicates a second maximum intensity.

The fourth output angle is an output angle different from the second output angle by a second deviation angle.

Each of the first specific incident angle and the second specific incident angle is 20°.

A first ratio as a ratio of the third reflectance to the first reflectance is 0.40 or lower.

A second ratio as a ratio of the fourth reflectance to the second reflectance is 0.40 or lower.

According to a fourteenth aspect of the present disclosure, in the mask according to the aforementioned thirteenth aspect, the metal plate may include a first surface and a second surface located opposite the first surface. The through-holes may include a plurality of first recesses located at the first surface, a plurality of second recesses located at the second surface, and a plurality of connection portions, each of the connection portions connecting each of the first recesses and each of the second recesses to each other. In plan view, a size of each second recess may be larger than a size of each first recess.

The first surface may be the surface having the first reflectance, the second reflectance, the third reflectance, and the fourth reflectance.

According to a fifteenth aspect of the present disclosure, in the mask according to the aforementioned fourteenth aspect, each of the through-holes may have a first through-dimension in the width direction and a second through-dimension in the longitudinal direction. A ratio of the first through-dimension to the second through-dimension may be 0.98 or higher.

A sixteenth aspect of the present disclosure provides a mask device including:
the mask according to any one of the aforementioned thirteenth to fifteenth aspects; and
a mask supporter that supports the mask.

A seventeenth aspect of the present disclosure provides a manufacturing device for a mask. The manufacturing method includes:
a step of preparing a metal plate; and
a processing step of forming a plurality of through-holes in the metal plate.

The metal plate includes a surface having a longitudinal direction of the metal plate and a width direction orthogonal to the longitudinal direction.

The surface has a first reflectance, a second reflectance, a third reflectance, and a fourth reflectance.

The first reflectance is a reflectance of first reflected light having a first output angle.

The third reflectance is a reflectance of the first reflected light having a third output angle.

The first reflected light is reflected light of first incident light reflected at the surface. The first incident light travels in the width direction in plan view and is incident on the surface at a first specific incident angle.

The first output angle is an output angle at which the first reflected light indicates a first maximum intensity.

The third output angle is an output angle different from the first output angle by a first deviation angle.

The second reflectance is a reflectance of second reflected light having a second output angle.

The fourth reflectance is a reflectance of the second reflected light having a fourth output angle.

The second reflected light is reflected light of second incident light reflected at the surface. The second incident light travels in the longitudinal direction in plan view and is incident on the surface at a second specific incident angle.

The second output angle is an output angle at which the second reflected light indicates a second maximum intensity.

The fourth output angle is an output angle different from the second output angle by a second deviation angle.

A first ratio as a ratio of the third reflectance to the first reflectance is 0.40 or lower.

A second ratio as a ratio of the fourth reflectance to the second reflectance is 0.40 or lower.

According to an eighteenth aspect of the present disclosure, in the manufacturing method for the mask according to the aforementioned seventeenth aspect, the processing step may include:
a resist forming step of forming a resist layer on the surface of the metal plate;
an exposure step of exposing the resist layer to light;
a developing step of developing the resist layer exposed to the light to form a resist pattern; and
an etching step of etching the metal plate.

According to a nineteenth aspect of the present disclosure, in the manufacturing method for the mask according to the aforementioned eighteenth aspect, the resist pattern may include openings and wall surfaces facing the openings. Each of fringes at the wall surfaces may have a width of 1.00 µm or smaller in plan view. Each of the fringe protrudes at a corner toward a center of the opening. The corner is an area where a surface of the resist pattern facing the metal plate and the wall surface are connected to each other.

Embodiments of the present disclosure will now be described in detail with reference to the drawings. The following embodiments are examples of embodiments of the present disclosure, and the present disclosure is not to be interpreted limitedly only to these embodiments.

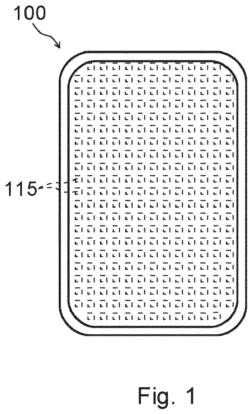

First, an organic device 100 will be described. The organic device 100 includes organic layers or electrodes formed by using a mask. Fig. 1 is a plan view illustrating an example of the organic device 100 when viewed in the normal direction to a substrate of the organic device 100. In the following description, a view in the normal direction to a surface of a material serving as a base, such as the substrate, is also referred to as a plan view.

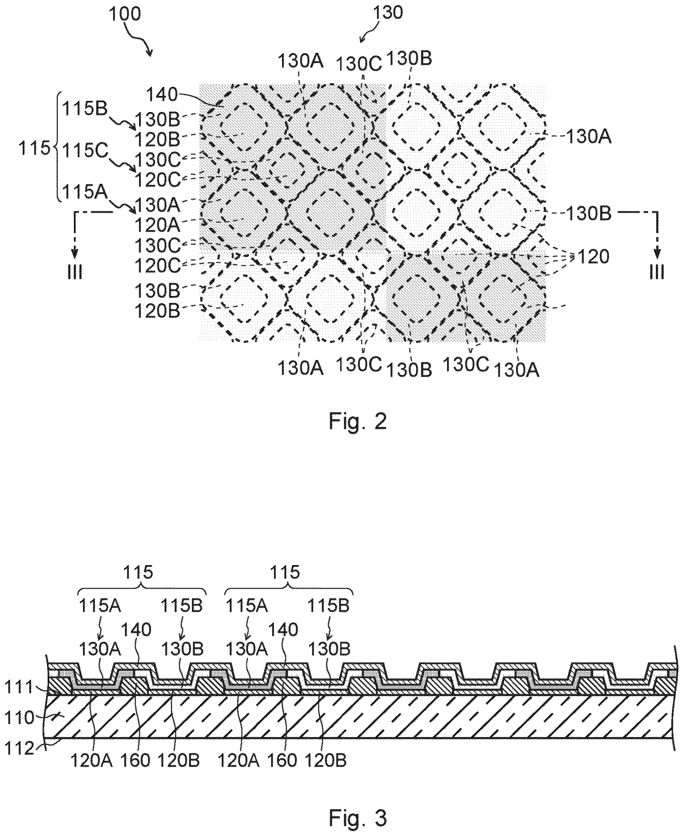

The organic device 100 includes the substrate and a plurality of elements 115 arranged in an in-plane direction of the substrate. The elements 115 are, for example, pixels. Fig. 2 is an enlarged plan view of the organic device 100. The elements 115 may be arranged in two different directions. Fig. 3 is a cross-sectional view taken along line III-III in Fig. 2.

The organic device 100 may include a substrate 110, a plurality of first electrodes 120, a plurality of organic layers 130, and a second electrode 140. The substrate 110 includes a first surface 111 and a second surface 112. The second surface 112 is located opposite the first surface 111.

The plurality of first electrodes 120 may be located on the first surface 111. The plurality of organic layers 130 may be located on the first electrodes 120. The second electrode 140 may be located on the organic layers 130. The second electrode 140 may extend to overlap the plurality of first electrodes 120 in plan view. Each element 115 is constituted of a multilayer structural body including the corresponding first electrode 120, the corresponding organic layer 130, and the second electrode 140. The element 115 can achieve a certain function in accordance with a voltage applied between the first electrode 120 and the second electrode 140 or an electric current flowing between the first electrode 120 and the second electrode 140.

The organic device 100 may be of an active matrix type. For example, although not shown, the organic device 100 may include switches electrically connected to each of the plurality of elements 115. Each of the switches is, for example, a transistor. The switch can be used for performing on/off control of a voltage applied to the element 115 or an electric current flowing to the element 115.

As shown in Fig. 2 and Fig. 3, the plurality of organic layers 130 may include a plurality of first organic layers 130A, a plurality of second organic layers 130B, and a plurality of third organic layers 130C. The first organic layers 130A, the second organic layers 130B, and the third organic layers 130C are, for example, red light emitting layers, blue light emitting layers, and green light emitting layers. When a configuration commonly shared among the first organic layers 130A, the second organic layers 130B, and the third organic layers 130C is to be described, the term and reference sign "organic layers 130" will be used.

As shown in Fig. 2 and Fig. 3, the plurality of first electrodes 120 may include a plurality of 1A_electrodes 120A, a plurality of 1B_electrodes 120B, and a plurality of 1C_electrodes 120C. Each 1A_electrode 120A overlaps the corresponding first organic layer 130A in plan view. Each 1B_electrode 120B overlaps the corresponding second organic layer 130B in plan view. Each 1C_electrode 120C overlaps the corresponding third organic layer 130C in plan view. When a configuration commonly shared among the 1A_electrodes 120A, the 1B_electrodes 120B, and the 1C_electrodes 120C is to be described, the term and reference sign "first electrodes 120" will be used.

Each element 115 may include at least one first sub element 115A, at least one second sub element 115B, and at least one third sub element 115C. The first sub element 115A includes the corresponding 1A_electrode 120A, the corresponding first organic layer 130A, and the second electrode 140. The second sub element 115B includes the corresponding 1B_electrode 120B, the corresponding second organic layer 130B, and the second electrode 140. The third sub element 115C includes the corresponding 1C_electrode 120C, the corresponding third organic layer 130C, and the second electrode 140. In the example shown in Fig. 2, each element 115 includes one first sub element 115A, one second sub element 115B, and two third sub elements 115C.

A component formed by using the mask may be each organic layer 130 or the second electrode 140. The component formed by using the mask is also referred to as a deposition layer.

The organic device 100 may include an insulation layer 160 located between two first electrodes 120 adjacent to each other in plan view. The insulation layer 160 contains, for example, polyimide. The insulation layer 160 may overlap an end of the corresponding first electrode 120 in plan view.

The components of the organic device 100 will now be described in detail.

The substrate 110 may be a tabular member having insulating properties. The substrate 110 preferably has transparency for allowing light to be transmitted therethrough. A material that can be used for the substrate 110 is, for example, a rigid material not having flexibility, such as quartz glass, Pyrex (registered trademark) glass, or a synthetic quartz plate, or a flexible material having flexibility, such as a resin film, an optical resin plate, or thin glass. The substrate 110 may be a laminated body having a barrier layer on one surface or each surface of a resin film.

The elements 115 are configured to achieve a certain function in accordance with a voltage applied between the first electrodes 120 and the second electrode 140 or an electric current flowing between the first electrodes 120 and the second electrode 140. For example, if the elements 115 are pixels of an organic EL display device, the elements 115 release light that forms a video image.

Each first electrode 120 includes a material having electrical conductivity. For example, the first electrode 120 includes metal, a metallic oxide having electrical conductivity, or another inorganic material having electric conductivity. The first electrode 120 may include a metallic oxide having transparency and electrical conductivity, such as indium tin oxide (ITO) or indium zinc oxide (IZO).

Each organic layer 130 includes an organic material. When electricity is applied to the organic layer 130, the organic layer 130 can exhibit a certain function. The expression "electricity is applied" refers to a state where a voltage is applied to the organic layer 130 or a state where an electric current flows to the organic layer 130. The organic layer 130 used may be, for example, a light emitting layer that releases light when electricity is applied thereto. The organic layer 130 may include an organic semiconductor material. Properties, such as the transmissivity and the refractive index, of the organic layer 130 may be adjusted, where appropriate.

When a voltage is applied between the first electrodes 120 and the second electrode 140, the organic layers 130 located therebetween are driven. If the organic layers 130 are light emitting layers, light is released from the organic layers 130, and the light is then extracted outward from the second electrode 140 or the first electrodes 120.

Each organic layer 130 may further include, for example, a hole injection layer, a hole transport layer, an electron transport layer, an electron injection layer, and a charge generation layer.

The second electrode 140 includes a material having electrical conductivity, such as metal. The second electrode 140 is formed on the organic layers 130 by vapor deposition using a mask. The material that can be used for forming the second electrode 140 is, for example, platinum, gold, silver, copper, iron, tin, chromium, aluminum, indium, lithium, sodium, potassium, calcium, magnesium, indium tin oxide (ITO), indium zinc oxide (IZO), or carbon. With regard to any of these materials, one kind may be used singularly, or two or more kinds may be used in combination with each other. If two or more kinds are to be used, layers composed of the respective materials may be stacked. Furthermore, an alloy containing two or more kinds of materials may be used. For example, a magnesium alloy, such as MgAg, or an aluminum alloy, such as AlLi, AlCa, or AlMg, may be used. MgAg is also referred to as silver magnesium. Silver magnesium is preferably used as the material of the second electrode 140. An alloy, such as alkali metal or alkaline earth metal, may also be used. For example, lithium fluoride, sodium fluoride, or potassium fluoride may also be used.

The second electrode 140 may be a common electrode. For example, the second electrode 140 in one element 115 may be electrically connected to the second electrode 140 in another element 115.

As shown in Fig. 2 and Fig. 3, the second electrode 140 may extend to overlap the plurality of first electrodes 120. For example, in plan view, the second electrode 140 may extend over the entire display region of the organic device 100.

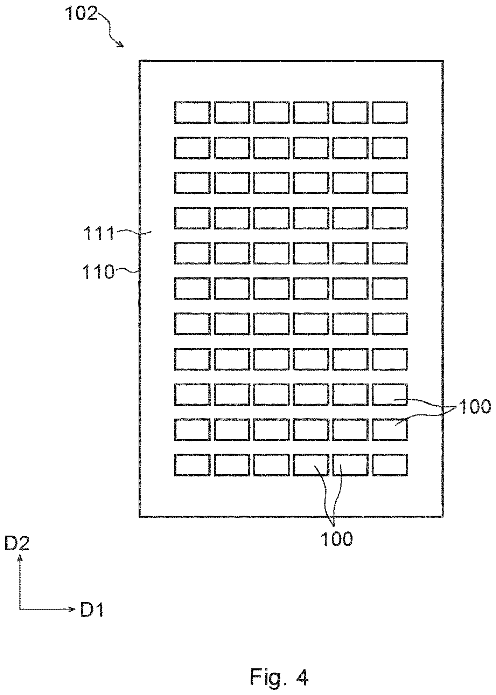

In a manufacturing method of the organic device 100, an organic device group 102 shown in Fig. 4 may be fabricated. The organic device group 102 includes two or more organic devices 100. For example, the organic device group 102 may include organic devices 100 arranged in a first direction D1 and a second direction D2. The second direction D2 is orthogonal to the first direction D1. The two or more organic devices 100 may include a single common substrate 110. For example, the organic device group 102 may include layers, such as first electrodes 120, organic layers 130, and second electrodes 140 that are located on a single substrate 110 and that constitute the two or more organic devices 100. By splitting the organic device group 102, organic devices 100 are obtained.

The first direction D1 may be the longitudinal direction of a mask, to be described later.

Next, a method for forming a deposition layer, such as an organic layer 130, by vapor deposition will be described.

The vapor deposition executed by using a mask 50 is physical vapor deposition. Examples of the physical vapor deposition include vacuum deposition, ion plating, and sputtering. When the mask 50 is used in the physical vapor deposition, a deposition layer is formed in a region of a target object overlapping through-holes in the mask 50 in plan view. The target object is, for example, a substrate.

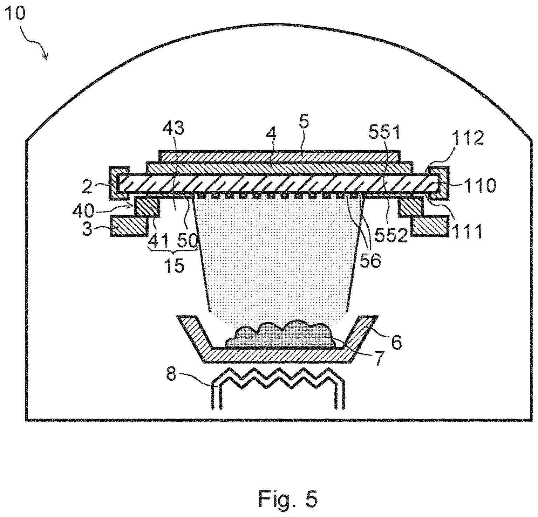

Fig. 5 illustrates a deposition apparatus 10. The deposition apparatus 10 executes a deposition process for depositing a deposition material on the substrate 110. In the example shown in Fig. 5, the deposition apparatus 10 executes vacuum deposition.

As shown in Fig. 5, the deposition apparatus 10 may include therein a deposition source 6, a heater 8, and a mask device 15. The deposition apparatus 10 may further include exhaust means for setting the interior of the deposition apparatus 10 to a vacuum atmosphere. The deposition source 6 is, for example, a crucible and accommodates a deposition material 7, such as an organic material or a metallic material. The heater 8 heats the deposition source 6 to cause the deposition material 7 to evaporate in the vacuum atmosphere. The mask device 15 is disposed facing the crucible 6.

As shown in Fig. 5, the mask device 15 includes at least one mask 50. The mask device 15 may include a mask supporter 40 that supports the mask 50. The mask supporter 40 may include a frame 41 that includes an opening 43. The mask 50 may be fixed to the frame 41 to extend across the opening 43 in plan view. The frame 41 may support the mask 50 in a stretched state in a planar direction thereof to suppress sagging of the mask 50.

As shown in Fig. 5, the mask device 15 is disposed within the deposition apparatus 10 such that the mask 50 faces the first surface 111 of the substrate 110. The mask 50 includes a plurality of through-holes 56 that allow the deposition material 7 coming from the deposition source 6 to pass therethrough. In the following description, a surface of the mask 50 facing the substrate 110 will be referred to as a first surface 551. A surface of the mask 50 located opposite the first surface 551 will be referred to as a second surface 552.

As shown in Fig. 5, the deposition apparatus 10 may include a substrate holder 2 that holds the substrate 110. The substrate holder 2 may be movable in the thickness direction of the substrate 110. The substrate holder 2 may be movable in the planar direction of the substrate 110. The substrate holder 2 may be configured to control the inclination of the substrate 110. For example, the substrate holder 2 may include a plurality of chucks attached to an outer edge of the substrate 110. Each chuck may be independently movable in the thickness direction and the planar direction of the substrate 110.

By moving at least the substrate holder 2 or a mask holder 3, the position of the mask 50 relative to the substrate 110 can be adjusted.

As shown in Fig. 5, the deposition apparatus 10 may include a cooling plate 4 disposed at the second surface 112 side of the substrate 110. The cooling plate 4 may have a flow path for causing a refrigerant to circulate through the interior of the cooling plate 4. The cooling plate 4 can suppress an increase in temperature of the substrate 110 during a deposition step.

As shown in Fig. 5, the deposition apparatus 10 may include a magnet 5 disposed at the second surface 112 side of the substrate 110. The magnet 5 may be disposed on a surface of the cooling plate 4 distant from the substrate 110. The magnet 5 can cause the mask 50 to be attracted toward the substrate 110 in accordance with a magnetic force. Accordingly, a gap between the mask 50 and the substrate 110 can be reduced or eliminated. Thus, the occurrence of a shadow can be suppressed during the deposition step. A shadow is a phenomenon where the deposition material 7 enters the gap between the mask 50 and the substrate 110 and causes the shape of the deposition layer to become nonuniform. The shape of the deposition layer refers to, for example, the thickness of the deposition layer and the size of the deposition layer in plan view. The mask 50 may be attracted toward the substrate 110 by using an electrostatic chuck that utilizes an electrostatic force.

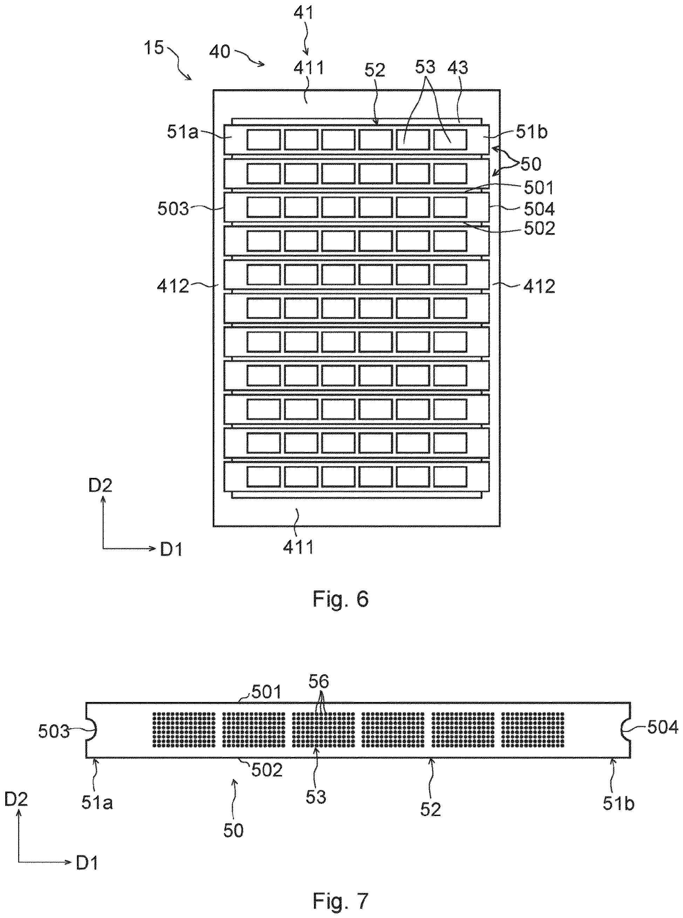

Fig. 6 is a plan view illustrating the mask device 15, as viewed from the first surface 551 side. The mask device 15 may include the mask supporter 40 including the frame 41, and may also include masks 50 fixed to the frame 41. The mask device 15 may include two or more masks 50 arranged in the second direction D2. The frame 41 supports the masks 50 in a state where tension is applied to the masks 50 to suppress sagging of the masks 50.

The frame 41 may include a pair of first sides 411 extending in the first direction D1 and a pair of second sides 412 extending in the second direction D2, and may also include the opening 43. The second sides 412 may be longer than the first sides 411. The pair of first sides 411 and the pair of second sides 412 are in contact with the opening 43 in plan view.

Each mask 50 may include a first side edge 501 and a second side edge 502 that extend in the first direction D1, and may also include a first end 503 and a second end 504. The first end 503 and the second end 504 are ends of the mask 50 in the first direction D1.

In plan view, each mask 50 includes a first end portion 51a, a second end portion 51b, and an intermediate portion 52. The first end portion 51a and the second end portion 51b are opposed to each other in the first direction D1. The intermediate portion 52 is located between the first end portion 51a and the second end portion 51b. The intermediate portion 52 includes a through-hole group 53.

The term "plan view" refers to a view of a target object in the thickness direction of each mask 50.

Each mask 50 is fixed to the second sides 412. In detail, the first end portion 51a is fixed to a first one of the second sides 412, and the second end portion 51b is fixed to a second one of the second sides 412. The first end portion 51a and the second end portion 51b may be fixed to the first one of the second sides 412 and the second one of the second sides 412 by welding. The intermediate portion 52 overlaps the opening 43 of the frame 41 in plan view.

Fig. 7 is a plan view illustrating an example of each mask 50. The through-hole group 53 in the intermediate portion 52 includes a plurality of through-holes 56 arranged orderly in plan view. The through-holes 56 may be arranged periodically in two directions. For example, the through-holes 56 may be arranged periodically in the first direction D1 and the second direction D2.

One through-hole group 53 corresponds to one organic device 100. For example, the plurality of first organic layers 130A included in one organic device 100 are composed of a deposition material that has passed through the plurality of through-holes 56 in one through-hole group 53. Each mask 50 includes at least one through-hole group 53. Each mask 50 may include two or more through-hole groups 53 arranged in the first direction D1.

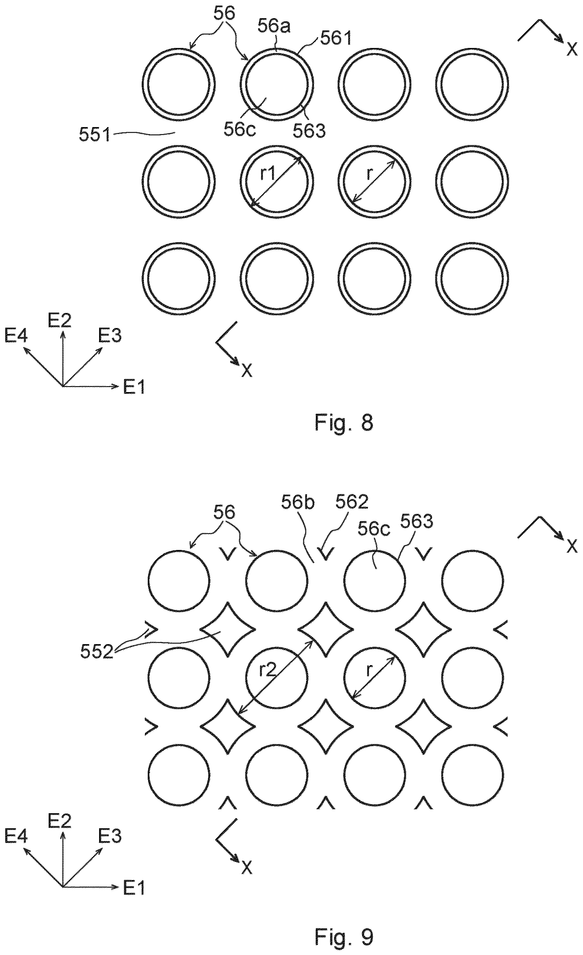

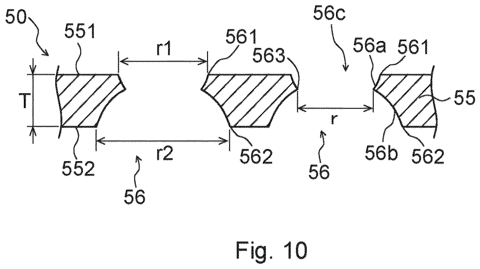

The through-holes 56 will now be described in detail. Fig. 8 is a plan view illustrating the through-holes 56 in the first surface 551. Fig. 9 is a bottom view illustrating the through-holes 56 in the second surface 552. Fig. 10 is a cross-sectional view taken along line X-X in Fig. 8 and Fig. 9.

Each through-hole 56 includes a first recess 56a, a second recess 56b, and a connection portion 563 connecting the first recess 56a and the second recess 56b to each other. The first recess 56a is a recess located in the first surface 551 and recessed toward the second surface 552. The second recess 56b is a recess located in the second surface 552 and recessed toward the first surface 551. The first recess 56a and the second recess 56b are connected to each other, so that the through-hole 56 extending through a metal plate 55 is formed. The first recess 56a is formed by etching the first surface 551. The second recess 56b is formed by etching the second surface 552.

The through-holes 56 may be arranged orderly in a first array direction E1 and a second array direction E2. The second array direction E2 may be orthogonal to the first array direction E1.

The first recess 56a includes a first outline 561 on the first surface 551. The first outline 561 has a dimension r1 in plan view. The dimension r1 is defined in a direction in which the first outline 561 has a maximum size. The second recess 56b includes a second outline 562 on the second surface 552. The second outline 562 has a dimension r2 in plan view. The dimension r2 is defined in a direction in which the second outline 562 has a maximum size. In the example shown in Fig. 8 and Fig. 9, the dimension r1 and the dimension r2 are defined in a third array direction E3 that is 45° relative to the first array direction E1 and the second array direction E2.

Two neighboring second recesses 56b may be connected to each other or do not have to be connected to each other. For example, two neighboring second recesses 56b in the first array direction E1 or the second array direction E2 may be connected to each other. For example, two neighboring second recesses 56b in the third array direction E3 or a fourth array direction E4 do not have to be connected to each other. The fourth array direction E4 may be orthogonal to the third array direction E3.

The dimension r1 may be, for example, 10 µm or larger, 20 µm or larger, or 30 µm or larger. The dimension r1 may be, for example, 40 µm or smaller, 50 µm or smaller, or 100 µm or smaller. The range of the dimension r1 may be defined in accordance with a first group constituted of 10 pm, 20 pm, and 30 µm and/or a second group constituted of 40 pm, 50 pm, and 100 pm. The range of the dimension r1 may be defined in accordance with a combination of any one of the values included in the aforementioned first group and any one of the values included in the aforementioned second group. The range of the dimension r1 may be defined in accordance with a combination of any two of the values included in the aforementioned first group. The range of the dimension r1 may be defined in accordance with a combination of any two of the values included in the aforementioned second group. The dimension r1 may be, for example, 10 µm or larger and 100 µm or smaller, 10 µm or larger and 50 µm or smaller, 10 µm or larger and 40 µm or smaller, 10 µm or larger and 30 µm or smaller, 10 µm or larger and 20 µm or smaller, 20 µm or larger and 100 µm or smaller, 20 µm or larger and 50 µm or smaller, 20 µm or larger and 40 µm or smaller, 20 µm or larger and 30 µm or smaller, 30 µm or larger and 100 µm or smaller, 30 µm or larger and 50 µm or smaller, 30 µm or larger and 40 µm or smaller, 40 µm or larger and 100 µm or smaller, 40 µm or larger and 50 µm or smaller, or 50 µm or larger and 100 µm or smaller.

As shown in Fig. 8 to Fig. 10, in plan view, the size of each second recess 56b may be larger than the size of each first recess 56a. For example, the dimension r2 may be larger than the dimension r1. A ratio r2/r1 of the dimension r2 to the dimension r1 may be, for example, 1.05 or higher, 1.10 or higher, or 1.15 or higher. The ratio r2/r1 may be, for example, 1.30 or lower, 1.50 or lower, 2.00 or lower, or 3.00 or lower. The range of r2/r1 may be defined in accordance with a first group constituted of 1.05, 1.10, and 1.15 and/or a second group constituted of 1.30, 1.50, 2.00, and 3.00. The range of r2/r1 may be defined in accordance with a combination of any one of the values included in the aforementioned first group and any one of the values included in the aforementioned second group. The range of r2/r1 may be defined in accordance with a combination of any two of the values included in the aforementioned first group. The range of r2/r1 may be defined in accordance with a combination of any two of the values included in the aforementioned second group. The ratio r2/r1 may be, for example, 1.05 or higher and 3.00 or lower, 1.05 or higher and 2.00 or lower, 1.05 or higher and 1.50 or lower, 1.05 or higher and 1.30 or lower, 1.05 or higher and 1.15 or lower, 1.05 or higher and 1.10 or lower, 1.10 or higher and 3.00 or lower, 1.10 or higher and 2.00 or lower, 1.10 or higher and 1.50 or lower, 1.10 or higher and 1.30 or lower, 1.10 or higher and 1.15 or lower, 1.15 or higher and 3.00 or lower, 1.15 or higher and 2.00 or lower, 1.15 or higher and 1.50 or lower, 1.15 or higher and 1.30 or lower, 1.30 or higher and 3.00 or lower, 1.30 or higher and 2.00 or lower, 1.30 or higher and 1.50 or lower, 1.50 or higher and 3.00 or lower, 1.50 or higher and 2.00 or lower, or 2.00 or higher and 3.00 or lower.

As shown in Fig. 10, the dimension of each first recess 56a in the planar direction of the first surface 551 may decrease from the first surface 551 toward the corresponding connection portion 563. The dimension of each second recess 56b in the planar direction of the first surface 551 may decrease from the second surface 552 toward the corresponding connection portion 563.

In plan view, each connection portion 563 may have a continuous outline along the circumference thereof. The connection portion 563 may define a through-portion 56c where the corresponding through-hole 56 has a minimum opening area in plan view of the mask 50.

A dimension r of the through-portion 56c in plan view may be, for example, 10 µm or larger, 15 µm or larger, 20 µm or larger, or 25 µm or larger. The dimension r may be, for example, 40 µm or smaller, 45 µm or smaller, 50 µm or smaller, or 60 µm or smaller. The range of the dimension r may be defined in accordance with a first group constituted of 10 pm, 15 µm, 20 µm, and 25 µm and/or a second group constituted of 40 pm, 45 pm, 50 pm, and 60 pm. The range of the dimension r may be defined in accordance with a combination of any one of the values included in the aforementioned first group and any one of the values included in the aforementioned second group. The range of the dimension r may be defined in accordance with a combination of any two of the values included in the aforementioned first group. The range of the dimension r may be defined in accordance with a combination of any two of the values included in the aforementioned second group. The dimension r may be, for example, 10 µm or larger and 60 µm or smaller, 10 µm or larger and 50 µm or smaller, 10 µm or larger and 45 µm or smaller, 10 µm or larger and 40 µm or smaller, 10 µm or larger and 25 µm or smaller, 10 µm or larger and 20 µm or smaller, 10 µm or larger and 15 µm or smaller, 15 µm or larger and 60 µm or smaller, 15 µm or larger and 50 µm or smaller, 15 µm or larger and 45 µm or smaller, 15 µm or larger and 40 µm or smaller, 15 µm or larger and 25 µm or smaller, 15 µm or larger and 20 µm or smaller, 20 µm or larger and 60 µm or smaller, 20 µm or larger and 50 µm or smaller, 20 µm or larger and 45 µm or smaller, 20 µm or larger and 40 µm or smaller, 20 µm or larger and 25 µm or smaller, 25 µm or larger and 60 µm or smaller, 25 µm or larger and 50 µm or smaller, 25 µm or larger and 45 µm or smaller, 25 µm or larger and 40 µm or smaller, 40 µm or larger and 60 µm or smaller, 40 µm or larger and 50 µm or smaller, 40 µm or larger and 45 µm or smaller, 45 µm or larger and 60 µm or smaller, 45 µm or larger and 50 µm or smaller, or 50 µm or larger and 60 µm or smaller.

The dimension r1 is calculated by measuring the shape of each through-hole 56 from the first surface 551 side. The dimension r2 is calculated by measuring the shape of each through-hole 56 from the second surface 552 side. A measuring device used is AMIC-2500 manufactured by Sinto S-Precision, Ltd.

The dimension r may be defined by light transmitted through each through-hole 56. For example, collimated light is caused to enter one of the first surface 551 and the second surface 552 of the mask 50 in the normal direction to the mask 50. Then, the collimated light is transmitted through the through-hole 56. Then, the collimated light is output from the other one of the first surface 551 and the second surface 552. A dimension of an area occupied by the output light in the planar direction of the mask 50 is employed as the dimension r of the through-portion 56c. The dimension of the through-portion 56c may also be referred to as a through-dimension.

The dimension r1, the dimension r2, and the dimension r are calculated by averaging out measurement results of 100 through-holes 56. The 100 through-holes 56 are extracted from the through-hole group 53 closest to the center point of the mask 50 in the first direction D1. The 100 through-holes 56 are a set of 10 rows by 10 rows of through-holes 56 located in the middle of the through-hole group 53 in plan view. A dimension, to be described later, related to each through-hole 56, each first recess 56a, or each second recess 56b is also calculated by averaging out measurement results of the 100 through-holes 56.

The material of the metal plate 55 and the frame 41 will now be described. The main material used for the mask 50 and the frame 41 may be an iron alloy containing nickel. Accordingly, a difference between a thermal expansion coefficient of the mask 50 and the frame 41 and a thermal expansion coefficient of the substrate 110 including glass can be reduced. Therefore, an instance where the dimensional accuracy and the positional accuracy of the deposition layer formed on the substrate 110 decrease due to thermal expansion of, for example, the mask 50, the frame 41, and the substrate 110 can be suppressed.

The content of nickel in the iron alloy may be, for example, 28 mass% or higher, 30 mass% or higher, or 34 mass% or higher. The content of nickel in the iron alloy may be, for example, 38 mass% or lower, 44 mass% or lower, or 54 mass% or lower. The range of the content of nickel in the iron alloy may be defined in accordance with a first group constituted of 28 mass%, 30 mass%, and 34 mass% and/or a second group constituted of 38 mass%, 44 mass%, and 54 mass%. The range of the content of nickel in the iron alloy may be defined in accordance with a combination of any one of the values included in the aforementioned first group and any one of the values included in the aforementioned second group. The range of the content of nickel in the iron alloy may be defined in accordance with a combination of any two of the values included in the aforementioned first group. The range of the content of nickel in the iron alloy may be defined in accordance with a combination of any two of the values included in the aforementioned second group. The content of nickel in the iron alloy may be, for example, 28 mass% or higher and 54 mass% or lower, 28 mass% or higher and 44 mass% or lower, 28 mass% or higher and 38 mass% or lower, 28 mass% or higher and 34 mass% or lower, 28 mass% or higher and 30 mass% or lower, 30 mass% or higher and 54 mass% or lower, 30 mass% or higher and 44 mass% or lower, 30 mass% or higher and 38 mass% or lower, 30 mass% or higher and 34 mass% or lower, 34 mass% or higher and 54 mass% or lower, 34 mass% or higher and 44 mass% or lower, 34 mass% or higher and 38 mass% or lower, 38 mass% or higher and 54 mass% or lower, 38 mass% or higher and 44 mass% or lower, or 44 mass% or higher and 54 mass% or lower.

The iron alloy may further contain cobalt in addition to nickel. For example, the material used for the metal plate 55 of the mask 50 may be an iron alloy in which the total content of nickel and cobalt is 28 mass% or higher and 54 mass% or lower and in which the content of cobalt is 0 mass% or higher and 6 mass% or lower.

The total content of nickel and cobalt in the metal plate 55 may be 28 mass% or higher and 38 mass% or lower. In this case, specific examples of the iron alloy containing nickel or containing nickel and cobalt include an invar material, a super invar material, and an ultra invar material. An invar material is an iron alloy containing 34 mass% or higher and 38 mass% or lower of nickel, as well as iron and unavoidable impurities as remaining portions. A super invar material is an iron alloy containing 30 mass% or higher and 34 mass% or lower of nickel, cobalt, as well as iron and unavoidable impurities as remaining portions. An ultra invar material is an iron alloy containing 28 mass% or higher and 34 mass% or lower of nickel, 2 mass% or higher and 7 mass% or lower of cobalt, 0.1 mass% or higher and 1.0 mass% or lower of manganese, 0.10 mass% or lower of silicon, 0.01 mass% or lower of carbon, as well as iron and unavoidable impurities as remaining portions.

The mask 50 including the aforementioned iron alloy may be manufactured by plating.

During a deposition process, if the temperature of the mask 50, the frame 41, and the substrate 110 does not reach a high temperature, it is not particularly necessary to set the thermal expansion coefficient of the mask 50 and the frame 41 to a value equal to that of the thermal expansion coefficient of the substrate 110. In this case, the material used for forming the metal plate 55 may be a material other than the aforementioned iron alloy. For example, an iron alloy, such as an iron alloy containing chromium, other than the aforementioned iron alloy containing nickel may be used. As the iron alloy containing chromium, for example, an iron alloy called stainless steel may be used. Furthermore, an alloy, such as a nickel alloy or a nickel-cobalt alloy, other than the iron alloy may be used.

A thickness T of the mask 50 may be, for example, 8 µm or larger, 10 µm or larger, 15 µm or larger, or 20 µm or larger. The thickness T may be, for example, 25 µm or smaller, 30 µm or smaller, 50 µm or smaller, or 80 µor smaller. The range of the thickness T may be defined in accordance with a first group constituted of 8 pm, 10 pm, 15 pm, and 20 µm and/or a second group constituted of 25 pm, 30 pm, 50 pm, and 80 µm. The range of the thickness T may be defined in accordance with a combination of any one of the values included in the aforementioned first group and any one of the values included in the aforementioned second group. The range of the thickness T may be defined in accordance with a combination of any two of the values included in the aforementioned first group. The range of the thickness T may be defined in accordance with a combination of any two of the values included in the aforementioned second group. The thickness T may be, for example, 8 µm or larger and 80 µm or smaller, 8 µm or larger and 50 µm or smaller, 8 µm or larger and 30 µm or smaller, 8 µm or larger and 25 µm or smaller, 8 µm or larger and 20 µm or smaller, 8 µm or larger and 15 µm or smaller, 8 µm or larger and 10 µm or smaller, 10 µm or larger and 80 µm or smaller, 10 µm or larger and 50 µm or smaller, 10 µm or larger and 30 µm or smaller, 10 µm or larger and 25 µm or smaller, 10 µm or larger and 20 µm or smaller, 10 µm or larger and 15 µm or smaller, 15 µm or larger and 80 µm or smaller, 15 µm or larger and 50 µm or smaller, 15 µm or larger and 30 µm or smaller, 15 µm or larger and 25 µm or smaller, 15 µm or larger and 20 µm or smaller, 20 µm or larger and 80 µm or smaller, 20 µm or larger and 50 µm or smaller, 20 µm or larger and 30 µm or smaller, 20 µm or larger and 25 µm or smaller, 25 µm or larger and 80 µm or smaller, 25 µm or larger and 50 µm or smaller, 25 µm or larger and 30 µm or smaller, 30 µm or larger and 80 µm or smaller, 30 µm or larger and 50 µm or smaller, or 50 µm or larger and 80 µm or smaller. The thickness T of the mask 50 may be the thickness T of the metal plate 55.

By setting the thickness T to 80 µm or smaller, an instance where the deposition material 7 gets caught on the wall surface of each through-hole 56 before the deposition material 7 passes through the through-hole 56 can be suppressed. Accordingly, the utilization efficiency of the deposition material 7 can be enhanced. By setting the thickness T to 8 µm or larger, the strength of the mask 50 can be ensured, and the occurrence of damage and deformation in the mask 50 can be suppressed.

As a method for measuring the thickness T, a contact measurement method is employed. In detail, the thickness T is measured by using a high-precision digital measuring device called Litmatic VL-50S manufactured by Mitutoyo Corporation.

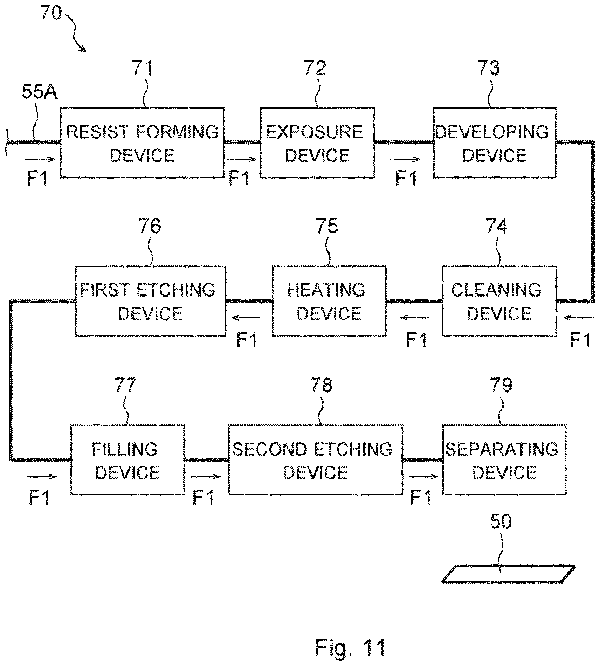

Next, a method for manufacturing the mask 50 will be described. Fig. 11 illustrates a manufacturing apparatus 70 for manufacturing the mask 50. The manufacturing apparatus 70 includes a resist forming device 71, an exposure device 72, a developing device 73, a resist cleaning device 74, a heating device 75, a first etching device 76, a filling device 77, a second etching device 78, and a separating device 79.

First, a metal plate wound into a roll is prepared. Then, the metal plate is unwound from the roll. The metal plate unwound from the roll is indicated by reference sign 55A. The metal plate 55A is conveyed sequentially to the resist forming device 71, the exposure device 72, the developing device 73, the resist cleaning device 74, the heating device 75, the first etching device 76, the filling device 77, the second etching device 78, and the separating device 79. In all of the devices from the resist forming device 71 to the separating device 79, the metal plate 55A may be conveyed continuously in the lengthwise direction thereof. Although not shown, the manufacturing method for the mask 50 may include a step of winding the metal plate 55A into a roll and a step of unwinding the metal plate 55A from the roll when the metal plate 55A is conveyed from one device to the subsequent device.

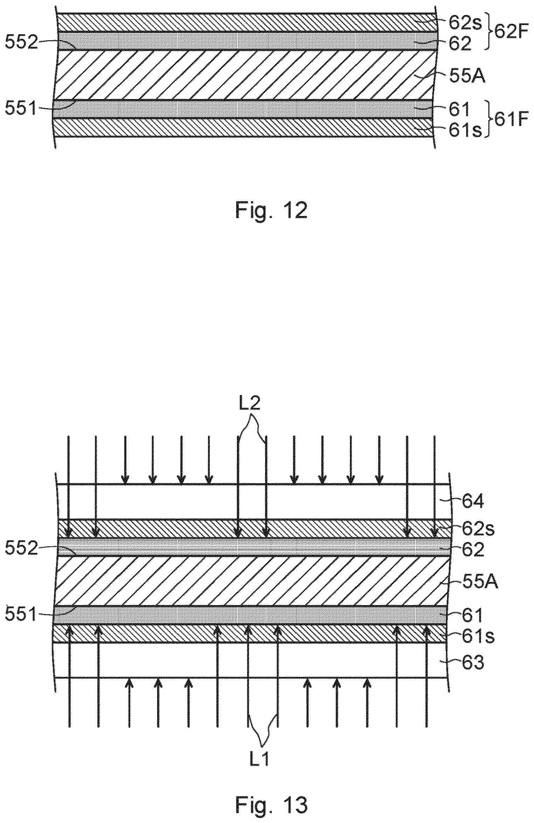

As shown in Fig. 12, the resist forming device 71 executes a resist forming step of forming a first resist layer 61 on the first surface 551 of the metal plate 55A and for forming a second resist layer 62 on the second surface 552. Each of the resist layers 61 and 62 may be a layer formed by coating a surface of the metal plate 55A with a solution containing a resist material and causing the solution to solidify. Alternatively, each of the resist layers 61 and 62 may be a layer formed by bonding a film, such as a dry film, onto the surface of the metal plate 55A.

The resist layer of the coating type is formed by coating the surface of the metal plate 55A with a solution containing a photosensitive material and causing the solution to solidify. In this case, a baking step of baking each of the resist layers 61 and 62 may be executed. The photosensitive material may be of a photo-soluble type, that is, a so-called positive type, or may be of a photo-curable type, that is, a so-called negative type.

The positive-type photosensitive material is, for example, a novolac-based positive resist, such as SC500. The negative-type photosensitive material is, for example, a casein resist. A negative-type resist layer may contain acrylic resin.

Fig. 12 is a cross-sectional view illustrating an example where the resist layers 61 and 62 are of a film type. As shown in Fig. 12, the resist forming step may involve bonding a first dry film 61F onto the first surface 551 and bonding a second dry film 62F onto the second surface 552. The first dry film 61F includes the first resist layer 61 and a first supporter 61s that supports the first resist layer 61. The first supporter 61s preferably has higher rigidity than the first resist layer 61. For example, the first supporter 61s may be a stretched plastic film. Examples of the stretched plastic film include a stretched polyester film, a stretched polyimide film, and a stretched polypropylene film. An example of the stretched polyester film is a stretched polyester terephthalate film (also referred to as a stretched PET film).

The second dry film 62F includes the second resist layer 62 and a second supporter 62s that supports the second resist layer 62. The second supporter 62s preferably has higher rigidity than the second resist layer 62. Similar to the first supporter 61s, for example, the second supporter 62s may also be a stretched plastic film.

The thickness of each of the resist layers 61 and 62 may be, for example, 1 µm or larger, 3 µm or larger, or 5 µm or larger. The thickness of each of the resist layers 61 and 62 may be, for example, 10 µm or smaller, 15 µm or smaller, or 20 µm or smaller. The range of the thickness of each resist layer may be defined in accordance with a first group constituted of 1 pm, 3 pm, and 5 µm and/or a second group constituted of 10 pm, 15 pm, and 20 µm. The range of the thickness of each resist layer may be defined in accordance with a combination of any one of the values included in the aforementioned first group and any one of the values included in the aforementioned second group. The range of the thickness of each resist layer may be defined in accordance with a combination of any two of the values included in the aforementioned first group. The range of the thickness of each resist layer may be defined in accordance with a combination of any two of the values included in the aforementioned second group. The thickness of each resist layer may be, for example, 1 µm or larger and 20 µm or smaller, 1 µm or larger and 15 µm or smaller, 1 µm or larger and 10 µm or smaller, 1 µm or larger and 5 µm or smaller, 1 µm or larger and 3 µm or smaller, 3 µm or larger and 20 µm or smaller, 3 µm or larger and 15 µm or smaller, 3 µm or larger and 10 µm or smaller, 3 µm or larger and 5 µm or smaller, 5 µm or larger and 20 µm or smaller, 5 µm or larger and 15 µm or smaller, 5 µm or larger and 10 µm or smaller, 10 µm or larger and 20 µm or smaller, 10 µm or larger and 15 µm or smaller, or 15 µm or larger and 20 µm or smaller.

The exposure device 72 executes an exposure step of exposing the first resist layer 61 to light and for exposing the second resist layer 62 to light. As shown in Fig. 13, first exposure light L1 is radiated onto the first resist layer 61 via a first exposure mask 63. Second exposure light L2 is radiated onto the second resist layer 62 via a second exposure mask 64. The exposure step may include a step of adjusting the position of the second exposure mask 64 relative to the first exposure mask 63.

The wavelength of each of the exposure light L1 and the exposure light L2 may be, for example, 180 nm or larger, 250 nm or larger, or 300 nm or larger. The wavelength of each of the exposure light L1 and the exposure light L2 may be, for example, 320 nm or smaller, 370 nm or smaller, or 400 nm or smaller. The range of the wavelength of each of the exposure light L1 and the exposure light L2 may be defined in accordance with a first group constituted of 180 nm, 250 nm, and 300 nm and/or a second group constituted of 320 nm, 370 nm, and 400 nm. The range of the wavelength of each of the exposure light L1 and the exposure light L2 may be defined in accordance with a combination of any one of the values included in the aforementioned first group and any one of the values included in the aforementioned second group. The range of the wavelength of each of the exposure light L1 and the exposure light L2 may be defined in accordance with a combination of any two of the values included in the aforementioned first group. The range of the wavelength of each of the exposure light L1 and the exposure light L2 may be defined in accordance with a combination of any two of the values included in the aforementioned second group. The wavelength of each of the exposure light L1 and the exposure light L2 may be, for example, 180 nm or larger and 400 nm or smaller, 180 nm or larger and 370 nm or smaller, 180 nm or larger and 320 nm or smaller, 180 nm or larger and 300 nm or smaller, 180 nm or larger and 250 nm or smaller, 250 nm or larger and 400 nm or smaller, 250 nm or larger and 370 nm or smaller, 250 nm or larger and 320 nm or smaller, 250 nm or larger and 300 nm or smaller, 300 nm or larger and 400 nm or smaller, 300 nm or larger and 370 nm or smaller, 300 nm or larger and 320 nm or smaller, 320 nm or larger and 400 nm or smaller, 320 nm or larger and 370 nm or smaller, 370 nm or larger and 400 nm or smaller.

As shown in Fig. 13, the exposure step may be executed in a state where the first supporter 61s is in contact with the first resist layer 61. In this case, light that has passed through the first exposure mask 63 is transmitted through the first supporter 61s and subsequently reaches the first resist layer 61. The exposure step may be executed in a state where the first exposure mask 63 is in contact with the first supporter 61s. Although not shown, the exposure step may be executed after the first supporter 61s is removed from the first resist layer 61.

As shown in Fig. 13, the exposure step may be executed in a state where the second supporter 62s is in contact with the second resist layer 62. In this case, light that has passed through the second exposure mask 64 is transmitted through the second supporter 62s and subsequently reaches the second resist layer 62. The exposure step may be executed in a state where the second exposure mask 64 is in contact with the second supporter 62s. Although not shown, the exposure step may be executed after the second supporter 62s is removed from the second resist layer 62.

As shown in Fig. 13, the exposure light L1 may be collimated light including a plurality of rays traveling parallel to each other. By using collimated light, the occurrence of a fringe, to be described later, in each resist layer can be suppressed. Similar to the exposure light L1, the exposure light L2 may also be collimated light including a plurality of rays traveling parallel to each other.

A declination angle of the collimated light may be, for example, 3.0° or smaller, 2.0° or smaller, or 1.0° or smaller. The declination angle is a maximum value of an angle formed between light coming from the center of a light source and the normal line to an irradiation surface irradiated with the collimated light. The declination angle is also referred to as central-ray parallelism. The declination angle of the collimated light may be 0.1° or larger.

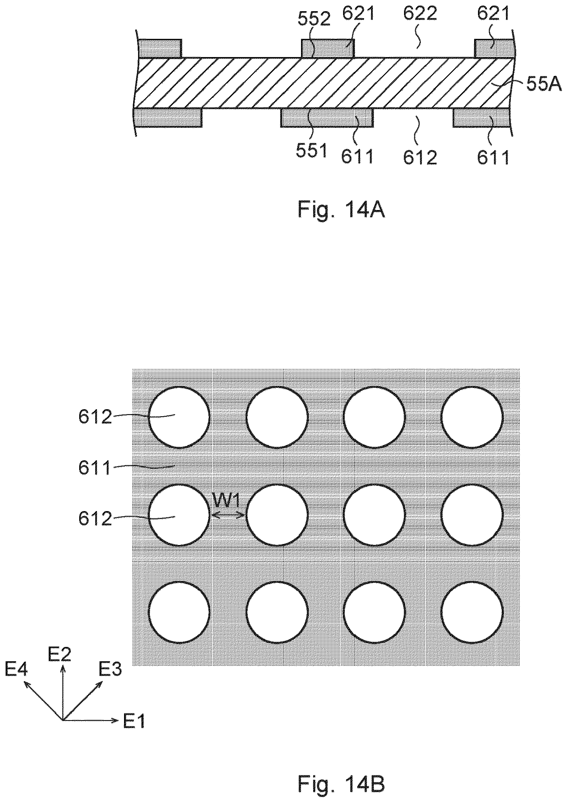

The developing device 73 executes a developing step of developing the first resist layer 61 and for developing the second resist layer 62. Accordingly, as shown in Fig. 14A, first openings 612 are formed in the first resist layer 61, and second openings 622 are formed in the second resist layer 62. The first resist layer 61 having the first openings 612 formed therein is also referred to as a first resist pattern 611. The second resist layer 62 having the second openings 622 formed therein is also referred to as a second resist pattern 621.

A step of forming the first resist pattern 611 on the first surface 551 and a step of forming the second resist pattern 621 on the second surface 552 are also referred to as a resist-pattern forming step. The resist-pattern forming step includes the resist forming step, the exposure step, and the developing step described above. The exposure step and the developing step are also referred to as a patterning step.

Fig. 14B is a plan view illustrating the metal plate 55A shown in Fig. 14A, as viewed from the first surface 551 side. The first resist pattern 611 has a width W1. The width W1 is a minimum value of the distance between two first openings 612.

The width W1 may be, for example, 10 µm or larger, 15 µm or larger, 20 µm or larger, 25 µm or larger, or 30 µm or larger. The width W1 may be, for example, 40 µm or smaller, 50 µm or smaller, or 60 µm or smaller. The range of the width W1 may be defined in accordance with a first group constituted of 10 pm, 15 µm, 20 µm, 25 µm, and 30 µm and/or a second group constituted of 40 µm, 50 µm, and 60 µm. The range of the width W1 may be defined in accordance with a combination of any one of the values included in the aforementioned first group and any one of the values included in the aforementioned second group. The range of the width W1 may be defined in accordance with a combination of any two of the values included in the aforementioned first group. The range of the width W1 may be defined in accordance with a combination of any two of the values included in the aforementioned second group. The width W1 may be, for example, 10 µm or larger and 60 µm or smaller, 10 µm or larger and 50 µm or smaller, 10 µm or larger and 40 µm or smaller, 10 µm or larger and 30 µm or smaller, 10 µm or larger and 25 µm or smaller, 10 µm or larger and 20 µm or smaller, 10 µm or larger and 15 µm or smaller, 15 µm or larger and 60 µm or smaller, 15 µm or larger and 50 µm or smaller, 15 µm or larger and 40 µm or smaller, 15 µm or larger and 30 µm or smaller, 15 µm or larger and 25 µm or smaller, 15 µm or larger and 20 µm or smaller, 20 µm or larger and 60 µm or smaller, 20 µm or larger and 50 µm or smaller, 20 µm or larger and 40 µm or smaller, 20 µm or larger and 30 µm or smaller, 20 µm or larger and 25 µm or smaller, 25 µm or larger and 60 µm or smaller, 25 µm or larger and 50 µm or smaller, 25 µm or larger and 40 µm or smaller, 25 µm or larger and 30 µm or smaller, 30 µm or larger and 60 µm or smaller, 30 µm or larger and 50 µm or smaller, 30 µm or larger and 40 µm or smaller, 40 µm or larger and 60 µm or smaller, 40 µm or larger and 50 µm or smaller, or 50 µm or larger and 60 µm or smaller.

The width W1 is calculated by measuring the shape of the first resist pattern 611 from the first surface 551 side. In detail, the width W1 is calculated by averaging out measurement results of the first resist pattern 611 adjacent to 100 first openings 612. The 100 first openings 612 are a set of 10 rows by 10 rows of first openings 612 located in the middle of a group of first openings 612 corresponding to the through-hole group 53. A measuring device used is a digital microscope VHX-7000 manufactured by Keyence Corporation.

The resist cleaning device 74 executes a resist cleaning step of cleaning the first resist pattern 611 by using a cleaning liquid. The resist cleaning step may involve cleaning the first resist pattern 611 and the second resist pattern 621.

The heating device 75 executes a heating step of heating the first resist pattern 611 to a processing temperature. The heating step may involve heating the second resist pattern 621 to the processing temperature in addition to the first resist pattern 611. By executing the heating step, the adhesiveness of the first resist pattern 611 and the second resist pattern 621 to the metal plate 55A can be enhanced.

After the resist cleaning step, an irradiating step of irradiating the first resist pattern 611 and the second resist pattern 621 with ultraviolet light may be executed. By executing the irradiating step, the adhesiveness of the first resist pattern 611 and the second resist pattern 621 to the metal plate 55A can be enhanced.

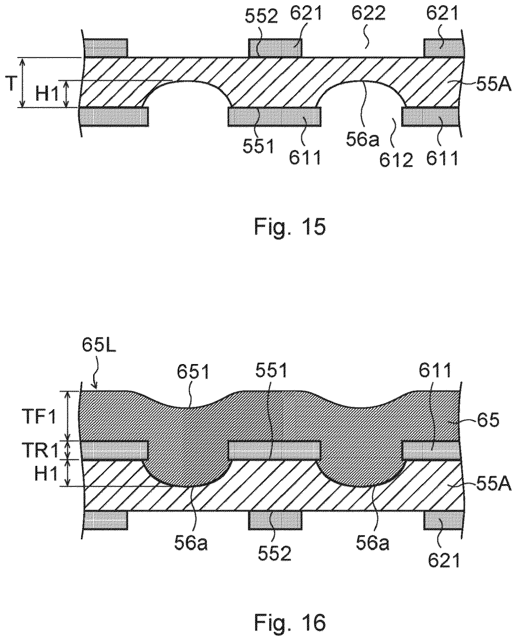

The first etching device 76 executes the first etching step of etching the first surface 551 by using a first etchant. The first etchant enters the first openings 612, so that the first recesses 56a are formed in the first surface 551, as shown in Fig. 15.

The first etching step may involve ejecting the first etchant toward the first surface 551. As shown in Fig. 15, the first etching step may be executed in a state where the first surface 551 is located below the second surface 552. In this case, the first etchant coming into contact with the metal plate 55 can drop from the metal plate 55 due to a gravitational force. Accordingly, an instance where the first etchant that has melted the material of the metal plate 55 continues to be in contact with the first surface 551 can be suppressed.

The first recesses 56a do not extend through the metal plate 55. Therefore, a depth H1 of each first recess 56a is smaller than the thickness T of the metal plate 55. The depth H1 may be, for example, 2 µm or larger, 3 µm or larger, or 5 µm or larger. The depth H1 may be, for example, 20 µm or smaller, 30 µm or smaller, or 45 µm or smaller. The range of the depth H1 may be defined in accordance with a first group constituted of 2 pm, 3 pm, and 5 µm and/or a second group constituted of 20 pm, 30 pm, and 45 µm. The range of the depth H1 may be defined in accordance with a combination of any one of the values included in the aforementioned first group and any one of the values included in the aforementioned second group. The range of the depth H1 may be defined in accordance with a combination of any two of the values included in the aforementioned first group. The range of the depth H1 may be defined in accordance with a combination of any two of the values included in the aforementioned second group. The depth H1 may be, for example, 2 µm or larger and 45 µm or smaller, 2 µm or larger and 30 µm or smaller, 2 µm or larger and 20 µm or smaller, 2 µm or larger and 5 µm or smaller, 2 µm or larger and 3 µm or smaller, 3 µm or larger and 45 µm or smaller, 3 µm or larger and 30 µm or smaller, 3 µm or larger and 20 µm or smaller, 3 µm or larger and 5 µm or smaller, 5 µm or larger and 45 µm or smaller, 5 µm or larger and 30 µm or smaller, 5 µm or larger and 20 µm or smaller, 20 µm or larger and 45 µm or smaller, 20 µm or larger and 30 µm or smaller, or 30 µm or larger and 45 µm or smaller.

An upper limit for the depth H1 may be defined in accordance with the thickness T of the metal plate 55. For example, the depth H1 may be (T - 5) µm or smaller. If the thickness T is 20 µm or larger, the depth H1 may be (T - 10) µm or smaller. If the thickness T is 30 µm or larger, the depth H1 may be (T - 20) µm or smaller.

A ratio H1/T of the depth H1 to the thickness T may be, for example, 0.10 or higher, 0.20 or higher, or 0.30 or higher. The ratio H1/T may be, for example, 0.50 or lower, 0.70 or lower, or 0.90 or lower. The range of H1/T may be defined in accordance with a first group constituted of 0.10, 0.20, and 0.30 and/or a second group constituted of 0.50, 0.70, and 0.90. The range of H1/T may be defined in accordance with a combination of any one of the values included in the aforementioned first group and any one of the values included in the aforementioned second group. The range of H1/T may be defined in accordance with a combination of any two of the values included in the aforementioned first group. The range of H1/T may be defined in accordance with a combination of any two of the values included in the aforementioned second group. The ratio H1/T may be, for example, 0.10 or higher and 0.90 or lower, 0.10 or higher and 0.70 or lower, 0.10 or higher and 0.50 or lower, 0.10 or higher and 0.30 or lower, 0.10 or higher and 0.20 or lower, 0.20 or higher and 0.90 or lower, 0.20 or higher and 0.70 or lower, 0.20 or higher and 0.50 or lower, 0.20 or higher and 0.30 or lower, 0.30 or higher and 0.90 or lower, 0.30 or higher and 0.70 or lower, 0.30 or higher and 0.50 or lower, 0.50 or higher and 0.90 or lower, 0.50 or higher and 0.70 or lower, or 0.70 or higher and 0.90 or lower.

A ratio H1/r1 of the depth H1 to the dimension r1 of the first outline 561 of each first recess 56a may be, for example, 0.10 or higher, 0.15 or higher, or 0.20 or higher. The ratio H1/r1 may be, for example, 0.30 or lower, 0.40 or lower, or 0.50 or lower. The range of H1/r1 may be defined in accordance with a first group constituted of 0.10, 0.15, and 0.20 and/or a second group constituted of 0.30, 0.40, and 0.50. The range of H1/r1 may be defined in accordance with a combination of any one of the values included in the aforementioned first group and any one of the values included in the aforementioned second group. The range of H1/r1 may be defined in accordance with a combination of any two of the values included in the aforementioned first group. The range of H1/r1 may be defined in accordance with a combination of any two of the values included in the aforementioned second group. The ratio H1/r1 may be, for example, 0.10 or higher and 0.50 or lower, 0.10 or higher and 0.40 or lower, 0.10 or higher and 0.30 or lower, 0.10 or higher and 0.20 or lower, 0.10 or higher and 0.15 or lower, 0.15 or higher and 0.50 or lower, 0.15 or higher and 0.40 or lower, 0.15 or higher and 0.30 or lower, 0.15 or higher and 0.20 or lower, 0.20 or higher and 0.50 or lower, 0.20 or higher and 0.40 or lower, 0.20 or higher and 0.30 or lower, 0.30 or higher and 0.50 or lower, 0.30 or higher and 0.40 or lower, or 0.40 or higher and 0.50 or lower.

The ranges of the depth H1, the ratio H1/T, and the ratio H1/r1 may be defined in accordance with the range of the thickness T of the metal plate 55. For example, if the thickness T is 10 µm or larger and 15 µm or smaller, the depth H1 may be 2.0 µm or larger and 5.0 µm or smaller, the ratio H1/T may be 0.20 or higher and 0.50 or lower, the dimension r1 may be 10 µm or larger and 20 µm or smaller, and the ratio H1/r1 may be 0.20 or higher and 0.25 or lower.

As shown in Fig. 16, the filling device 77 executes a filling step of filling the first recesses 56a with resin 65. As shown in Fig. 16, the filling step may involve forming a resin layer 65L that covers the first resist pattern 611. The first recesses 56a are filled with the resin 65 constituting the resin layer 65L. The filling step is executed in a state where the first surface 551 is located above the second surface 552.

The resin 65 has resistance to a second etchant used in the second etching step, to be described later. By filling the first recesses 56a with the resin 65, entry of the second etchant into the first recesses 56a during the second etching step can be suppressed.

A thickness TF1 of the resin layer 65L is larger than the depth H1 of each first recess 56a. The thickness TF1 of the resin layer 65L is larger than a thickness TR1 of the first resist pattern 611. The thickness TF1 of the resin layer 65L is the distance, in the thickness direction, from the surface of the resin layer 65L to the surface of the first resist pattern 611.

As shown in Fig. 16, the surface of the resin layer 65L may be provided with depressions 651. The depressions 651 are formed as a result of the resin 65 constituting the resin layer 65L flowing toward the first recesses 56a. The depressions 651 may be provided at positions overlapping the first recesses 56a in the thickness direction.

The thickness TR1, the thickness TF1, and the depth H1 are calculated based on a cross-sectional image of a sample of a laminated body including the resin layer 65L, the first resist pattern 611, and the metal plate 55A. The cross-sectional image is calculated by observing a cross section of the sample using a scanning electronic microscope. The scanning electronic microscope used is a scanning electronic microscope ULTRA55 manufactured by ZEISS.

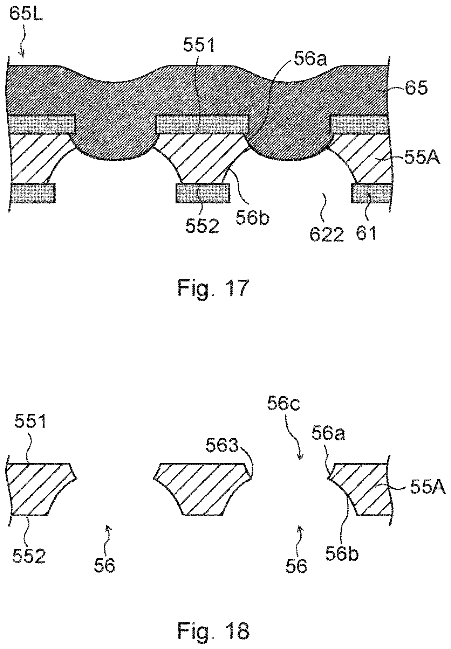

The second etching device 78 executes the second etching step of etching the second surface 552 by using the second etchant. The second etchant enters the second openings 622, whereby the second recesses 56b are formed in the second surface 552, as shown in Fig. 17.

The second etching step may involve ejecting the second etchant toward the second surface 552. As shown in Fig. 17, the second etching step may be executed in a state where the second surface 552 is located below the first surface 551. In this case, the second etchant coming into contact with the metal plate 55 can drop from the metal plate 55 due to a gravitational force. Accordingly, an instance where the second etchant that has melted the material of the metal plate 55 continues to be in contact with the metal plate 55 can be suppressed.

After the second etching step, a removing step may be executed. The removing step may include a resin removing step of removing the resin 65. The resin 65 is removed by using, for example, an alkaline removal liquid. The removing step may include a resist removing step of removing the first resist pattern 611 and the second resist pattern 621. The first resist pattern 611 and the second resist pattern 621 may be removed simultaneously with the resin 65 by using the alkaline removal liquid. After the resin 65 is removed, a removal liquid different from the removal liquid used for removing the resin 65 may be used to remove the first resist pattern 611 and the second resist pattern 621. Fig. 18 is a cross-sectional view illustrating the metal plate 55A in a state where the resin 65, the first resist pattern 611, and the second resist pattern 621 have been removed therefrom.

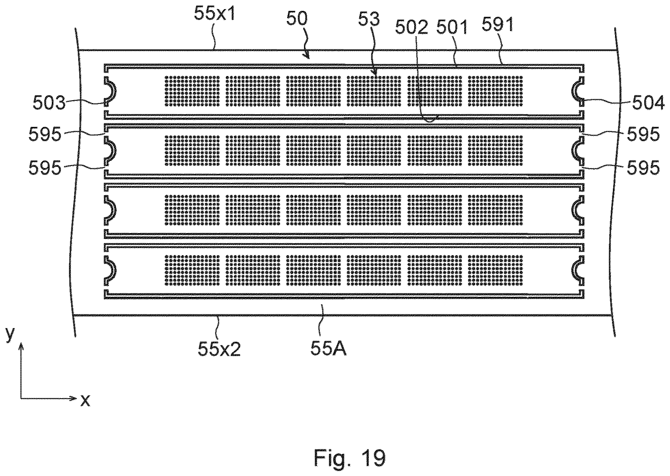

Fig. 19 is a plan view illustrating the metal plate 55A provided with through-hole groups 53. In Fig. 19, reference sign x denotes the longitudinal direction of the metal plate 55A, and reference sign y denotes the width direction of the metal plate 55A. The longitudinal direction x matches a conveying direction F1 mentioned above. The width direction y is orthogonal to the longitudinal direction x. The metal plate 55A includes a first side edge 55x1 and a second side edge 55x2.

As shown in Fig. 19, in a state before masks 50 are separated from the metal plate 55A, a plurality of masks 50 may be arranged in the width direction y of the metal plate 55A. The metal plate 55A may include outer edge holes 591 that define the outer edges of the masks 50. The outer edges of each mask 50 may be connected to bridges 595. The bridges 595 may be connected to the first end 503 and the second end 504.

The separating device 79 executes a separating step of separating the masks 50 from the metal plate 55A. By breaking the bridges 595, each mask 50 can be separated from the metal plate 55A. Accordingly, the masks 50 are obtained.

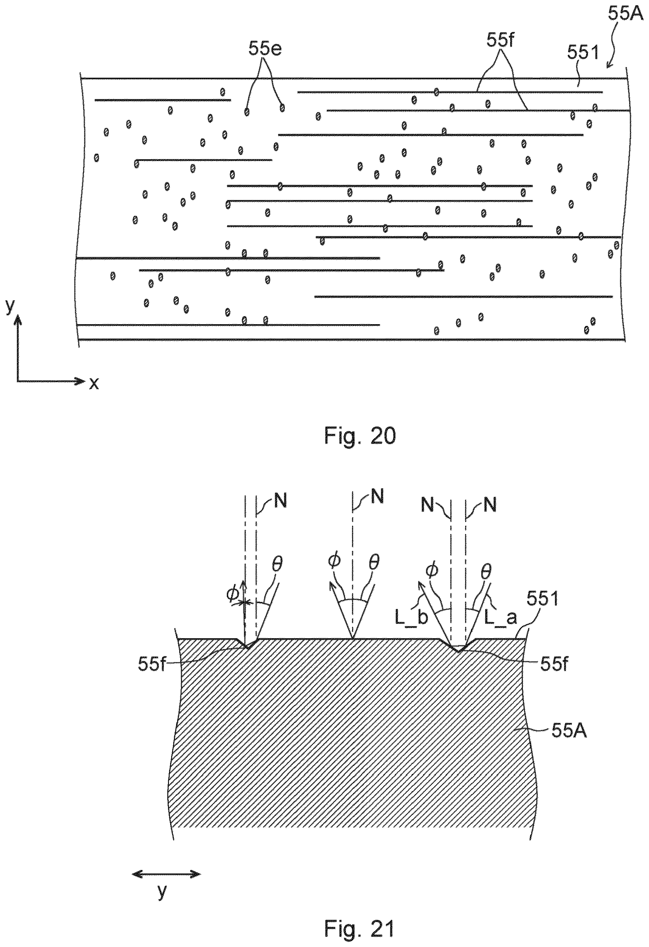

After performing studies, the present inventors have observed a phenomenon where the dimensional accuracy of the through-holes 56 in the mask 50 has deteriorated due to recesses in the surface of the metal plate 55A. The recesses in the surface are, for example, rolling streaks and oil pits. Fig. 20 is a plan view illustrating an example of the first surface 551 of the metal plate 55A. The first surface 551 of the metal plate 55A may include a plurality of rolling streaks 55f extending in the longitudinal direction x and a plurality of oil pits 55e. The rolling streaks 55f are recesses appearing in the surface of the metal plate 55A in the rolling direction. The oil pits 55e are recesses appearing in the surface of the metal plate 55A due to rolling oil remaining on the surface of the metal plate 55A during a rolling step.

In the rolling step, the rolling oil is supplied between the metal plate before being rolled and a rolling roller. If a recess is formed in the surface of the metal plate before being rolled, the rolling oil enters the recess. The recess formed in the surface of the metal plate before being rolled is also referred to as an initial recess. The initial recess is formed as a result of, for example, erosion of a grain boundary. A portion of the rolling oil entering the initial recess is discharged from the initial recess during rolling, whereas the remaining portion remains in the initial recess even after the rolling. The initial recess having the rolling oil remaining therein occurs as an oil pit 55e in the surface of the metal plate 55A.

Fig. 21 is a cross-sectional view illustrating an example of light reflection occurring at the metal plate 55A. In the example shown in Fig. 21, the metal plate 55A is cut in the width direction y. The cross section of the metal plate 55A has rolling streaks 55f appearing therein. Reference sign L_a denotes light incident on the first surface 551. Reference sign θ denotes an incident angle of the incident light L_a. Reference sign L_b denotes light reflected at the first surface 551. Reference sign ϕ denotes an output angle of the reflected light L_b. A single-dot chain line that is given reference sign N denotes the normal direction to the first surface 551.

As shown in Fig. 21, in a region not having recesses, such as the rolling streaks 55f, the output angle ϕ of the reflected light L_b is substantially equal to the incident angle θ of the incident light L_a. Specifically, regular reflection has occurred at the first surface 551. On the other hand, in a region having recesses, such as the rolling streaks 55f, the output angle ϕ of the reflected light L_b has deviated from the incident angle θ of the incident light L_a. In some of the rolling streaks 55f, the output angle ϕ is larger than the incident angle θ. In some of the rolling streaks 55f, the output angle ϕ is smaller than the incident angle θ. The reflected light L_b having the output angle ϕ different from the incident angle θ is also referred to as diffusion light. The recesses, such as the rolling streaks 55f, cause diffusion light to occur.

The rolling streaks 55f extend in the longitudinal direction x. Therefore, the diffusion light occurring due to the rolling streaks 55f tends to occur within a plane parallel to the normal direction N to the first surface 551 and the width direction y, as shown in Fig. 21. In other words, the rolling streaks 55f tend to cause light traveling in the width direction y in plan view to diffuse. In the following description, light traveling in the width direction y in plan view and incident on the surface of the metal plate 55A will also be referred to as first incident light. Light traveling in the longitudinal direction x in plan view and incident on the surface of the metal plate 55A will also be referred to as second incident light.

The rolling streaks 55f tend to cause the first incident light to diffuse more than the second incident light. Specifically, the rolling streaks 55f have directional dependency with respect to diffusion light. On the other hand, the directional dependency of the shape of the oil pits 55e in plan view is smaller than the directional dependency of the shape of the rolling streaks 55f. Therefore, the directional dependency with respect to diffusion light in the oil pits 55e is smaller than the directional dependency with respect to diffusion light in the rolling streaks 55f.

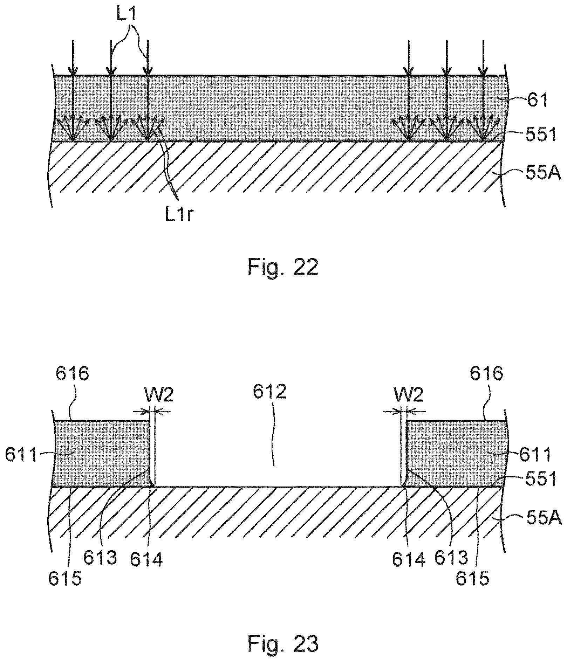

The relationship between the diffusion light occurring at the surface of the metal plate 55A and the dimensional accuracy of the through-holes 56 in the mask 50 will now be described with reference to Fig. 22 to Fig. 25. Fig. 22 is a cross-sectional view illustrating an example where light is reflected at the surface of the metal plate 55A in the exposure step. Reference sign L1r denotes diffusion light occurring as a result of reflection of the exposure light L1 at the first surface 551. In the example shown in Fig. 22, the first resist layer 61 includes a negative-type photosensitive material.

Fig. 23 is a cross-sectional view illustrating an example of the first resist pattern 611 formed by developing the first resist layer 61 shown in Fig. 22. The first resist pattern 611 includes a first resist layer, a first opening 612 formed in the first resist layer, and a wall surface 613 of the first resist layer facing the first opening 612. When diffusion light occurs, the first resist layer 61 located at a position where the first opening 612 is to be formed is exposed to the light. As a result, a fringe 614 occurs at the wall surface 613. The fringe 614 is a part of the first resist layer protruding at a corner toward the center of the first opening 612 in plan view. The corner is where a surface 615 of the first resist pattern 611 facing the first surface 551 of the metal plate 55A connects to the wall surface 613. The fringe 614 has a width W2 in plan view.

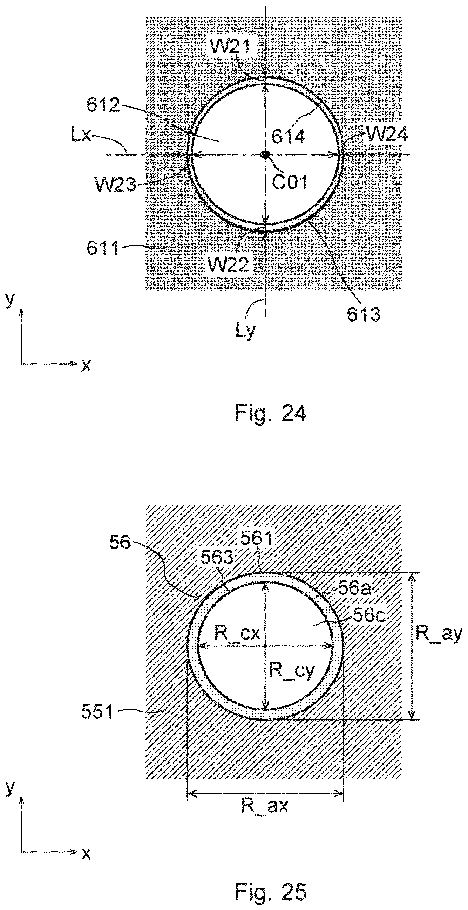

Fig. 24 is a plan view illustrating an example of the first resist pattern 611 including the fringe 614. In the first etching step, the etching of a region of the first surface 551 overlapping the fringe 614 is hindered by the fringe 614. As a result, the dimensional accuracy of the first recess 56a of each through-hole 56 deteriorates.

Fig. 25 is a plan view illustrating an example of the first recess 56a and the through-portion 56c of each through-hole 56. Reference sign R_ay denotes a dimension of the first outline 561 of the first recess 56a in the width direction y, and reference sign R_ax denotes a dimension of the first outline 561 of the first recess 56a in the longitudinal direction x. Reference sign R_cy denotes a dimension of the through-portion 56c in the width direction y, and reference sign R_cx denotes a dimension of the through-portion 56c in the longitudinal direction x. The dimension R_cy is also referred to as a first through-dimension. The dimension R_cx is also referred to as a second through-dimension. Either one of the dimensional accuracy of the first outline 561 and the dimensional accuracy of the through-portion 56c may also possibly be affected by the fringe 614 in the first resist pattern 611.

As will be described later, the metal plate 55A according to the embodiment of the present disclosure can suppress the occurrence of the fringe 614. For example, the width W2 of the fringe 614 can be reduced. Thus, the first recess 56a of the through-hole 56 has high dimensional accuracy. Accordingly, the accuracy of the deposition layer of the organic device 100 can be enhanced.

In Fig. 24, reference signs W21 and W22 denote widths of the fringe 614 in the width direction y, and reference signs W23 and W24 denote widths of the fringe 614 in the longitudinal direction x. The width W2 of the fringe 614 corresponding to one first opening 612 is calculated by averaging out the widths W21, W22, W23, and W24.

The width of the fringe 614 may be, for example, 0.01 µm or larger, 0.10 µm or larger, or 0.20 µm or larger. The width of the fringe 614 may be, for example, 0.40 µm or smaller, 0.70 µm or smaller, or 1.00 µm or smaller. The range of the width of the fringe 614 may be defined in accordance with a first group constituted of 0.01 pm, 0.10 pm, and 0.20 µm and/or a second group constituted of 0.40 pm, 0.70 pm, and 1.00 µm. The range of the width of the fringe 614 may be defined in accordance with a combination of any one of the values included in the aforementioned first group and any one of the values included in the aforementioned second group. The range of the width of the fringe 614 may be defined in accordance with a combination of any two of the values included in the aforementioned first group. The range of the width of the fringe 614 may be defined in accordance with a combination of any two of the values included in the aforementioned second group. The width of the fringe 614 may be, for example, 0.01 µm or larger and 1.00 µm or smaller, 0.01 µm or larger and 0.70 µm or smaller, 0.01 µm or larger and 0.40 µm or smaller, 0.01 µm or larger and 0.20 µm or smaller, 0.01 µm or larger and 0.10 µm or smaller, 0.10 µm or larger and 1.00 µm or smaller, 0.10 µm or larger and 0.70 µm or smaller, 0.10 µm or larger and 0.40 µm or smaller, 0.10 µm or larger and 0.20 µm or smaller, 0.20 µm or larger and 1.00 µm or smaller, 0.20 µm or larger and 0.70 µm or smaller, 0.20 µm or larger and 0.40 µm or smaller, 0.40 µm or larger and 1.00 µm or smaller, 0.40 µm or larger and 0.70 µm or smaller, or 0.70 µm or larger and 1.00 µm or smaller.

The width of the fringe 614 is calculated by averaging out the widths W2 of fringes 614 occurring at the wall surfaces 613 facing five first openings 612. The five first openings 612 are arranged in the longitudinal direction x at the center of the through-hole group 53 located in the middle of the corresponding mask 50 in the longitudinal direction x.

As mentioned above, the diffusion light L1r tends to occur readily in the width direction y in each rolling streak 55f. Therefore, with regard to the fringe 614 occurring due to the rolling streak 55f, the widths W21 and W22 in the width direction y tend to be larger than the widths W23 and W24 in the longitudinal direction x. As a result, the dimension of the through-hole 56 in the width direction y tends to be smaller than the dimension of the through-hole 56 in the longitudinal direction x. For example, the dimension R_ay of the first outline 561 in the width direction y tends to be smaller than the dimension R_ax of the first outline 561 in the longitudinal direction x. For example, the first through-dimension R_cy of the through-portion 56c in the width direction y tends to be smaller than the second through-dimension R_cx of the through-portion 56c in the longitudinal direction x.

In the metal plate 55A according to the embodiment of the present disclosure, the rolling streaks 55f may be reduced. By reducing the rolling streaks 55f, the occurrence of a phenomenon where the dimension of each through-hole 56 in the width direction y becomes smaller than the dimension of each through-hole 56 in the longitudinal direction x can be suppressed. Consequently, for example, a ratio of the dimension R_ay to the dimension R_ax becomes closer to 1.00. For example, a ratio of the first through-dimension R_cy to the second through-dimension R_cx becomes closer to 1.00.

The ratio of the dimension R_ay to the dimension R_ax may be, for example, 0.95 or higher, 0.98 or higher, or 0.99 or higher. The ratio of the dimension R_ay to the dimension R_ax may be, for example, 1.00 or lower, 1.01 or lower, or 1.02 or lower. The range of the ratio of the dimension R_ay to the dimension R_ax may be defined in accordance with a first group constituted of 0.95, 0.98, and 0.99 and/or a second group constituted of 1.00, 1.01, and 1.02. The range of the ratio of the dimension R_ay to the dimension R_ax may be defined in accordance with a combination of any one of the values included in the aforementioned first group and any one of the values included in the aforementioned second group. The range of the ratio of the dimension R_ay to the dimension R_ax may be defined in accordance with a combination of any two of the values included in the aforementioned first group. The range of the ratio of the dimension R_ay to the dimension R_ax may be defined in accordance with a combination of any two of the values included in the aforementioned second group. The ratio of the dimension R_ay to the dimension R_ax may be, for example, 0.95 or higher and 1.02 or lower, 0.95 or higher and 1.01 or lower, 0.95 or higher and 1.00 or lower, 0.95 or higher and 0.99 or lower, 0.95 or higher and 0.98 or lower, 0.98 or higher and 1.02 or lower, 0.98 or higher and 1.01 or lower, 0.98 or higher and 1.00 or lower, 0.98 or higher and 0.99 or lower, 0.99 or higher and 1.02 or lower, 0.99 or higher and 1.01 or lower, 0.99 or higher and 1.00 or lower, 1.00 or higher and 1.02 or lower, 1.00 or higher and 1.01 or lower, or 1.01 or higher and 1.02 or lower.

The ratio of the first through-dimension R_cy to the second through-dimension R_cx may be, for example, 0.95 or higher, 0.98 or higher, or 0.99 or higher. The ratio of the first through-dimension R_cy to the second through-dimension R_cx may be, for example, 1.00 or lower, 1.01 or lower, or 1.02 or lower. The range of the ratio of the first through-dimension R_cy to the second through-dimension R_cx may be defined in accordance with a first group constituted of 0.95, 0.98, and 0.99 and/or a second group constituted of 1.00, 1.01, and 1.02. The range of the ratio of the first through-dimension R_cy to the second through-dimension R_cx may be defined in accordance with a combination of any one of the values included in the aforementioned first group and any one of the values included in the aforementioned second group. The range of the ratio of the first through-dimension R_cy to the second through-dimension R_cx may be defined in accordance with a combination of any two of the values included in the aforementioned first group. The range of the ratio of the first through-dimension R_cy to the second through-dimension R_cx may be defined in accordance with a combination of any two of the values included in the aforementioned second group. The ratio of the first through-dimension R_cy to the second through-dimension R_cx may be, for example, 0.95 or higher and 1.02 or lower, 0.95 or higher and 1.01 or lower, 0.95 or higher and 1.00 or lower, 0.95 or higher and 0.99 or lower, 0.95 or higher and 0.98 or lower, 0.98 or higher and 1.02 or lower, 0.98 or higher and 1.01 or lower, 0.98 or higher and 1.00 or lower, 0.98 or higher and 0.99 or lower, 0.99 or higher and 1.02 or lower, 0.99 or higher and 1.01 or lower, 0.99 or higher and 1.00 or lower, 1.00 or higher and 1.02 or lower, 1.00 or higher and 1.01 or lower, or 1.01 or higher and 1.02 or lower.

Next, the metal plate 55A according to the embodiment of the present disclosure will be described. The metal plate 55A includes a surface where the occurrence of diffusion light is suppressed. The surface where the occurrence of diffusion light is suppressed may be the first surface 551 or the second surface 552. The first surface 551 and the second surface 552 may both be surfaces where the occurrence of diffusion light is suppressed. The following description relates to an example where the first surface 551 is the surface where the occurrence of diffusion light is suppressed.

The first surface 551 of the metal plate 55A may have a first reflectance R1, a second reflectance R2, a third reflectance R3, and a fourth reflectance R4. A ratio R3/R1 of the third reflectance R3 to the first reflectance R1 is also referred to as a first ratio. A ratio R4/R2 of the fourth reflectance R4 to the second reflectance R2 is also referred to as a second ratio. The metal plate 55A preferably has the first ratio R3/R1 and the second ratio R4/R2 that are reduced. As supported by Examples, to be described later, the metal plate 55A having the reduced first ratio R3/R1 and the reduced second ratio R4/R2 can suppress the occurrence of the fringe 614 in the first resist pattern 611.

The first reflectance R1 is the reflectance of first reflected light L_by having a first output angle ϕ1. The third reflectance R3 is the reflectance of the first reflected light L_by having a third output angle ϕ3. The first reflected light L_by is reflected light of first incident light L_ay reflected at the first surface 551. The first incident light L_ay is light traveling in the width direction y in plan view and incident on the first surface 551 at a first specific incident angle Θ1. The first specific incident angle Θ1 is, for example, 20°.

Diffusion of light at the surface of the metal plate 55A cannot be completely avoided. Therefore, the first reflected light L_by has an intensity distribution according to the output angle within a plane parallel to the normal direction N to the first surface 551 and the width direction y. The first output angle ϕ1 is an output angle at which the first reflected light L_by indicates a maximum intensity. The third output angle ϕ3 is an output angle different from the first output angle ϕ1 by a first deviation angle ϕd1. The first deviation angle ϕd1 is, for example, 2.5°.

The second reflectance R2 is the reflectance of second reflected light L_bx having a second output angle ϕ2. The fourth reflectance R4 is the reflectance of the second reflected light L_bx having a fourth output angle ϕ4. The second reflected light L_bx is reflected light of second incident light L_ax reflected at the first surface 551. The second incident light L_ax is light traveling in the longitudinal direction x in plan view and incident on the first surface 551 at a second specific incident angle Θ2. The second specific incident angle Θ2 is, for example, 20°.

The second reflected light L_bx has an intensity distribution according to the output angle within a plane parallel to the normal direction N to the first surface 551 and the longitudinal direction x. The second output angle ϕ2 is an output angle at which the second reflected light L_bx indicates a maximum intensity. The fourth output angle ϕ4 is an output angle different from the second output angle ϕ2 by a second deviation angle ϕd2. The second deviation angle ϕd2 is, for example, 2.5°.

The first ratio R3/R1 may be, for example, 0.00 or higher, 0.05 or higher, or 0.10 or higher. The first ratio R3/R1 may be, for example, 0.20 or lower, 0.30 or lower, or 0.40 or lower. The range of the first ratio R3/R1 may be defined in accordance with a first group constituted of 0.00, 0.05, and 0.10 and/or a second group constituted of 0.20, 0.30, and 0.40. The range of the first ratio R3/R1 may be defined in accordance with a combination of any one of the values included in the aforementioned first group and any one of the values included in the aforementioned second group. The range of the first ratio R3/R1 may be defined in accordance with a combination of any two of the values included in the aforementioned first group. The range of the first ratio R3/R1 may be defined in accordance with a combination of any two of the values included in the aforementioned second group. The first ratio R3/R1 may be, for example, 0.00 or higher and 0.40 or lower, 0.00 or higher and 0.30 or lower, 0.00 or higher and 0.20 or lower, 0.00 or higher and 0.10 or lower, 0.00 or higher and 0.05 or lower, 0.05 or higher and 0.40 or lower, 0.05 or higher and 0.30 or lower, 0.05 or higher and 0.20 or lower, 0.05 or higher and 0.10 or lower, 0.10 or higher and 0.40 or lower, 0.10 or higher and 0.30 or lower, 0.10 or higher and 0.20 or lower, 0.20 or higher and 0.40 or lower, 0.20 or higher and 0.30 or lower, or 0.30 or higher and 0.40 or lower.

Similar to the first ratio R3/R1, the second ratio R4/R2 is also reduced. The second ratio R4/R2 may be, for example, 0.00 or higher, 0.05 or higher, or 0.10 or higher. The second ratio R4/R2 may be, for example, 0.20 or lower, 0.30 or lower, or 0.40 or lower. The range of the second ratio R4/R2 may be defined in accordance with a first group constituted of 0.00, 0.05, and 0.10 and/or a second group constituted of 0.20, 0.30, and 0.40. The range of the second ratio R4/R2 may be defined in accordance with a combination of any one of the values included in the aforementioned first group and any one of the values included in the aforementioned second group. The range of the second ratio R4/R2 may be defined in accordance with a combination of any two of the values included in the aforementioned first group. The range of the second ratio R4/R2 may be defined in accordance with a combination of any two of the values included in the aforementioned second group. The second ratio R4/R2 may be, for example, 0.00 or higher and 0.40 or lower, 0.00 or higher and 0.30 or lower, 0.00 or higher and 0.20 or lower, 0.00 or higher and 0.10 or lower, 0.00 or higher and 0.05 or lower, 0.05 or higher and 0.40 or lower, 0.05 or higher and 0.30 or lower, 0.05 or higher and 0.20 or lower, 0.05 or higher and 0.10 or lower, 0.10 or higher and 0.40 or lower, 0.10 or higher and 0.30 or lower, 0.10 or higher and 0.20 or lower, 0.20 or higher and 0.40 or lower, 0.20 or higher and 0.30 or lower, or 0.30 or higher and 0.40 or lower. The second ratio R4/R2 may be lower than the first ratio R3/R1.

A difference between the first ratio R3/R1 and the second ratio R4/R2 is preferably small. Accordingly, an instance where directional dependency occurs in the size of each through-hole 56 in plan view can be suppressed.

An absolute value of the difference between the first ratio R3/R1 and the second ratio R4/R2 may be, for example, 0.02 or larger, 0.05 or larger, or 0.10 or larger. The absolute value of the difference between the first ratio R3/R1 and the second ratio R4/R2 may be, for example, 0.15 or smaller, 0.20 or smaller, or 0.30 or smaller. The range of the absolute value of the difference between the first ratio R3/R1 and the second ratio R4/R2 may be defined in accordance with a first group constituted of 0.02, 0.05, and 0.10 and/or a second group constituted of 0.15, 0.20, and 0.30. The range of the absolute value of the difference between the first ratio R3/R1 and the second ratio R4/R2 may be defined in accordance with a combination of any one of the values included in the aforementioned first group and any one of the values included in the aforementioned second group. The range of the absolute value of the difference between the first ratio R3/R1 and the second ratio R4/R2 may be defined in accordance with a combination of any two of the values included in the aforementioned first group. The range of the absolute value of the difference between the first ratio R3/R1 and the second ratio R4/R2 may be defined in accordance with a combination of any two of the values included in the aforementioned second group. The absolute value of the difference between the first ratio R3/R1 and the second ratio R4/R2 may be, for example, 0.02 or larger and 0.30 or smaller, 0.02 or larger and 0.20 or smaller, 0.02 or larger and 0.15 or smaller, 0.02 or larger and 0.10 or smaller, 0.02 or larger and 0.05 or smaller, 0.05 or larger and 0.30 or smaller, 0.05 or larger and 0.20 or smaller, 0.05 or larger and 0.15 or smaller, 0.05 or larger and 0.10 or smaller, 0.10 or larger and 0.30 or smaller, 0.10 or larger and 0.20 or smaller, 0.10 or larger and 0.15 or smaller, 0.15 or larger and 0.30 or smaller, 0.15 or larger and 0.20 or smaller, or 0.20 or larger and 0.30 or smaller.

The metal plate 55A may have a low regular reflectance. In the embodiment of the present disclosure, a regular reflectance is an average value of the first reflectance R1 and the second reflectance R2. By setting an upper limit for the regular reflectance of the metal plate 55A, a step of detecting an alignment mark provided in the metal plate 55A can be readily executed.

The alignment mark is, for example, an area where the reflectance is lower than surrounding areas of the metal plate 55A. The alignment mark is, for example, a recess located in the surface of the metal plate 55A and not extending through the metal plate 55A. When the alignment mark is detected by using a detector that detects reflected light from the metal plate 55A, the alignment mark is ideally recognized as a black-colored area. However, if the metal plate 55A has a high reflectance, the outline of the alignment mark may conceivably become blurred due to reflected light from the surface of the metal plate 55A located around the alignment mark.

By setting an upper limit for the regular reflectance of the metal plate 55A, the reflected light from the surface of the metal plate 55A located around the alignment mark can be limited. Therefore, blurring of the outline of the detected alignment mark can be suppressed.

The regular reflectance may be, for example, 2.0% or higher, 2.6% or higher, or 3.0% or higher. The regular reflectance may be, for example, 26.0% or lower, 31.0% or lower, or 35.0% or lower. The range of the regular reflectance may be defined in accordance with a first group constituted of 2.0%, 2.6%, and 3.0% and/or a second group constituted of 26.0%, 31.0%, and 35.0%. The range of the regular reflectance may be defined in accordance with a combination of any one of the values included in the aforementioned first group and any one of the values included in the aforementioned second group. The range of the regular reflectance may be defined in accordance with a combination of any two of the values included in the aforementioned first group. The range of the regular reflectance may be defined in accordance with a combination of any two of the values included in the aforementioned second group. The regular reflectance may be, for example, 2.0% or higher and 35.0% or lower, 2.0% or higher and 31.0% or lower, 2.0% or higher and 26.0% or lower, 2.0% or higher and 3.0% or lower, 2.0% or higher and 2.6% or lower, 2.6% or higher and 35.0% or lower, 2.6% or higher and 31.0% or lower, 2.6% or higher and 26.0% or lower, 2.6% or higher and 3.0% or lower, 3.0% or higher and 35.0% or lower, 3.0% or higher and 31.0% or lower, 3.0% or higher and 26.0% or lower, 26.0% or higher and 35.0% or lower, 26.0% or higher and 31.0% or lower, or 31.0% or higher and 35.0% or lower.

The metal plate 55A preferably satisfies the aforementioned numerical range related to the reflectance and the ratio when the first specific incident angle Θ1 and the second specific incident angle Θ2 are 20°. The advantages of the first specific incident angle Θ1 and the second specific incident angle Θ2 being 20° will now be described.

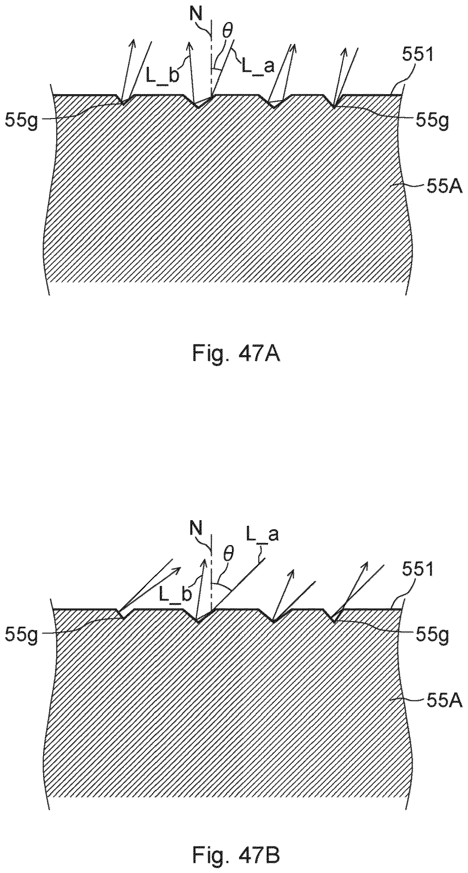

Fig. 47A is a cross-sectional view illustrating an example of light reflection occurring at the surface of the metal plate 55A when the incident angle θ is 20°. Fig. 47B is a cross-sectional view illustrating an example of light reflection occurring at the surface of the metal plate 55A when the incident angle θ is 45°. As shown in Fig. 47B, when recesses 55g in the surface have a small width, the light with the incident angle θ of 45° is less likely to reach the bottom of each recess 55g. As shown in Fig. 47A, the light with the incident angle θ of 20° tends to reach the bottom of each recess 55g readily, as compared with the light with the incident angle θ of 45°. The reflectance measured by using the light with the incident angle θ of 20° can include the effect of light reflection occurring due to the bottom of each recess 55g. By using the light with the incident angle θ of 20°, diffusion light caused by each recess 55g can be appropriately evaluated.

In the exposure step, the exposure light becomes incident on the resist layer on the metal plate 55A in the normal direction to the surface of the metal plate 55A. Specifically, the incident angle of the exposure light is 0° or substantially 0°. The light with the incident angle θ of 20° is more preferable than the light with the incident angle θ of 45° in being closer to the incident angle of the exposure light.

The metal plate 55A may satisfy the aforementioned numerical range related to the reflectance and the ratio when the first specific incident angle Θ1 and the second specific incident angle Θ2 are 45°, in addition to when the first specific incident angle Θ1 and the second specific incident angle Θ2 are 20°. However, the diffusion light occurring at the surface of the metal plate 55A when the incident angle θ is 45° is different from the diffusion light occurring at the surface of the metal plate 55A when the incident angle θ is 20°. Therefore, the metal plate 55A satisfying the aforementioned numerical range related to the reflectance and the ratio when the angles Θ1 and Θ2 are 45° does not necessarily satisfy the aforementioned numerical range related to the reflectance and the ratio when the angles Θ1 and Θ2 are 20°.

The first output angle ϕ1 may be substantially equal to the first specific incident angle Θ1. By suppressing the occurrence of diffusion light, a difference between the first specific incident angle Θ1 and the first output angle ϕ1 can be reduced. An absolute value of the difference between the first specific incident angle Θ1 and the first output angle ϕ1 may be, for example, 0.0° or larger, 0.1° or larger, or 0.2° or larger. The absolute value of the difference between the first specific incident angle Θ1 and the first output angle ϕ1 may be, for example, 0.3° or smaller, 1.0° or smaller, or 2.0° or smaller. The range of the absolute value of the difference between the first specific incident angle Θ1 and the first output angle ϕ1 may be defined in accordance with a first group constituted of 0.0°, 0.1°, and 0.2° and/or a second group constituted of 0.3°, 1.0°, and 2.0°. The range of the absolute value of the difference between the first specific incident angle Θ1 and the first output angle ϕ1 may be defined in accordance with a combination of any one of the values included in the aforementioned first group and any one of the values included in the aforementioned second group. The range of the absolute value of the difference between the first specific incident angle Θ1 and the first output angle ϕ1 may be defined in accordance with a combination of any two of the values included in the aforementioned first group. The range of the absolute value of the difference between the first specific incident angle Θ1 and the first output angle ϕ1 may be defined in accordance with a combination of any two of the values included in the aforementioned second group. The absolute value of the difference between the first specific incident angle Θ1 and the first output angle ϕ1 may be, for example, 0.0° or larger and 2.0° or smaller, 0.0° or larger and 1.0° or smaller, 0.0° or larger and 0.3° or smaller, 0.0° or larger and 0.2° or smaller, 0.0° or larger and 0.1° or smaller, 0.1° or larger and 2.0° or smaller, 0.1° or larger and 1.0° or smaller, 0.1° or larger and 0.3° or smaller, 0.1° or larger and 0.2° or smaller, 0.2° or larger and 2.0° or smaller, 0.2° or larger and 1.0° or smaller, 0.2° or larger and 0.3° or smaller, 0.3° or larger and 2.0° or smaller, 0.3° or larger and 1.0° or smaller, or 1.0° or larger and 2.0° or smaller.

The second output angle ϕ2 may be substantially equal to the second specific incident angle Θ2. By suppressing the occurrence of diffusion light, a difference between the second specific incident angle Θ2 and the second output angle ϕ2 can be reduced. A numerical range for an absolute value of the difference between the second specific incident angle Θ2 and the second output angle ϕ2 may be the same as the aforementioned numerical range related to the absolute value of the difference between the first specific incident angle Θ1 and the first output angle ϕ1.

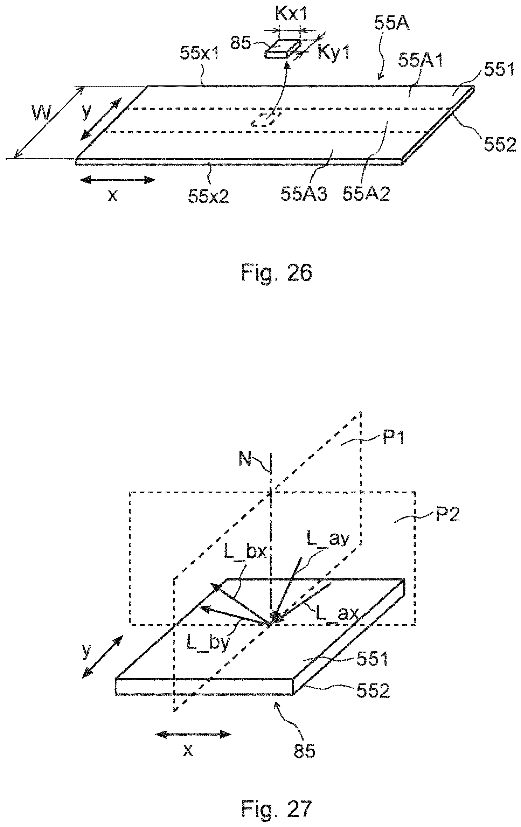

A measurement method for the first reflectance R1, the second reflectance R2, the third reflectance R3, and the fourth reflectance R4 will now be described with reference to Fig. 26 to Fig. 32.

First, as shown in Fig. 26, the metal plate 55A extending in the longitudinal direction x is prepared. As shown in Fig. 19, a dimension W of the metal plate 55A in the width direction y may be set such that the metal plate 55A includes the plurality of masks 50 arranged in the width direction y.

The dimension W of the metal plate 55A may be, for example, 300 mm or larger, 400 mm or larger, or 500 mm or larger. The dimension W of the metal plate 55A may be, for example, 600 mm or smaller, 800 mm or smaller, or 1000 mm or smaller. The range of the dimension W of the metal plate 55A may be defined in accordance with a first group constituted of 300 mm, 400 mm, and 500 mm and/or a second group constituted of 600 mm, 800 mm, and 1000 mm. The range of the dimension W of the metal plate 55A may be defined in accordance with a combination of any one of the values included in the aforementioned first group and any one of the values included in the aforementioned second group. The range of the dimension W of the metal plate 55A may be defined in accordance with a combination of any two of the values included in the aforementioned first group. The range of the dimension W of the metal plate 55A may be defined in accordance with a combination of any two of the values included in the aforementioned second group. The dimension W of the metal plate 55A may be, for example, 300 mm or larger and 1000 mm or smaller, 300 mm or larger and 800 mm or smaller, 300 mm or larger and 600 mm or smaller, 300 mm or larger and 500 mm or smaller, 300 mm or larger and 400 mm or smaller, 400 mm or larger and 1000 mm or smaller, 400 mm or larger and 800 mm or smaller, 400 mm or larger and 600 mm or smaller, 400 mm or larger and 500 mm or smaller, 500 mm or larger and 1000 mm or smaller, 500 mm or larger and 800 mm or smaller, 500 mm or larger and 600 mm or smaller, 600 mm or larger and 1000 mm or smaller, 600 mm or larger and 800 mm or smaller, or 800 mm or larger and 1000 mm or smaller.

By cutting a part of the metal plate 55A, a sample 85 is prepared. The sample 85 is extracted from a second region 55A2 of the metal plate 55A. The second region 55A2 is located between a first region 55A1 and a third region 55A3 in the width direction y. The first region 55A1, the second region 55A2, and the third region 55A3 are regions defined by imaginarily dividing the metal plate 55A. The first region 55A1, the second region 55A2, and the third region 55A3 are arranged in the width direction y from the first side edge 55x1 toward the second side edge 55x2. The first region 55A1 includes the first side edge 55x1 and has a dimension of 100 mm in the width direction y. The third region 55A3 includes the second side edge 55x2 and has a dimension of 100 mm in the width direction y. If the dimension of the metal plate 55A in the width direction y is 500 mm, the second region 55A2 has a dimension of 300 mm in the width direction y.

The sample 85 is located in the middle of the second region 55A2 in the width direction y. The distance from the distal end of the metal plate 55A to the sample 85 in the longitudinal direction x is 1000 mm. The "distal end of the metal plate 55A" refers to the distal end of the metal plate 55A wound into a roll.

A dimension Ky1 of the sample 85 in the width direction y is 50 mm. A dimension Kx1 of the sample 85 in the longitudinal direction x is 60 mm.

Fig. 27 is a perspective view illustrating a step of measuring the reflectance of the sample 85. As mentioned above, the first incident light L_ay travels in the width direction y in plan view and becomes incident on the first surface 551. In a first measuring step for the first reflectance and the third reflectance, the first reflected light L_by reflected at the first surface 551 and traveling in the width direction y in plan view is detected. The first incident light L_ay and the first reflected light L_by travel within a first plane P1. The first plane P1 is parallel to the normal direction N to the first surface 551 and the width direction y.

As mentioned above, the second incident light L_ax travels in the longitudinal direction x in plan view and becomes incident on the first surface 551. In a second measuring step for the second reflectance and the fourth reflectance, the second reflected light L_bx reflected at the first surface 551 and traveling in the longitudinal direction x in plan view is detected. The second incident light L_ax and the second reflected light L_bx travel within a second plane P2. The second plane P2 is parallel to the normal direction N to the first surface 551 and the longitudinal direction x.

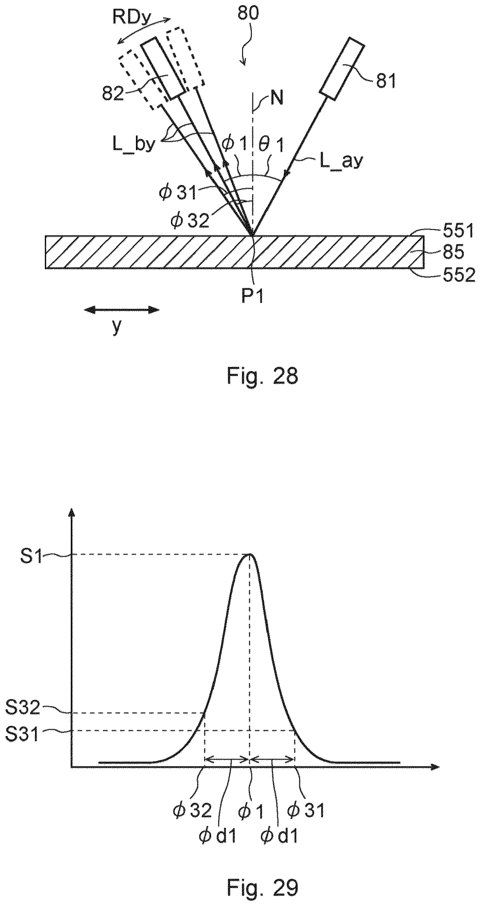

Fig. 28 is a cross-sectional view illustrating the first measuring step of measuring the first reflectance R1 and the third reflectance R3 of the sample 85. A measuring device 80 for measuring the reflectance includes a projector 81 and a receiver 82. The projector 81 radiates light toward the first surface 551. The receiver 82 detects light reflected at the first surface 551. As shown in Fig. 27 and Fig. 28, in the step of measuring the first reflectance R1 and the third reflectance R3, light radiation and detection are executed within the first plane P1 in Fig. 27.

The projector 81 includes a light source that generates light. The light source is, for example, a halogen lamp. The light incident on the first surface 551 may be collimated light. In this case, the projector 81 may include an optical system for generating the collimated light. The optical system includes, for example, a condenser lens, a collimator lens, a diaphragm, and a neutral-density filter.

The receiver 82 includes a light receiver that detects light reflected at the first surface 551. If the light reflected at the first surface 551 is collimated light, the receiver 82 may include an optical system for focusing the collimated light onto the light receiver. The optical system includes, for example, a telescope lens.

The receiver 82 is movable within the first plane P1 to detect the first reflected light L_by having various output angles. For example, the receiver 82 can move in a first rotational direction RDy within the first plane P1 about a light irradiation position P. Accordingly, as shown in Fig. 29, the intensity of the first reflected light L_by is detected at various output angles. In a graph shown in Fig. 29, the abscissa axis denotes the output angle of the first reflected light L_by, whereas the ordinate axis denotes the intensity of the first reflected light L_by.

As shown in Fig. 29, the intensity of the first reflected light L_by indicates a maximum value S1 at the first output angle ϕ1. The maximum value of the intensity of the first reflected light L_by is also referred to as a first maximum intensity. The first reflectance R1 is calculated by dividing the first maximum intensity S1 by a reference intensity.

The reference intensity is calculated in a correcting step. In the correcting step, light is radiated from the projector 81 toward the receiver 82. Specifically, in a state where the measuring device 80 is set to a transmissive measurement mode, the light radiated from the projector 81 directly enters the receiver 82. In the transmissive measurement mode, the incident angle and the reception angle are both 0°. The intensity of the light detected by the receiver 82 in the correcting step is the reference intensity. A reference distance between the projector 81 and the receiver 82 is configured to be equal to an optical path length in the measuring step. In the measuring step, the measuring device 80 is set to a reflective measurement mode. The optical path length is a light propagation distance by which light radiated from the projector 81 is reflected at the surface of the metal plate 55 and reaches the receiver 82.

The receiver 82 measures the intensity of the first reflected light L_by while moving in the first rotational direction RDy such that the output angle of the first reflected light L_by changes in units of 0.1°. The first reflected light L_by decreases in intensity as it deviates from the first output angle ϕ1. As mentioned above, the third reflectance R3 is the reflectance of the first reflected light L_by having the third output angle ϕ3. The third reflectance R3 is calculated by dividing the intensity of the first reflected light L_by having the third output angle ϕ3 by the reference intensity.

The third output angle ϕ3 is an output angle different from the first output angle ϕ1 by the first deviation angle ϕd1. The third output angle ϕ3 has two candidates. The first candidate is a thirty-first output angle ϕ31 that is larger than the first output angle ϕ1 by the first deviation angle ϕd1. The second candidate is a thirty-second output angle ϕ32 that is smaller than the first output angle ϕ1 by the first deviation angle ϕd1.

If an intensity S31 of the first reflected light L_by having the thirty-first output angle ϕ31 is larger than an intensity S32 of the first reflected light L_by having the thirty-second output angle ϕ32, the thirty-first output angle ϕ31 is employed as the third output angle ϕ3. Specifically, the third reflectance R3 is calculated by dividing the intensity S31 of the first reflected light L_by having the thirty-first output angle ϕ31 by the reference intensity.

If the intensity S32 of the first reflected light L_by having the thirty-second output angle ϕ32 is larger than the intensity S31 of the first reflected light L_by having the thirty-first output angle ϕ31, the thirty-second output angle ϕ32 is employed as the third output angle ϕ3. Specifically, the third reflectance R3 is calculated by dividing the intensity S32 of the first reflected light L_by having the thirty-second output angle ϕ32 by the reference intensity.

In the example shown in Fig. 29, the intensity S32 of the first reflected light L_by having the thirty-second output angle ϕ32 is larger than the intensity S31 of the first reflected light having the thirty-first output angle. Therefore, the third reflectance R3 is calculated by dividing the intensity S32 by the reference intensity.

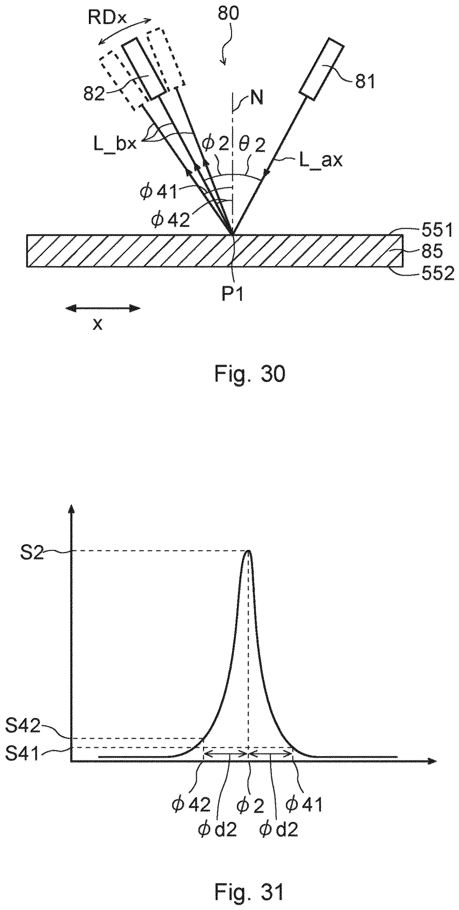

Fig. 30 is a cross-sectional view illustrating the second measuring step of measuring the second reflectance R2 and the fourth reflectance R4 of the sample 85. As shown in Fig. 27 and Fig. 30, in the step of measuring the second reflectance R2 and the fourth reflectance R4, light radiation and detection are executed within the second plane P2 in Fig. 27.

The receiver 82 is movable within the second plane P2 to detect the second reflected light L_bx having various output angles. For example, the receiver 82 can move in a second rotational direction RDx within the second plane P2 about the light irradiation position P. Accordingly, as shown in Fig. 31, the intensity of the second reflected light L_bx is detected at various output angles. In a graph shown in Fig. 31, the abscissa axis denotes the output angle of the second reflected light L_bx, whereas the ordinate axis denotes the intensity of the second reflected light L_bx.

As shown in Fig. 31, the intensity of the second reflected light L_bx indicates a maximum value S2 at the second output angle ϕ2. The maximum value of the intensity of the second reflected light L_bx is also referred to as a second maximum intensity. The second reflectance R2 is calculated by dividing the second maximum intensity S2 by the aforementioned reference intensity.

The receiver 82 measures the intensity of the second reflected light L_bx while moving in the second rotational direction RDx such that the output angle of the second reflected light L_bx changes in units of 0.1°. The second reflected light L_bx decreases in intensity as it deviates from the second output angle ϕ2. As mentioned above, the fourth reflectance R4 is the reflectance of the second reflected light L_bx having the fourth output angle ϕ4. The fourth reflectance R4 is calculated by dividing the intensity of the second reflected light L_bx having the fourth output angle ϕ4 by the reference intensity.

The fourth output angle ϕ4 is an output angle different from the second output angle ϕ2 by the second deviation angle ϕd2. The fourth output angle ϕ4 has two candidates. The first candidate is a forty-first output angle ϕ41 that is larger than the second output angle ϕ2 by the second deviation angle ϕd2. The second candidate is a forty-second output angle ϕ42 that is smaller than the second output angle ϕ2 by the second deviation angle ϕd2.

If an intensity S41 of the second reflected light L_bx having the forty-first output angle ϕ41 is larger than an intensity S42 of the second reflected light L_bx having the forty-second output angle ϕ42, the forty-first output angle ϕ41 is employed as the fourth output angle ϕ4. Specifically, the fourth reflectance R4 is calculated by dividing the intensity S41 of the second reflected light L_bx having the forty-first output angle ϕ41 by the reference intensity.

If the intensity S42 of the second reflected light L_bx having the forty-second output angle ϕ42 is larger than the intensity S41 of the second reflected light L_bx having the forty-first output angle ϕ41, the forty-second output angle ϕ42 is employed as the fourth output angle ϕ4. Specifically, the fourth reflectance R4 is calculated by dividing the intensity S42 of the second reflected light L_bx having the forty-second output angle ϕ42 by the reference intensity.

In the example shown in Fig. 31, the intensity S42 of the second reflected light L_bx having the forty-second output angle ϕ42 is larger than the intensity S41 of the second reflected light L_bx having the forty-first output angle ϕ41. Therefore, the fourth reflectance R4 is calculated by dividing the intensity S42 by the reference intensity.

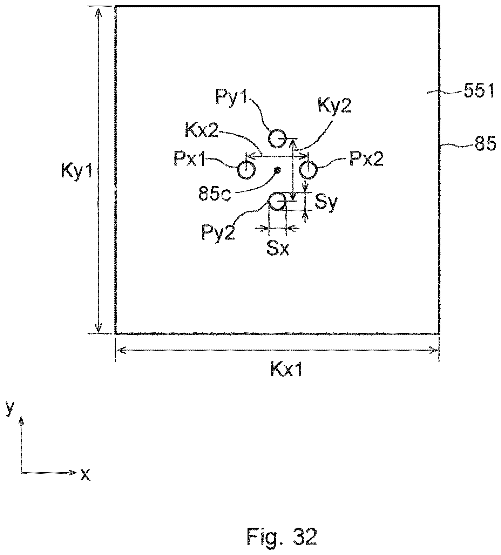

Fig. 32 is a plan view illustrating measurement positions in the sample 85. The first reflectance R1 and the third reflectance R3 are measured at a first measurement position Py1 and a second measurement position Py2, respectively. Average values of measurement results at the first measurement position Py1 and the second measurement position Py2 are employed as an ultimate first reflectance R1 and an ultimate third reflectance R3. The first measurement position Py1 and the second measurement position Py2 are symmetrical positions in the width direction y with respect to a center point 85c. Reference sign Ky2 denotes a distance between a center point of the first measurement position Py1 and a center point of the second measurement position Py2 in the width direction y. The distance Ky2 is 15 mm. The center point 85c is located at the center of the sample 85 in plan view.

The second reflectance R2 and the fourth reflectance R4 are measured at a third measurement position Px1 and a fourth measurement position Px2, respectively. Average values of measurement results at the third measurement position Px1 and the fourth measurement position Px2 are employed as an ultimate second reflectance R2 and an ultimate fourth reflectance R4. The third measurement position Px1 and the fourth measurement position Px2 are symmetrical positions in the longitudinal direction x with respect to the center point 85c. Reference sign Kx2 denotes a distance between a center point of the third measurement position Px1 and a center point of the fourth measurement position Px2 in the longitudinal direction x. The distance Kx2 is 15 mm.

In Fig. 32, reference signs Sx and Sy denote dimensions of each of the first measurement position Py1, the second measurement position Py2, the third measurement position Px1, and the fourth measurement position Px2 in the longitudinal direction x and the width direction y. The dimension Sx and the dimension Sy correspond to dimensions of a beam of incident light reaching the surface of the metal plate 55A. At the first measurement position Py1 and the second measurement position Py2, the dimension Sy is determined in accordance with the aperture diameter of the diaphragm and the first specific incident angle Θ1. If the aperture diameter of the diaphragm is 10.5 mm and the first specific incident angle Θ1 is 20°, the dimension Sy at each of the first measurement position Py1 and the second measurement position Py2 is 11.2 mm. The dimension Sx at each of the first measurement position Py1 and the second measurement position Py2 is 10.5 mm. At the third measurement position Px1 and the fourth measurement position Px2, the dimension Sx is determined in accordance with the aperture diameter of the diaphragm and the second specific incident angle Θ2. If the aperture diameter of the diaphragm is 10.5 mm and the second specific incident angle Θ2 is 20°, the dimension Sx at each of the third measurement position Px1 and the fourth measurement position Px2 is 11.2 mm. The dimension Sy at each of the third measurement position Px1 and the fourth measurement position Px2 is 10.5 mm.

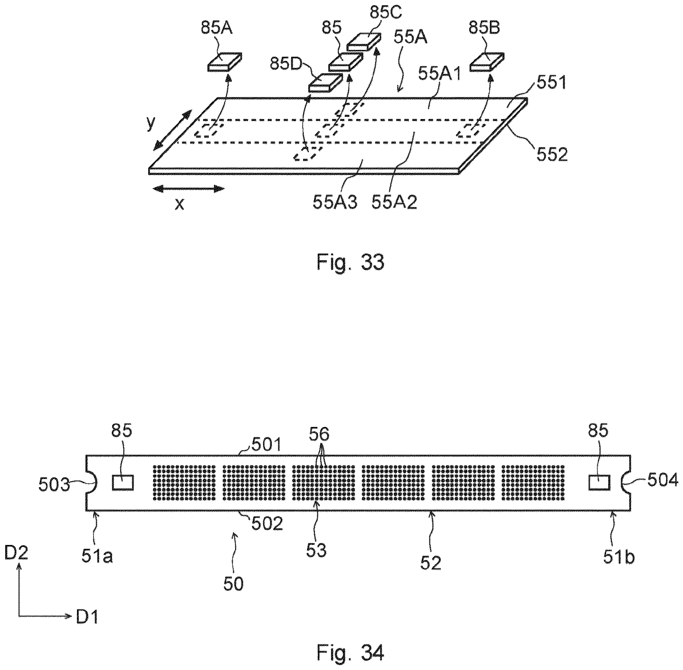

The reflectance measuring step may include a verifying step of measuring the reflectance of a verification sample. Fig. 33 illustrates verification samples extracted from the metal plate. In the example shown in Fig. 33, a first verification sample 85A to a fourth verification sample 85D in addition to the aforementioned sample 85 are extracted from the metal plate 55A.

The first verification sample 85A and the second verification sample 85B are extracted from the second region 55A2, similar to the sample 85. The first verification sample 85A and the second verification sample 85B are located in the middle of the second region 55A2 in the width direction y. The first verification sample 85A is located at the downstream side of the sample 85 in the longitudinal direction x. The downstream side is the side located away from the distal end of the metal plate 55A wound into a roll. The distance between the center point of the sample 85 and the center point of the first verification sample 85A in the longitudinal direction x is 1 m. The second verification sample 85B is located at the upstream side of the sample 85 in the longitudinal direction x. The upstream side is the side located toward the distal end of the metal plate 55A wound into a roll. The distance between the center point of the sample 85 and the center point of the second verification sample 85B in the longitudinal direction x is 1 m.

The reflectance of each of the first verification sample 85A and the second verification sample 85B and the reflectance-related parameters thereof are within the aforementioned numerical range defined with respect to the reflectance of the sample 85 and the reflectance-related parameters thereof. For example, the first ratio R3/R1 and the second ratio R4/R2 calculated from the first verification sample 85A and the second verification sample 85B are 0.40 or lower. In accordance with the verification using the first verification sample 85A and the second verification sample 85B, the reflectance of the target metal plate 55A and the reflectance-related parameters thereof are guaranteed to be within the aforementioned numerical range regardless of the position of the metal plate 55A in the longitudinal direction x.

The third verification sample 85C is extracted from the first region 55A1. The third verification sample 85C is located in the middle of the first region 55A1 in the width direction y. The fourth verification sample 85D is extracted from the third region 55A3. The fourth verification sample 85D is located in the middle of the third region 55A3 in the width direction y. The third verification sample 85C, the sample 85, and the fourth verification sample 85D are arranged in the width direction y. The distance between the center point of the sample 85 and the center point of the third verification sample 85C in the width direction y is 200 mm. The distance between the center point of the sample 85 and the center point of the fourth verification sample 85D in the width direction y is 200 mm.

The reflectance of each of the third verification sample 85C and the fourth verification sample 85D and the reflectance-related parameters thereof are within the aforementioned numerical range defined with respect to the reflectance of the sample 85 and the reflectance-related parameters thereof. For example, the first ratio R3/R1 and the second ratio R4/R2 calculated from the third verification sample 85C and the fourth verification sample 85D are 0.40 or lower. In accordance with the verification using the third verification sample 85C and the fourth verification sample 85D, the reflectance of the target metal plate 55A and the reflectance-related parameters thereof are guaranteed to be within the aforementioned numerical range regardless of the position of the metal plate 55A in the width direction y.

Next, a manufacturing method for the metal plate 55A will be described. With regard to the embodiment of the present disclosure, the following description relates to an example where the metal plate 55A is formed of a rolled material composed of an iron alloy containing nickel.

First, iron, nickel, and other raw materials are prepared. For example, each raw material is prepared such that the percentage of iron and the percentage of nickel relative to the entire raw material are about 64 mass% and about 36 mass%, respectively. Then, after each raw material is ground, where necessary, a melting step of melting the raw material in a melting furnace is executed. For example, each raw material is melted and mixed by utilizing gas discharge, such as arc discharge. Accordingly, a base material for the metal plate can be obtained.

The temperature during the melting is set in accordance with the raw material, and is, for example, 1500°C or higher. The melting step may include a step of injecting, for example, aluminum, manganese, and silicon into the melting furnace for deoxidization, dehydration, and denitrification. Moreover, the melting step may be executed in an atmosphere of inactive gas, such as argon gas, in a low pressure state lower than the atmospheric pressure.

After the base material is taken out of the melting furnace, a grinding step of scraping the surface of the base material may be executed. Accordingly, an oxide coating, such as a scale, can be removed. A specific grinding method is not particularly limited. For example, a so-called grinding technique that involves grinding the surface of the base material by rotating a grinding wheel may be employed. For example, a so-called pushing technique that involves grinding the surface of the base material by pushing the base material onto a cutting tool may be employed. The grinding step may be executed to make the thickness of the base material uniform.

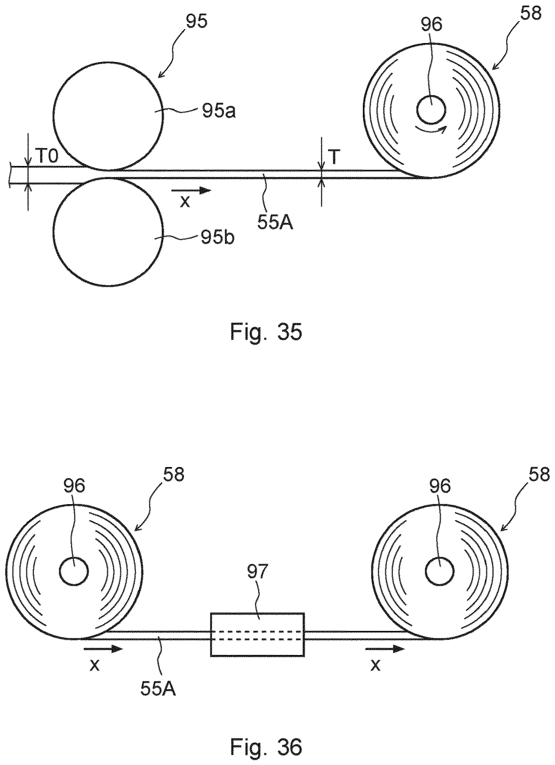

Subsequently, a rolling step of rolling the base material composed of the iron alloy containing nickel is executed. Accordingly, a metal plate extending in the longitudinal direction x is obtained. The rolling step may be executed multiple times until a metal plate 55A having an ultimate thickness T is obtained. Fig. 35 illustrates the final rolling step of obtaining the metal plate 55A having the ultimate thickness T.

In the rolling step, for example, conveyance is performed while applying tension in the longitudinal direction x toward a rolling device 66 including a pair of rolling rollers 95a and 95b. The rolling rollers are also referred to as working rollers. The metal plate that has reached between the pair of rolling rollers 95a and 95b is rolled by the pair of rolling rollers 95a and 95b. As a result, the metal plate is reduced in thickness and is stretched in the longitudinal direction x. The surface of the metal plate 55A has recesses, such as the rolling streaks 55f, formed therein. A wound body 58 may be fabricated by winding the metal plate 55A around a core 96.

The specific configuration and procedure for executing the rolling step is not particularly limited. For example, the rolling step may include a hot rolling step and/or a cold rolling step. The hot rolling step involves rolling the metal plate at a temperature higher than or equal to a temperature that causes the crystal array in the iron alloy constituting the metal plate to change. The cold rolling step involves rolling the metal plate at a temperature lower than or equal to a temperature that causes the crystal array in the iron alloy to change. The direction in which the base material or the metal plate passes through between the pair of rolling rollers 95a and 95b is not limited to one direction.

In the rolling step, the pressure of a rolling actuator for adjusting the shape of the metal plate may be adjusted. Moreover, in addition to the rolling rollers 95a and 95b, the shape of a backup roller may be adjusted, where appropriate.

In the rolling step, such as the cold rolling step, rolling oil may be supplied between the metal plate and the rolling rollers 95a and 95b. Accordingly, the temperature of the metal plate can be controlled. Examples of the rolling oil include kerosene, neat oil, and mineral oil.

In the rolling step, the viscosity of the rolling oil may be adjusted. In order to suppress the occurrence of recesses, such as the oil pits 55e and the rolling streaks 55f, the viscosity of the rolling oil is preferably low.

In the rolling step, the rolling speed, that is, the conveying speed of the metal plate, may be adjusted. In order to suppress the occurrence of recesses, such as the oil pits 55e and the rolling streaks 55f, the rolling speed is preferably low.

In the rolling step, the surface roughness of the rolling rollers may be adjusted. In order to suppress the occurrence of recesses, such as the oil pits 55e and the rolling streaks 55f, the surface roughness of the rolling rollers is preferably low.

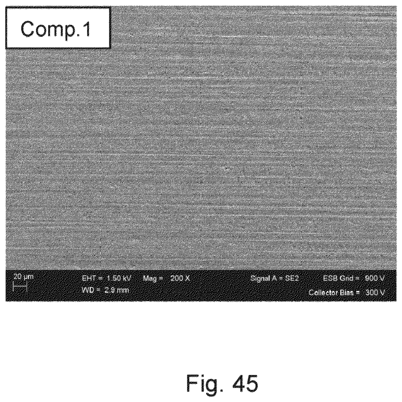

An image of the metal plate 55A according to Comparative Example 1 shown in Fig. 45, to be described later, indicates that the first ratio R3/R1 increases with increasing number of rolling streaks 55f. The percentage of the rolling streaks 55f in the surface of the metal plate 55A is preferably reduced. The adjustment of the viscosity of the rolling oil and the rolling speed is conceivably effective for reducing the percentage of the rolling streaks 55f.

An analyzing step of analyzing the quality and the properties of the metal plate may be executed before or after the rolling step or during the rolling step. For example, the composition of the metal plate may be analyzed by radiating a fluorescent X ray thereto. Moreover, the thermal extraction-contraction amount of the metal plate may be measured in accordance with a thermomechanical analysis (TMA) .

Subsequently, in order to remove residual stress accumulated within the metal plate 55A due to the rolling, an annealing step of annealing the metal plate 55A by using an annealing device 97 may be executed, as shown in Fig. 36. As shown in Fig. 36, the annealing step may be executed while pulling the metal plate 55A in the longitudinal direction x. Specifically, the annealing step may be executed as continuous annealing while performing conveying, instead of so-called batch-wise annealing. In this case, the temperature and the conveying speed are preferably set to suppress deformations, such as buckling, occurring in the metal plate 55A. By executing the annealing step, the metal plate 55A from which residual strain has been removed to a certain extent can be obtained. Although Fig. 36 illustrates an example where the metal plate 55A is conveyed in the horizontal direction during the annealing step, the configuration is not limited to this. During the annealing step, the metal plate 55A may be conveyed in another direction, such as the vertical direction.

The conditions for the annealing step are appropriately set in accordance with the thickness of the metal plate 55A and the rolling reduction. For example, the annealing step is executed for 30 seconds or longer and 90 seconds or shorter within a range of 500°C or higher and 600°C or lower. The above number of seconds indicates a time period required for the metal plate 55A to pass through a space adjusted to an annealing temperature within the annealing device 97. The annealing temperature may be set such that the metal plate 55A does not soften.

A lower limit for the annealing temperature may be lower than 500°C mentioned above. For example, the annealing temperature may be 400°C or higher, or 450°C or higher. An upper limit for the annealing temperature may be higher than 600°C mentioned above. For example, the temperature in the annealing step may be 700°C or lower, or 650°C or lower. The range of the temperature in the annealing step may be defined in accordance with a combination of any one of the aforementioned plurality of upper-limit candidate values and any one of the aforementioned plurality of lower-limit candidate values. For example, the temperature in the annealing step may be 400°C or higher and 700°C or lower, or 450°C or higher and 650°C or lower. The range of the temperature in the annealing step may be defined in accordance with a combination of any two of the aforementioned plurality of upper-limit candidate values. For example, the temperature in the annealing step may be 650°C or higher and 700°C or lower. The range of the temperature in the annealing step may be defined in accordance with a combination of any two of the aforementioned plurality of lower-limit candidate values. For example, the temperature in the annealing step may be 400°C or higher and 450°C or lower.

The time period of the annealing step may be 40 seconds or longer, or 50 seconds or longer. A lower limit for the time period of the annealing step may be shorter than 30 seconds mentioned above. For example, the time period of the annealing step may be 10 seconds or longer, or 20 seconds or longer. Furthermore, the time period of the annealing step may be 80 seconds or shorter, 70 seconds or shorter, or 60 seconds or shorter. An upper limit for the time period of the annealing step may be longer than 90 seconds mentioned above. For example, the time period of the annealing step may be 100 seconds or shorter. The range of the time period of the annealing step may be defined in accordance with a combination of any one of the aforementioned plurality of upper-limit candidate values and any one of the aforementioned plurality of lower-limit candidate values. For example, the time period of the annealing step may be 10 seconds or longer and 100 seconds or shorter, 20 seconds or longer and 90 seconds or shorter, 30 seconds or longer and 80 seconds or shorter, 40 seconds or longer and 70 seconds or shorter, or 50 seconds or longer and 60 seconds or shorter. The range of the time period of the annealing step may be defined in accordance with a combination of any two of the aforementioned plurality of upper-limit candidate values. For example, the time period of the annealing step may be 90 seconds or longer and 100 seconds or shorter. The range of the time period of the annealing step may be defined in accordance with a combination of any two of the aforementioned plurality of lower-limit candidate values. For example, the time period of the annealing step may be 10 seconds or longer and 20 seconds or shorter.

Preferably, the aforementioned annealing step is executed in an irreducible atmosphere or an inert-gas atmosphere. An irreducible atmosphere is an atmosphere that does not contain a reducible gas, such as hydrogen. The expression "does not include a reducible gas" implies that the concentration of the reducible gas, such as hydrogen, is 10% or lower. In the annealing step, the concentration of the reducible gas may be 8% or lower, 6% or lower, 4% or lower, 2% or lower, or 1% or lower. An inert-gas atmosphere is an atmosphere in which the concentration of an inert gas, such as argon gas, helium gas, or nitrogen gas, is 90% or higher. In the annealing step, the concentration of the inert gas may be 92% or higher, 94% or higher, 96% or higher, 98% or higher, or 99% or higher. By executing the annealing step in the irreducible atmosphere or the inert-gas atmosphere, generation of a nickel compound, such as nickel hydroxide, at the surface layer of the metal plate 55A can be suppressed. The annealing device 97 may have a mechanism that monitors the concentration of the inert gas and a mechanism that adjusts the concentration of the inert gas.

Prior to the annealing step, a cleaning step of cleaning the metal plate 55A may be executed. Accordingly, adhesion of foreign matter on the surface of the metal plate 55A during the annealing step can be suppressed. An example of a cleaning liquid used for the cleaning may be a hydrocarbon-based liquid.

Subsequently, a slitting step of cutting off predetermined regions at opposite widthwise ends of the metal plate 55A obtained from the rolling step may be executed such that the width of the metal plate 55A is within a predetermined range. This slitting step is executed for removing cracks occurring at the opposite ends of the metal plate 55A due to the rolling. By executing such a slitting step, a phenomenon, that is, a so-called sheet fracture, where the metal plate 55A starts to break from the cracks can be suppressed.

The width of the parts cut off in the slitting step may be adjusted such that the shape of the metal plate 55A after the slipping step is bilaterally symmetrical in the width direction. Moreover, the slitting step may be executed prior to the aforementioned annealing step.

According to this embodiment, the metal plate 55A including the surface that satisfies the aforementioned conditions related to the first ratio and the second ratio of the reflectance is used, so that the occurrence of the fringe 614 in the first resist pattern 611 can be suppressed. Accordingly, the first recess 56a of each through-hole 56 in the mask 50 has high dimensional accuracy.

Next, an inspection method for the metal plate 55A will be described. The inspection method may be executed as one of the steps in the manufacturing method for the metal plate 55A. The inspection method may be executed for sorting out metal plates 55A available for sale.

The inspection method for the metal plate 55A may include a measuring step, a first determination step, and a second determination step. The measuring step involves measuring the aforementioned first reflectance R1, second reflectance R2, third reflectance R3, and fourth reflectance R4 of the metal plate 55A. The first determination step involves determining whether the first ratio R3/R1 is lower than or equal to a first threshold value. The first threshold value is, for example, 0.40. The first threshold value may be 0.30 or 0.20. The second determination step involves determining whether the second ratio R4/R2 is lower than or equal to a second threshold value. The second threshold value is, for example, 0.40. The second threshold value may be 0.30 or 0.20.

The inspection method for the metal plate 55A may include a third determination step. The third determination step involves determining whether the absolute value of the difference between the first ratio R3/R1 and the second ratio R4/R2 is smaller than or equal to a third threshold value. The third threshold value is, for example, 0.30. The third threshold value may be 0.20 or 0.15.

The inspection method for the metal plate 55A may include a fourth determination step. The fourth determination step involves determining whether the absolute value of the difference between the first ratio R3/R1 and the second ratio R4/R2 is larger than or equal to a fourth threshold value. The fourth threshold value is, for example, 0.02. The fourth threshold value may be 0.05 or 0.10.

It is preferable that the measuring step is at least executed when the first specific incident angle Θ1 and the second specific incident angle Θ2 are 20°. The measuring step may further be executed when the first specific incident angle Θ1 and the second specific incident angle Θ2 are angles other than 20°. For example, the measuring step may further be executed when the first specific incident angle Θ1 and the second specific incident angle Θ2 are 45°.

The first determination step to the fourth determination step are preferably executed based on the result of the measuring step when the first specific incident angle Θ1 and the second specific incident angle Θ2 are 20°. The first determination step to the fourth determination step may further be executed based on the result of the measuring step when the first specific incident angle Θ1 and the second specific incident angle Θ2 are angles other than 20°. For example, the first determination step to the fourth determination step may further be executed based on the result of the measuring step when the first specific incident angle Θ1 and the second specific incident angle Θ2 are 45°. However, as mentioned above, the diffusion light occurring at the surface of the metal plate 55A when the incident angle θ is 45° is different from the diffusion light occurring at the surface of the metal plate 55A when the incident angle θ is 20°. Therefore, the metal plate 55A determined as being acceptable in a determination step based on the result of the measuring step when the first specific incident angle Θ1 and the second specific incident angle Θ2 are 45° does not necessarily indicate excellent properties.

Next, an example of a method for manufacturing the organic device 100 will be described.

First, the substrate 110 having the first electrodes 120 formed thereon is prepared. The first electrodes 120 are formed by, for example, forming an electrically conductive layer constituting the first electrodes 120 on the substrate 110 by sputtering, and subsequently patterning the electrically conductive layer by photolithography. The insulation layer 160 located between two neighboring first electrodes 120 may be formed on the substrate 110.

Subsequently, the organic layers 130 including the first organic layers 130A and the second organic layers 130B are formed on the first electrodes 120. The first organic layers 130A are formed by vapor deposition using a first mask 50 having through-holes 56 corresponding to the first organic layers 130A. The second organic layers 130B are also formed by vapor deposition using a second mask 50 having through-holes 56 corresponding to the second organic layers 130B. The third organic layers 130C are also formed by vapor deposition using a third mask 50 having through-holes 56 corresponding to the third organic layers 130C.

Then, a step of forming the second electrode 140 on the organic layers 130 is executed. Accordingly, the organic device 100 can be obtained.

According to this embodiment, the occurrence of fringes in the first resist pattern 611 can be suppressed, as mentioned above. Therefore, the first recess 56a of each through-hole 56 in the mask 50 has high dimensional accuracy. Accordingly, the accuracy of the deposition layer of the organic device 100 can be enhanced.

### EXAMPLES

Next, the embodiment of the present disclosure will be described in further detail with reference to Examples. However, the embodiment of the present disclosure is not limited to the description of Examples below so long as the embodiment of the present disclosure does not exceed the gist thereof.

### (Example 1)

The metal plate 55A prepared was composed of an iron alloy containing 36 mass% of nickel, as well as iron and unavoidable impurities as remaining portions. The metal plate 55A had a thickness T of 10 µm, and a dimension of 500 mm in the width direction y. The manufacturing method for the metal plate 55A included the aforementioned rolling step and the aforementioned annealing step.

The inspection method for inspecting the metal plate 55A was executed. The inspection method included the measuring step, the first determination step, the second determination step, and the third determination step mentioned above.

In the measuring step, the first reflectance R1, the second reflectance R2, the third reflectance R3, and the fourth reflectance R4 of the metal plate 55A were measured by using a goniophotometer. The goniophotometer used was GP-200 manufactured by Murakami Color Research Laboratory.

The measuring step included the correcting step, the first measuring step, and the second measuring step mentioned above. The correcting step was executed in a transmissive mode of GP-200. In the transmissive mode, light radiated from the projector 81 directly entered the receiver 82. The projector 81 included a diaphragm and a neutral-density filter. The correcting step involved setting a "HIGH VOLT" value of GP-200 such that a maximum light intensity value calculated by GP-200 became 85%. Specific settings of GP-200 were as follows.
Light Source: 12 V, 50 W Halogen Lamp
Measurement Mode: Transmissive Mode
Incident Angle: 0°
Reception Angle of Receiver 82: -5.0° to +5.0° in units of 0.1°
Aperture Diameter of Diaphragm of Projector 81: 10.5 mm
Aperture Diameter of Diaphragm of Receiver 82: 9.1 mm
Sensitivity: 950
HIGH VOLT: 474
Neutral-Density Filter: Combination of 1/10 Neutral-Density Filter and 1/100 Neutral-Density Filter

In the correcting step, the maximum light intensity value calculated by GP-200 may deviate from 85%. If the maximum value deviates from 85%, the reference intensity is set in view of the deviation. For example, if the maximum light intensity value is 84.9% and the neutral-density filter is a combination of a 1/10 neutral-density filter and a 1/100 neutral-density filter, the reference intensity is set to 84900.

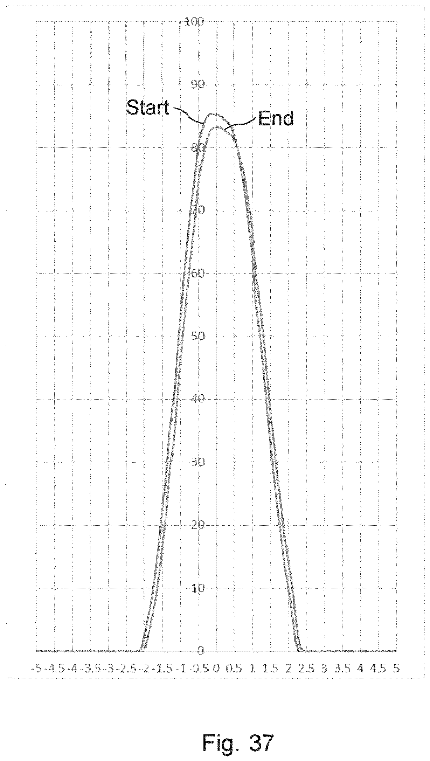

Fig. 37 illustrates a light-intensity measurement result in the correcting step. "Start" indicates a spectrum measured at the start of the correcting step. "End" indicates a spectrum measured at the end of the correcting step.

The first measuring step and the second measuring step are executed in a reflective mode of GP-200. In the first measuring step and the second measuring step, the sample 85 of the metal plate 55A is set on a sample stage of GP-200. In Example 1 and Examples 4 and 8, to be described later, the sample stage used included a groove for suctioning the sample 85. The diameter of the groove was 30 mm. In Examples 2, 3, 5 to 7, and 9 to 11 and Comparative Examples 1 to 6, the sample 85 having a magnet bonded thereto was set on the sample stage.

In the first measuring step and the second measuring step, the "HIGH VOLT" value set in the correcting step was used. The configuration of the neutral-density filter was adjusted such that the maximum light intensity value calculated by GP-200 was 10% or higher and 90% or lower. In Example 1 and Examples 2, 3, and 5 to 11 and Comparative Examples 1 and 3 to 6, to be described later, the neutral-density filter was a combination of a 1/2 neutral-density filter and a 1/100 neutral-density filter. In Example 4, to be described later, the neutral-density filter was a combination of a 1/10 neutral-density filter and a 1/100 neutral-density filter. In Comparative Example 2, to be described later, the neutral-density filter was a 1/100 neutral-density filter.

Specific settings of GP-200 in the first measuring step and the second measuring step were as follows.
Light Source: 12 V, 50 W Halogen Lamp
Measurement Mode: Reflective Mode
Incident Angle: 20°
Reception Angle of Receiver 82: 5.0° to 35.0° in units of 0.1°
Tilt Angle: 0°
Aperture Diameter of Diaphragm of Projector 81: 10.5 mm
Aperture Diameter of Diaphragm of Receiver 82: 9.1 mm
Sensitivity: 950
HIGH VOLT: 474

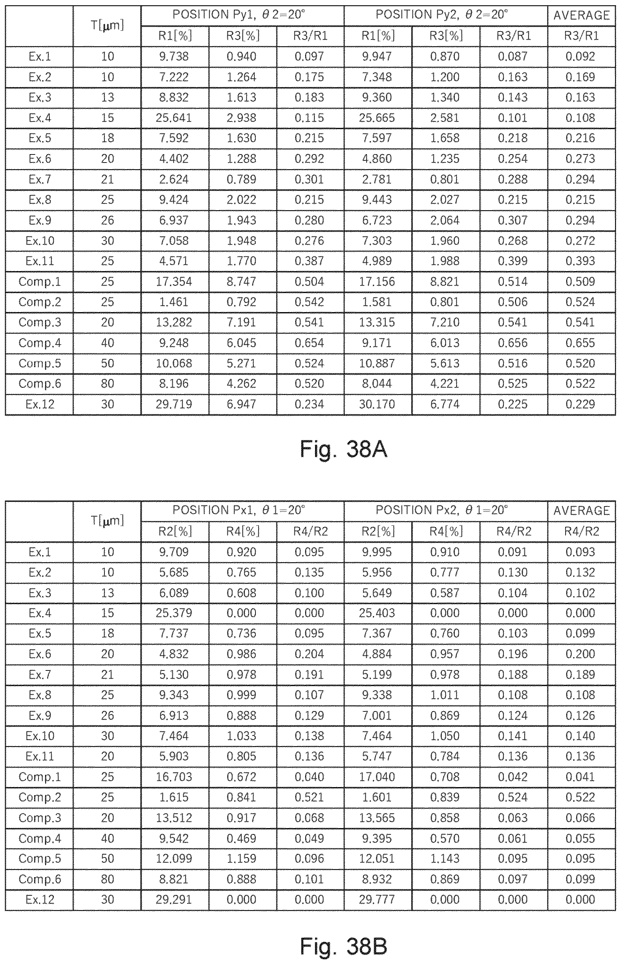

The results of the first measuring step are shown in Fig. 38A. In the first measuring step, the first reflectance R1 and the third reflectance R3 were measured at the first measurement position Py1 and the second measurement position Py2, respectively. "Ex.1" denotes Example 1. "Average" denotes an average value of the first ratio R3/R1 at the first measurement position Py1 and the first ratio R3/R1 at the second measurement position Py2.

The results of the second measuring step are shown in Fig. 38B. In the second measuring step, the second reflectance R2 and the fourth reflectance R4 were measured at the third measurement position Px1 and the fourth measurement position Px2, respectively. "Average" denotes an average of the second ratio R4/R2 at the third measurement position Px1 and the second ratio R4/R2 at the fourth measurement position Px2.

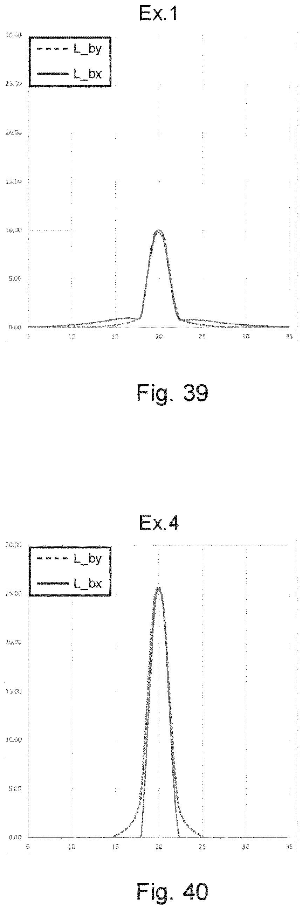

Fig. 39 illustrates a spectrum of the first reflected light L_by detected in the first measuring step and a spectrum of the second reflected light L_bx detected in the second measuring step.

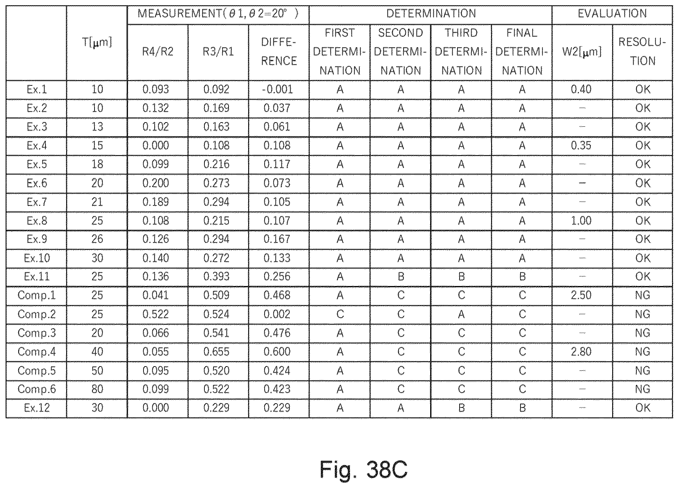

After the measuring step, the first determination step, the second determination step, and the third determination step were executed. The results of these determination steps are shown in Fig. 38C. The values of the first ratio R3/R1 shown in Fig. 38C are the average values shown in Fig. 38A. The values of the second ratio R4/R2 shown in Fig. 38C are the average values shown in Fig. 38B.

In a "first determination" column and a "second determination" column, "A" denotes that the first ratio R3/R1 or the second ratio R4/R2 is 0.30 or lower. In the "first determination" column and the "second determination" column, "B" denotes that the first ratio R3/R1 or the second ratio R4/R2 is higher than 0.30 and 0.40 or lower. In the "first determination" column and the "second determination" column, "C" denotes that the first ratio R3/R1 or the second ratio R4/R2 is higher than 0.40.

In a "third determination" column, "A" denotes that the absolute value of the difference between the first ratio R3/R1 and the second ratio R4/R2 is 0.20 or smaller. In the "third determination" column, "B" denotes that the absolute value of the difference between the first ratio R3/R1 and the second ratio R4/R2 is larger than 0.20 and 0.40 or smaller. In the "third determination" column, "C" denotes that the absolute value of the difference between the first ratio R3/R1 and the second ratio R4/R2 is larger than 0.40.

In a "final determination" column, "A" denotes that the results of the first determination, the second determination, and the third determination are all "A". In the "final determination" column, "B" denotes that the results of the first determination, the second determination, and the third determination do not include "C" but include at least one "B". In the "final determination" column, "C" denotes that the results of the first determination, the second determination, and the third determination include at least one "C".

First evaluation and second evaluation related to the processing accuracy of the metal plate 55A were executed. The results of the first evaluation and the second evaluation are shown in Fig. 38C. In the first evaluation, the width W2 of the fringe 614 in the first resist pattern 611 formed on the surface of the metal plate 55A was measured. In the second evaluation, the size of each first opening 612 in the first resist pattern 611 was measured.

In the first evaluation and the second evaluation, the aforementioned resist forming step, exposure step, and developing step shown in Fig. 12 to Fig. 14B were executed, whereby the first resist pattern 611 and the second resist pattern 621 were formed on the metal plate 55A. The wavelength of each of the exposure light L1 and the exposure light L2 from the exposure device 72 was 365 nm, and the declination angle was 2.0° of smaller. Then, the heating step of heating the resist patterns 611 and 621 at a processing temperature of 200°C or higher was executed.

A sample including the first resist pattern 611 was observed in plan view by using a scanning electronic microscope. The scanning electronic microscope used was ULTRA55 manufactured by ZEISS. The observation conditions were as follows.
Acceleration Voltage: 1.5 kV
Working Distance: 3.0 mm
Aperture: 30 µm High Current
Observation Power: 800× to 3000×

The width W2 of the fringe 614 in the first resist pattern 611 was calculated based on a plan-view image of the first resist pattern 611. The width W2 was calculated by averaging out W21, W22, W23, and W24 shown in Fig. 24. The width W2 was 0.40 µm.

The size of each first opening 612 in the first resist pattern 611 at the surface 615 was calculated based on the plan-view image of the first resist pattern 611. In detail, the size of each first opening 612 was measured in the first array direction E1, the second array direction E2, the third array direction E3, and the fourth array direction E4 shown in Fig. 14B. The sizes of 30 first openings 612 were measured. Therefore, the number of dimensional measurement values of the first openings 612 was 120. Then, an average value AVE of the 120 dimensional measurement values and a standard deviation σ were calculated. In a "resolution" column in Fig. 38C, "OK" denotes that conditions (1) and (2) indicated below are satisfied. In the "resolution" column in Fig. 38C, "NG" denotes that at least one of conditions (1) and (2) indicated below is not satisfied.
Condition (1): Difference Between Average Value AVE and Design Value is 1.8 µm or Smaller
Condition (2): 2σ is 1.5 µm or smaller

The design value for the size of each first opening 612 was 42 µm.

### (Examples 2 to 11, Comparative Examples 1 to 6, and Example 12)

The metal plate 55A prepared was composed of an iron alloy containing 36 mass% of nickel, as well as iron and unavoidable impurities as remaining portions. The metal plate 55A according to each of Examples 2 to 11, Comparative Examples 1 to 6, and Example 12 was different from the metal plate 55A according to Example 1 with regard to at least one of the thickness T and the conveying speed in the rolling step.

An inspection method identical to the case in Example 1 described above was executed on the metal plate 55A according to each of Examples 2 to 11, Comparative Examples 1 to 6, and Example 12. The results of the first measuring step are shown in Fig. 38A. The results of the second measuring step are shown in Fig. 38B. The results of the first determination step, the second determination step, and the third determination step are shown in Fig. 38C. "Comp.1" denotes Comparative Example 1.

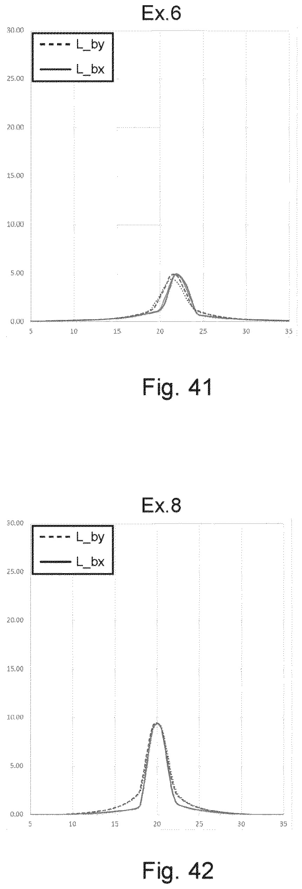

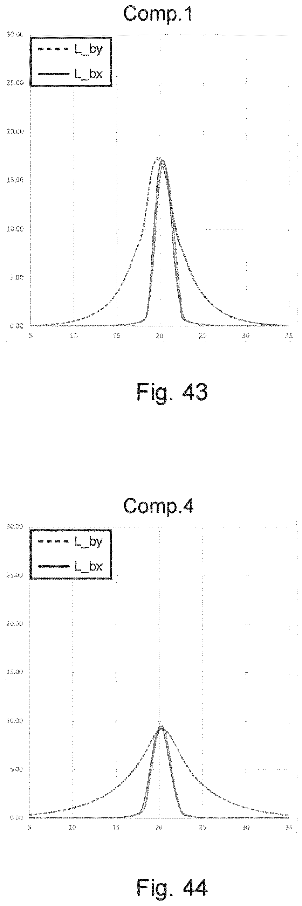

Fig. 40 illustrates a spectrum of the first reflected light L_by detected in the first measuring step in Example 4 and a spectrum of the second reflected light L_bx detected in the second measuring step in Example 4. Fig. 41 illustrates a spectrum of the first reflected light L_by detected in the first measuring step in Example 6 and a spectrum of the second reflected light L_bx detected in the second measuring step in Example 6. Fig. 42 illustrates a spectrum of the first reflected light L_by detected in the first measuring step in Example 8 and a spectrum of the second reflected light L_bx detected in the second measuring step in Example 8. Fig. 43 illustrates a spectrum of the first reflected light L_by detected in the first measuring step in Comparative Example 1 and a spectrum of the second reflected light L_bx detected in the second measuring step in Comparative Example 1. Fig. 44 illustrates a spectrum of the first reflected light L_by detected in the first measuring step in Comparative Example 4 and a spectrum of the second reflected light L_bx detected in the second measuring step in Comparative Example 4.

First evaluation identical to the case in Example 1 described above was executed on the metal plate 55A according to each of Examples 4 and 8 and Comparative Examples 1 and 4. Second evaluation identical to the case in Example 1 described above was executed on the metal plate 55A according to each of Examples 2 to 11 and Comparative Examples 1 to 6. The results of the first evaluation and the second evaluation are shown in Fig. 38C.

In each of Examples 1 to 11 and Example 12, the result of the first determination and the result of the second determination were "A" or "B". In each of Examples 1 to 11, the result of the second evaluation with regard to the resolution of the resist pattern was "OK". In each of Comparative Examples 1 to 6, at least the result of the first determination or the result of the second determination was "C". In each of Comparative Examples 1 to 6, the result of the second evaluation with regard to the resolution of the resist pattern was "NG". It is apparent that the first ratio R3/R1 and the second ratio R4/R2 are effective indicators related to the metal plate 55A used for manufacturing a mask.

Fig. 45 illustrates an image indicating a result obtained by observing the surface of the metal plate 55A according to Comparative Example 1 by using a scanning electronic microscope. The surface of the metal plate 55A according to Comparative Example 1 included many rolling streaks, as compared with oil pits.

### (Verification Sample)

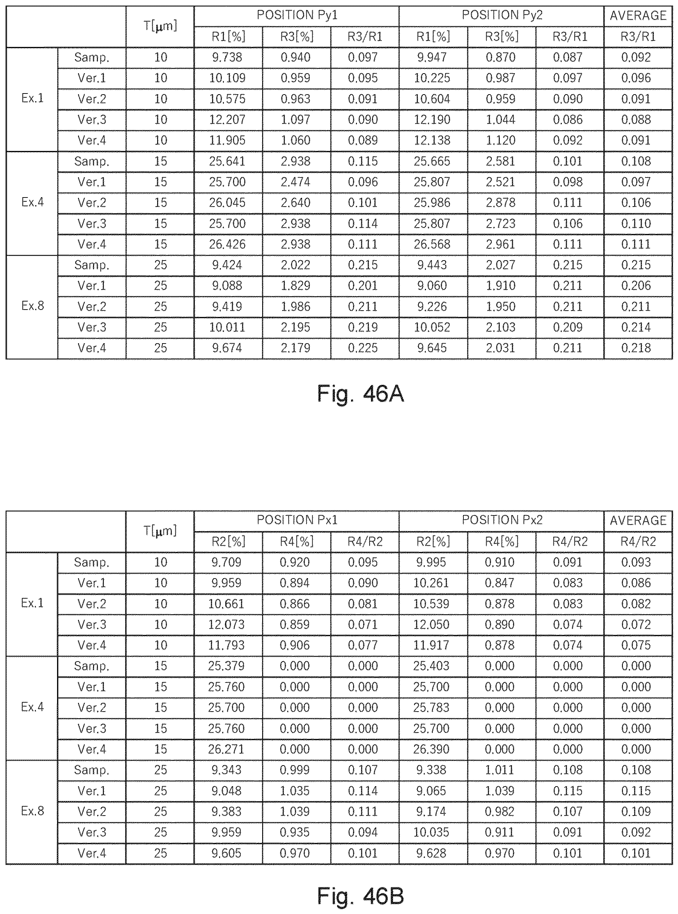

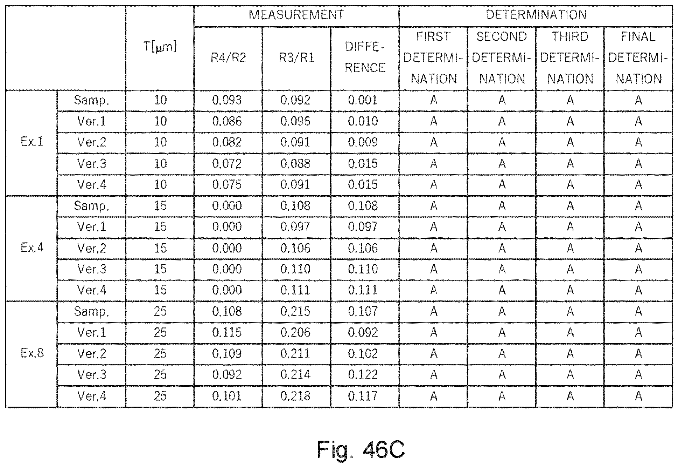

With regard to the metal plate 55A according to each of Examples 1, 4, and 8, the reflectance related to each of the first verification sample 85A to the fourth verification sample 85D shown in Fig. 33 was measured. The results of the first measuring step are shown in Fig. 46A. In the first measuring step, the first reflectance R1 and the third reflectance R3 of each of the first verification sample 85A to the fourth verification sample 85D were measured at the first measurement position Py1 and the second measurement position Py2, respectively. The results of the second measuring step are shown in Fig. 46B. In the second measuring step, the second reflectance R2 and the fourth reflectance R4 of each of the first verification sample 85A to the fourth verification sample 85D were measured at the third measurement position Px1 and the fourth measurement position Px2, respectively. After the measuring step, the first determination step, the second determination step, and the third determination step were executed. The results of these determination steps are shown in Fig. 46C.

In Figs. 46A, 46B, and 46C, "Samp." denotes the sample 85 in Fig. 33. The measurement results and the determination results of "Samp." are the same as the measurement results and the determination results in each of Examples 1, 4, and 8 shown in Figs. 38A to 38C. "Ver.1" to "Ver.4" denote the first verification sample 85A to the fourth verification sample 85D in Fig. 33.

It is apparent from Fig. 46C that the measurement results of the first verification sample 85A to the fourth verification sample 85D were substantially the same as the measurement results of the sample 85. In detail, an absolute value of the difference between the values of the first ratio R3/R1 and the second ratio R4/R2 of each of the first verification sample 85A to the fourth verification sample 85D and the values of the first ratio R3/R1 and the second ratio R4/R2 of the sample 85 was 0.020 or smaller. The determination results of each of the first verification sample 85A to the fourth verification sample 85D were the same as the determination results of the sample 85.

### (Change of Incident Angle)

The measuring step of measuring the reflectance of the metal plate 55A according to each of Examples 1 to 12 and Comparative Examples 1 to 6 was executed at an incident angle of 45°. Specific settings of GP-200 in the first measuring step and the second measuring step were as follows.
Light Source: 12 V, 50 W Halogen Lamp
Measurement Mode: Reflective Mode
Incident Angle: 45°
Reception Angle of Receiver 82: 30.0° to 60.0° in units of 0.1°
Tilt Angle: 0°
Aperture Diameter of Diaphragm of Projector 81: 10.5 mm
Aperture Diameter of Diaphragm of Receiver 82: 9.1 mm
Sensitivity: 950
HIGH VOLT: 444

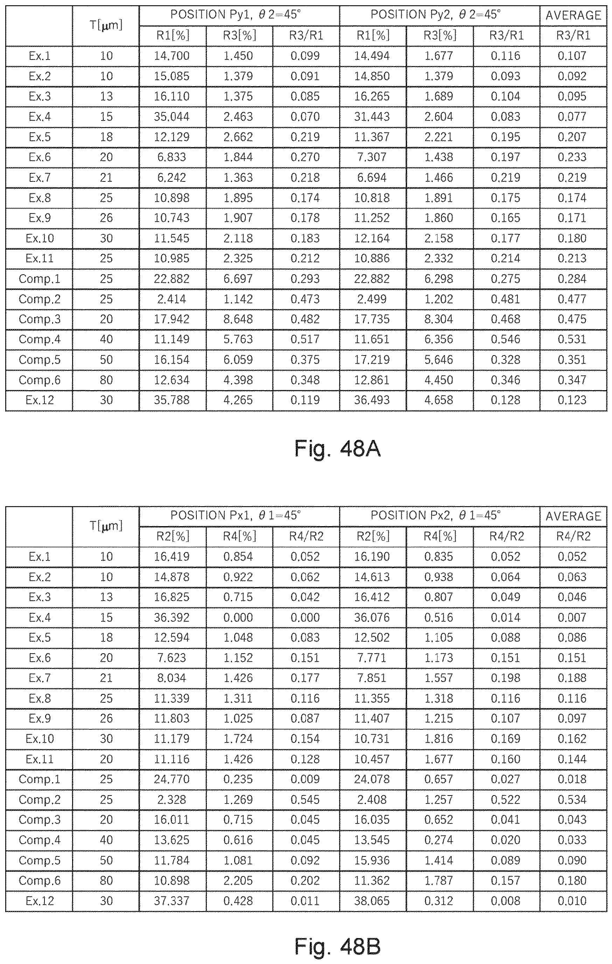

The results of the first measuring step are shown in Fig. 48A. The results of the second measuring step are shown in Fig. 48B.

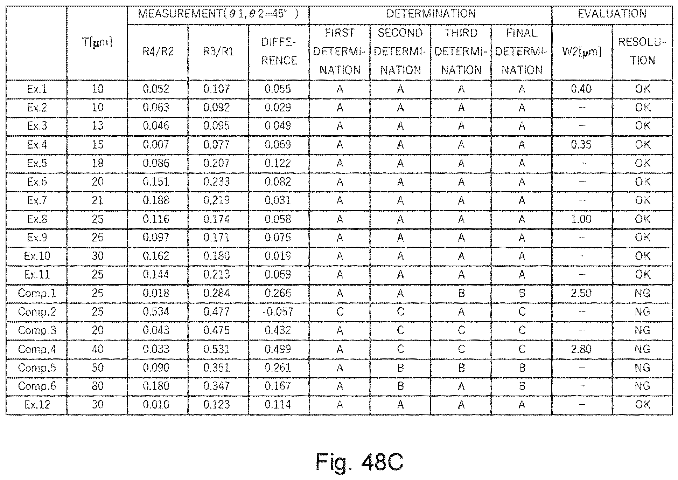

After the measuring step, the first determination step, the second determination step, and the third determination step were executed. The results of these determination steps are shown in Fig. 48C. The values of the first ratio R3/R1 shown in Fig. 48C are the average values shown in Fig. 48A. The values of the second ratio R4/R2 shown in Fig. 48C are the average values shown in Fig. 48B. The determination criteria for "A", "B", and "C" in the "first determination" column, the "second determination" column, the "third determination" column, and the "final determination" column are the same as the determination criteria when the incident angle is 20°.

As shown in Fig. 48C, the final determination result of the metal plate 55A according to each of Examples 1 to 12 when the incident angle is 45° was "A", similar to the result when the incident angle is 20°. The final determination result of the metal plate 55A according to each of Comparative Examples 2 to 4 when the incident angle is 45° was "C", similar to the result when the incident angle is 20°. On the other hand, the final determination result of the metal plate 55A according to each of Comparative Examples 1, 5, and 6 when the incident angle is 45° was "B", unlike the result when the incident angle is 20°. It is apparent that the metal plate 55A determined as being acceptable when the incident angle was 45° did not necessarily indicate excellent properties.

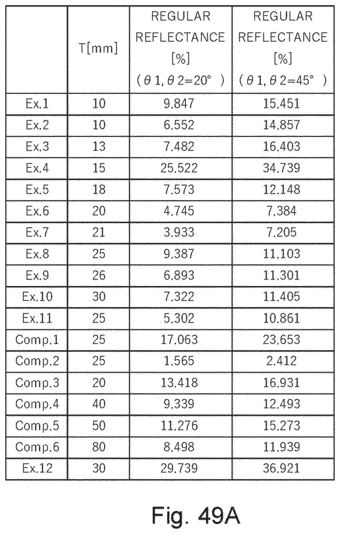

Fig. 49A is a table illustrating the regular reflectance of the metal plate according to each of Examples 1 to 12 and Comparative Examples 1 to 6. The regular reflectance when the incident angle is 20° is an average value of the first reflectance R1 at the first measurement position Py1 and the first reflectance R1 at the second measurement position Py2, shown in Fig. 38A, and the second reflectance R2 at the third measurement position Px1 and the second reflectance R2 at the fourth measurement position Px2, shown in Fig. 38B. The regular reflectance when the incident angle is 45° is an average value of the first reflectance R1 at the first measurement position Py1 and the first reflectance R1 at the second measurement position Py2, shown in Fig. 48A, and the second reflectance R2 at the third measurement position Px1 and the second reflectance R2 at the fourth measurement position Px2, shown in Fig. 48B.

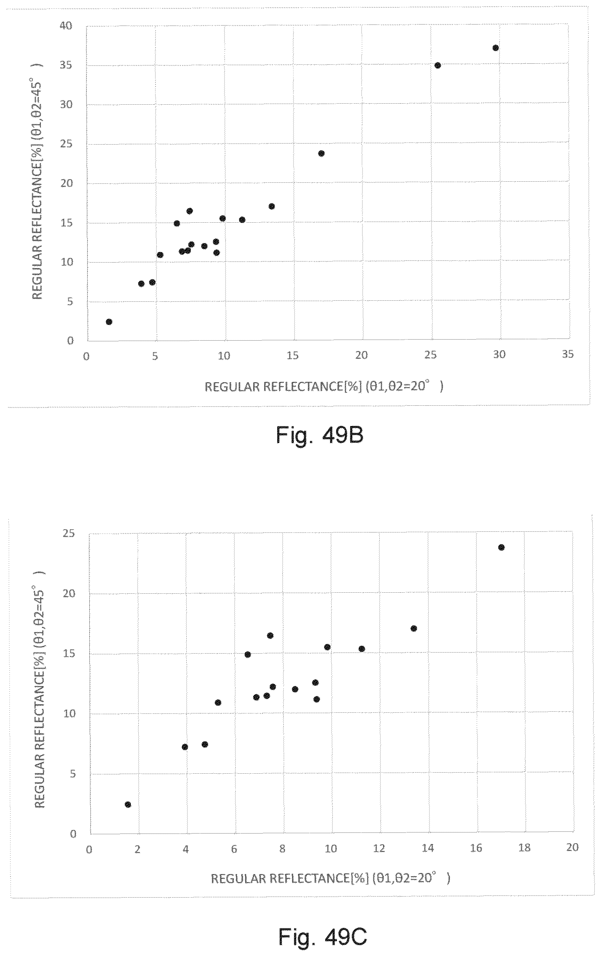

Each of Figs. 49B and 49C is a graph illustrating the relationship between the regular reflectance when the incident angle is 20° and the regular reflectance when the incident angle is 45°. The abscissa axis of the graph indicates the regular reflectance when the incident angle is 20°, whereas the ordinate axis of the graph indicates the regular reflectance when the incident angle is 45°. The range of the abscissa axis of the graph in Fig. 49B is between 0% and 35%. The range of the abscissa axis of the graph in Fig. 49C is between 0% and 20%.

It is conceivable that there is a certain correlation between the regular reflectance when the incident angle is 20° and the regular reflectance when the incident angle is 45°. However, as shown in Fig. 49C, in a case where the regular reflectance is low, as in a case where the regular reflectance when the incident angle is 20° or lower, it is apparent that the degree of the correlation decreases.

## Claims

1. A metal plate (55) used for manufacturing a mask (50), the metal plate comprising:
a surface having a longitudinal direction of the metal plate and a width direction orthogonal to the longitudinal direction,
wherein the surface has a first reflectance (R1), a second reflectance (R2), a third reflectance (R3), and a fourth reflectance (R4),
wherein the first reflectance is a reflectance of first reflected light (L_by) having a first output angle (ϕ1),
wherein the third reflectance is a reflectance of the first reflected light having a third output angle (ϕ3),
wherein the first reflected light is reflected light of first incident light (L_ay) reflected at the surface, the first incident light traveling in the width direction in plan view and being incident on the surface at a first specific incident angle (θ1),
wherein the first output angle is an output angle at which the first reflected light indicates a first maximum intensity (S1),
wherein the third output angle is an output angle different from the first output angle by a first deviation angle (ϕd1),
wherein the second reflectance is a reflectance of second reflected light (L_bx) having a second output angle (ϕ2),
wherein the fourth reflectance is a reflectance of the second reflected light having a fourth output angle (ϕ4),
wherein the second reflected light is reflected light of second incident light (L_ax) reflected at the surface, the second incident light traveling in the longitudinal direction in plan view and being incident on the surface at a second specific incident angle (θ2),
wherein the second output angle is an output angle at which the second reflected light indicates a second maximum intensity (S2),
wherein the fourth output angle is an output angle different from the second output angle by a second deviation angle (ϕd2),
wherein each of the first specific incident angle and the second specific incident angle is 20°,
wherein a first ratio (R3/R1) as a ratio of the third reflectance to the first reflectance is 0.40 or lower, and
wherein a second ratio (R4/R2) as a ratio of the fourth reflectance to the second reflectance is 0.40 or lower.

2. The metal plate according to Claim 1, wherein each of the first deviation angle and the second deviation angle is 2.5°.

3. The metal plate according to Claim 1 or 2,
wherein an absolute value of a difference between the first specific incident angle and the first output angle is 0.30° or smaller, and
wherein an absolute value of a difference between the second specific incident angle and the second output angle is 0.30° or smaller.

4. The metal plate according to any one of Claims 1 to 3, wherein the surface of the metal plate includes a plurality of rolling streaks (55f) extending in the longitudinal direction and a plurality of oil pits (55e).

5. The metal plate according to any one of Claims 1 to 4, wherein the metal plate has a thickness of 80 µm or smaller.

6. The metal plate according to any one of Claims 1 to 5, wherein the metal plate includes an iron alloy containing 34 mass% or higher and 38 mass% or lower of nickel.

7. The metal plate according to any one of Claims 1 to 6, wherein an absolute value of a difference between the first ratio and the second ratio is 0.20 or smaller.

8. The metal plate according to any one of Claims 1 to 7, wherein each of the first ratio and the second ratio is 0.30 or lower.

9. The metal plate according to Claim 8, wherein the second ratio is 0.20 or lower.

10. The metal plate according to any one of Claims 1 to 9,
wherein the metal plate has a regular reflectance of 35.0% or lower, and
wherein the regular reflectance is an average value of the first reflectance and the second reflectance.

11. An inspection method for a metal plate (55) used for manufacturing a mask (50),
wherein the metal plate includes a surface having a longitudinal direction and a width direction orthogonal to the longitudinal direction,
wherein the inspection method comprises:
a step of measuring a first reflectance (R1), a second reflectance (R2), a third reflectance (R3), and a fourth reflectance (R4) of the metal plate;
a first determination step of determining whether a first ratio (R3/R1) as a ratio of the third reflectance to the first reflectance is lower than or equal to a first threshold value; and
a second determination step of determining whether a second ratio (R4/R2) as a ratio of the fourth reflectance to the second reflectance is lower than or equal to a second threshold value,
wherein the first reflectance is a reflectance of first reflected light (L_by) having a first output angle (ϕ1),
wherein the third reflectance is a reflectance of the first reflected light having a third output angle (ϕ3),
wherein the first reflected light is reflected light of first incident light (L_ay) reflected at the surface, the first incident light traveling in the width direction in plan view and being incident on the surface at a first specific incident angle (θ1),
wherein the first output angle is an output angle at which the first reflected light indicates a first maximum intensity (S1),
wherein the third output angle is an output angle different from the first output angle by a first deviation angle (ϕd1),
wherein the second reflectance is a reflectance of second reflected light (L_bx) having a second output angle (ϕ2),
wherein the fourth reflectance is a reflectance of the second reflected light having a fourth output angle (ϕ4),
wherein the second reflected light is reflected light of second incident light (L_ax) reflected at the surface, the second incident light traveling in the longitudinal direction in plan view and being incident on the surface at a second specific incident angle (θ2),
wherein the second output angle is an output angle at which the second reflected light indicates a second maximum intensity (S2), and
wherein the fourth output angle is an output angle different from the second output angle by a second deviation angle (ϕd2).

12. A manufacturing method for a metal plate (55) used for manufacturing a mask (50), the manufacturing method comprising:
a rolling step of rolling the metal plate to reduce a thickness of the metal plate;
wherein the metal plate having undergone the rolling includes a surface having a longitudinal direction of the metal plate and a width direction orthogonal to the longitudinal direction,
wherein the surface has a first reflectance (R1), a second reflectance (R2), a third reflectance (R3), and a fourth reflectance (R4),
wherein the first reflectance is a reflectance of first reflected light (L_by) having a first output angle (ϕ1),
wherein the third reflectance is a reflectance of the first reflected light having a third output angle (ϕ3) ,
wherein the first reflected light is reflected light of first incident light (L_ay) reflected at the surface, the first incident light traveling in the width direction in plan view and being incident on the surface at a first specific incident angle (θ1),
wherein the first output angle is an output angle at which the first reflected light indicates a maximum intensity (S1),
wherein the third output angle is an output angle different from the first output angle by a first deviation angle (ϕd1),
wherein the second reflectance is a reflectance of second reflected light (L_bx) having a second output angle (ϕ2),
wherein the fourth reflectance is a reflectance of the second reflected light having a fourth output angle (ϕ4),
wherein the second reflected light is reflected light of second incident light (L_ax) reflected at the surface, the second incident light traveling in the longitudinal direction in plan view and being incident on the surface at a second specific incident angle (θ2),
wherein the second output angle is an output angle at which the second reflected light indicates a maximum intensity (S2),
wherein the fourth output angle is an output angle different from the second output angle by a second deviation angle (ϕd2),
wherein a first ratio (R3/R1) as a ratio of the third reflectance to the first reflectance is 0.40 or lower, and
wherein a second ratio (R4/R2) as a ratio of the fourth reflectance to the second reflectance is 0.40 or lower.

13. A mask (50) comprising:
a metal plate (55); and
a plurality of through-holes (56) extending through the metal plate,
wherein the metal plate includes a surface having a longitudinal direction of the metal plate and a width direction orthogonal to the longitudinal direction,
wherein the surface has a first reflectance (R1), a second reflectance (R2), a third reflectance (R3), and a fourth reflectance (R4),
wherein the first reflectance is a reflectance of first reflected light (L_by) having a first output angle (ϕ1),
wherein the third reflectance is a reflectance of the first reflected light having a third output angle (ϕ3),
wherein the first reflected light is reflected light of first incident light (L_ay) reflected at the surface, the first incident light traveling in the width direction in plan view and being incident on the surface at a first specific incident angle (θ1),
wherein the first output angle is an output angle at which the first reflected light indicates a maximum intensity (S1),
wherein the third output angle is an output angle different from the first output angle by a first deviation angle (ϕd1),
wherein the second reflectance is a reflectance of second reflected light (L_bx) having a second output angle (ϕ2),
wherein the fourth reflectance is a reflectance of the second reflected light having a fourth output angle (ϕ4),
wherein the second reflected light is reflected light of second incident light (L_ax) reflected at the surface, the second incident light traveling in the longitudinal direction in plan view and being incident on the surface at a second specific incident angle (θ2),
wherein the second output angle is an output angle at which the second reflected light indicates a maximum intensity (S2),
wherein the fourth output angle is an output angle different from the second output angle by a second deviation angle (ϕpd2),
wherein each of the first specific incident angle and the second specific incident angle is 20°,
wherein a first ratio (R3/R1) as a ratio of the third reflectance to the first reflectance is 0.40 or lower, and
wherein a second ratio (R4/R2) as a ratio of the fourth reflectance to the second reflectance is 0.40 or lower.

14. The mask according to Claim 13,
wherein the metal plate includes a first surface (551) and a second surface (552) located opposite the first surface,
wherein the through-holes include a plurality of first recesses (56a) located at the first surface, a plurality of second recesses (56b) located at the second surface, and a plurality of connection portions (563), each of the connection portions connecting each of the first recesses and each of the second recesses to each other,
wherein, in plan view, a size of each second recess is larger than a size of each first recess, and
wherein the first surface is the surface having the first reflectance, the second reflectance, the third reflectance, and the fourth reflectance.

15. The mask according to Claim 14,
wherein each of the through-holes has a first through-dimension (R_cy) in the width direction and a second through-dimension (R_cx) in the longitudinal direction, and
wherein a ratio of the first through-dimension to the second through-dimension is 0.98 or higher.

16. A mask device comprising:
the mask according to any one of Claims 13 to 15; and
a mask supporter (40) that supports the mask.

17. A manufacturing method for a mask (50), the manufacturing method comprising:
a step of preparing a metal plate (55A); and
a processing step of forming a plurality of through-holes (56) in the metal plate,
wherein the metal plate includes a surface having a longitudinal direction of the metal plate and a width direction orthogonal to the longitudinal direction,
wherein the surface has a first reflectance (R1), a second reflectance (R2), a third reflectance (R3), and a fourth reflectance (R4),
wherein the first reflectance is a reflectance of first reflected light (L_by) having a first output angle (ϕ1),
wherein the third reflectance is a reflectance of the first reflected light having a third output angle (ϕ3),
wherein the first reflected light is reflected light of first incident light (L_ay) reflected at the surface, the first incident light traveling in the width direction in plan view and being incident on the surface at a first specific incident angle (θ1),
wherein the first output angle is an output angle at which the first reflected light indicates a maximum intensity (S1),
wherein the third output angle is an output angle different from the first output angle by a first deviation angle (ϕd1),
wherein the second reflectance is a reflectance of second reflected light (L_bx) having a second output angle (ϕ2),
wherein the fourth reflectance is a reflectance of the second reflected light having a fourth output angle (ϕ4),
wherein the second reflected light is reflected light of second incident light (L_ax) reflected at the surface, the second incident light traveling in the longitudinal direction in plan view and being incident on the surface at a second specific incident angle (θ2),
wherein the second output angle is an output angle at which the second reflected light indicates a maximum intensity (S2),
wherein the fourth output angle is an output angle different from the second output angle by a second deviation angle (ϕd2),
wherein a first ratio (R3/R1) as a ratio of the third reflectance to the first reflectance is 0.40 or lower, and
wherein a second ratio (R4/R2) as a ratio of the fourth reflectance to the second reflectance is 0.40 or lower.

18. The manufacturing method for the mask according to Claim 17,
wherein the processing step includes:
a resist forming step of forming a resist layer (61) on the surface of the metal plate;
an exposure step of exposing the resist layer to light;
a developing step of developing the resist layer exposed to the light to form a resist pattern (611); and
an etching step of etching the metal plate.

19. The manufacturing method for the mask according to Claim 18,
wherein the resist pattern includes openings (612) and wall surfaces (613) facing the openings,
wherein each of fringes (614) at the wall surfaces has a width of 1.00 µm or smaller in plan view,
wherein each of the fringes protrudes at a corner toward a center of the opening, and
wherein the corner is an area where a surface of the resist pattern facing the metal plate and the wall surface are connected to each other.
